# EUROPEAN PATENT APPLICATION

(11) **EP 1 932 895 A1**
(43) Date of publication of application: **18.06.2008**
(21) Application number: 06782513.3
(22) Date of filing: 08.08.2006
(51) Int. Cl.: C09K 11/06, H01L 51/50

(54) **PYRENE DERIVATIVE AND ORGANIC ELECTROLUMINESCENCE DEVICE MAKING USE OF THE SAME**

(30) Priority: 16.09.2005 JP 2005270664
(71) Applicant: Idemitsu Kosan Co., Ltd., Chiyoda-ku Tokyo 100-8321 (JP)
(72) Inventor: ITO, Mitsunori, Chiba, 299-0293 (JP); KUBOTA, Mineyuki, Chiba, 299-0293 (JP); FUNAHASHI, Masakazu, Chiba, 299-0293 (JP)
(74) Representative: Gille Hrabal Struck Neidlein Prop Roos
(86) International application number: PCT/JP2006/315687
(87) International publication number: WO 2007/032162

(57) **Abstract**

Provided is an organic electroluminescence device including one or two or more organic thin-film layers having at least a light emitting layer interposed between a negative electrode and a positive electrode, in which the light emitting layer contains a pyrene derivative of a specified structure and an amine compound of a specified structure. The organic electroluminescence device excels in heat resistance, ensures long life and high luminous efficiency, and is capable of emitting blue, green and red lights.

## Description

### Technical Field

The present invention relates to an organic electroluminescence (hereinafter, the electroluminescence may sometimes be abbreviated as EL) device, in particular, an organic EL device which uses a specific pyrene derivative and a specific amine compound as light emitting materials, has a long lifetime and high luminous efficiency, and can be produced at a low cost.

### Background Art

An organic electroluminescence device is a spontaneous light emitting device which utilizes the principle that a fluorescent substance emits light by energy of recombination of holes injected from an anode and electrons injected from a cathode when an electric field is applied. Since an organic EL device of the laminate type driven under a low electric voltage was reported by C. W. Tang et al. of Eastman Kodak Company (C. W. Tang and S. A. Vanslyke, Applied Physics Letters, Volume 51, Page 913, 1987 or the like), many studies have been conducted on organic EL devices using organic materials as the constituent materials. Tang et al. used tris(8-quinolinolato)aluminum for a light emitting layer and a triphenyldiamine derivative for a hole transporting layer. Advantages of the laminate structure are that the efficiency of hole injection into the light emitting layer can be increased, that the efficiency of forming exciton which are formed by blocking and recombining electrons injected from the cathode can be increased, and that exciton formed within the light emitting layer can be enclosed. As described above, for the structure of the organic EL device, a two-layered structure having a hole transporting (injecting) layer and an electron-transporting light emitting layer and a three-layered structure having a hole transporting (injecting) layer, a light emitting layer, and an electron-transporting (injecting) layer are well known. In order to increase the efficiency of recombination of injected holes and electrons in the devices of the laminate type, the structure of the device and the process for forming the device have been studied.

Further, as the light emitting material, chelate complexes such as tris(8-quinolinolato)aluminum complexes, coumarin derivatives, tetraphenylbutadiene derivatives, bis styrylarylene derivatives, and oxadiazole derivatives are known. It is reported that light in the visible region ranging from blue light to red light can be obtained by using those light emitting materials, and development of a device exhibiting color images is expected (for example, Patent Documents 1 to 3).
In recent years, a large number of investigations have been conducted on the use of a phosphorescent compound as a light emitting material and the use of energy in a triplet state in EL light emission. A group of Princeton University has reported that an organic light emitting device using an iridium complex as a light emitting material shows high luminous efficiency (Non-patent Document 1). In addition to the organic electroluminescence device using a low molecular weight material as described above, an organic electroluminescence device using a conjugated polymer has been reported by a group of Cambridge University (Non-patent Document 2). In this report, light emission has been confirmed from a monolayer of polyphenylene vinylene (PPV) formed in a coating system.

Recent advances in organic electroluminescence device are remarkable, and characteristics of the organic electroluminescence device allow formation of a thin and lightweight light-emitting device with high luminance under application of a low voltage, wide range of emission wavelengths, and high-speed response, thereby suggesting the possibility of extensive uses.

In association with the significant progress of an organic light emitting device, performance requested for a light emitting material has been growing, and Patent Documents 4 and 5 each disclose a fluorene compound having a specific structure as a material which: can emit light with high luminance at a low voltage; and is excellent in durability.
At present, however, an optical output with additionally high luminance or additionally high conversion efficiency has been needed. In addition, an organic EL device containing the compound still involves a large number of problems in terms of durability such as a change over time due to long-term use and deterioration due to, for example, an atmospheric gas containing oxygen or moisture. Further, when one attempts to apply the device to, for example, a full-color display, each of blue, green, and red light beams must be emitted with a good color purity. However, the device has not sufficiently satisfied the requirement yet.

Patent Document 1: JP 08-239655 A
Patent Document 2: JP 07-183561 A
Patent Document 3: JP 03-200889 A
Patent Document 4: JP 2004-83481 A
Patent Document 5: JP 2004-43349 A
Non-patent Document 1: Nature, 395, 151 (1998)
Non-patent Document 2: Nature, 347, 539 (1990)

### Disclosure of the Invention

### Problems to be solved by the Invention

The present invention has been made with a view to solving the above-mentioned problems, and an object of the present invention is to provide a pyrene derivative and an amine compound particularly suitably used as a light emitting material in an organic EL device.
Another obj ect of the present invention is to provide an organic EL device having high luminous efficiency and a long lifetime. Another object of the present invention is to enable such organic EL device to be produced simply at a relatively low cost.
Therefore, the present invention aims to provide an organic EL device which: is excellent in durability; has a long lifetime and high luminous efficiency; and can emit blue light.

### Means for solving the Problems

The inventors of the present invention have made extensive studies with a view to solving the above-mentionedproblems . As a result, the inventors have found the following: upon production of an organic EL device including an organic thin film layer composed of one or more layers including at least a light emitting layer, the organic thin film layer being interposed between a cathode and an anode, the incorporation of a pyrene derivative represented by the following general formula (1) and an amine compound represented by the following general formula (2) into at least one layer of the organic light emitting layer can provide the organic EL device with high luminous efficiency and a long lifetime. Thus, the inventors have completed the present invention.

(A)ₖ-(X)ₘ-(Ar)ₙ-(Y)ₒ-(B)ₚ (1)

where: X's each represent a substituted or unsubstituted pyrene residue;
A's and B's each independently represent a hydrogen atom, a substituted or unsubstituted aromatic hydrocarbon group having 6 to 50 carbon atoms, a substituted or unsubstituted aromatic heterocyclic group having 5 to 50 carbon atoms, or a substituted or unsubstituted, saturated or unsaturated alkylene group having 1 to 50 carbon atoms;
Ar's each represent a substituted or unsubstituted aromatic hydrocarbon group having 6 to 50 carbon atoms, or a substituted or unsubstituted aromatic heterocyclic group having 5 to 50 carbon atoms;
Y's each represent a substituted or unsubstituted fused ring group or fused heterocyclic group having 4 to 50 carbon atoms;
k, o, and p each independently represent an integer of 0 to 10;
m represents an integer of 1 to 10;
n represents an integer of 3 or more;
multiple X's, multiple A's, multiple B's, multiple Ar's, or multiple Y's may be identical to or different from each other; and
at least one bond between X, Ar and Y is a meta bond or an ortho bond;

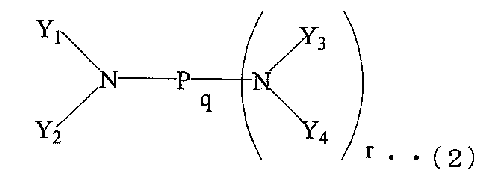

where: P represents a substituted or unsubstituted aromatic hydrocarbon group having 6 to 40 carbon atoms, a substituted or unsubstituted heterocyclic group having 3 to 40 carbon atoms, a substituted or unsubstituted styryl group, or a substituted or unsubstituted fused aromatic ring group having 10 to 40 carbon atoms;
Y₁ to Y₄ each independently represent a group selected from the group consisting of a substituted or unsubstituted alkylene group, aralkylene group, alkenylene group, amino group, and silyl group, and an unsubstituted carbonyl group, ether group, and thioether group each having a linking group composed of a substituted or unsubstituted arylene group or divalent heterocyclic group, and may be identical to or different from one another;
when r represents 2 or more, Y₃s or Y₄s may be identical to or different from each other;
q represents an integer of 1 to 20; and
r represents an integer of 0 to 3.

### Effects of the Invention

The use of the pyrene derivative represented by the above general formula (1) and the amine compound represented by the general formula (2) (including a general formula (4)) as light emitting materials enables the production of an organic EL device having high luminous efficiency and a long lifetime.

### Best Mode for carrying out the Invention

An organic EL device of the present invention is an organic EL device including an organic thin film layer composed of one or more layers including at least a light emitting layer, the organic thin film layer being interposed between an anode and a cathode, in which at least one layer of the organic layer contains a pyrene derivative represented by the following general formula (1) and an amine compound represented by the following general formula (2).

A pyrene derivative according to the present invention is represented by the following formula (1):

(A)ₖ-(X)ₘ-(Ar)ₙ-(Y)ₒ-(B)ₚ (1)

where: X's each represent a substituted or unsubstituted pyrene residue; A's and B's each independently represent a hydrogen atom, a substituted or unsubstituted aromatic hydrocarbon group having 6 to 50 carbon atoms, a substituted or unsubstituted aromatic heterocyclic group having 5 to 50 carbon atoms, or a substituted or unsubstituted, saturated or unsaturated alkylene group having 1 to 50 carbon atoms; Ar's each represent a substituted or unsubstituted aromatic hydrocarbon group having 6 to 50 carbon atoms, or a substituted or unsubstituted aromatic heterocyclic group having 5 to 50 carbon atoms; Y's each represent a substituted or unsubstituted fused ring group or fused heterocyclic group having 4 to 50 carbon atoms; k, o, and p each independently represent an integer of 0 to 10; m represents an integer of 1 to 10; n represents an integer of 3 or more; multiple X's, multiple A's, multiple B's, multiple Ar's, or multiple Y's may be identical to or different from each other; and at least one of an B-Ar bond and an Ar-Y bond is a meta bond or an ortho bond.

Further, preferred example of the above-mentioned formula (1) is represented by the following formula (3):

X-Ar₁-Ar₂-Ar₃-Y (3)

where: X represents a substituted or unsubstituted pyrene residue; A's and B's each independently represent a hydrogen atom, a substituted or unsubstituted aromatic hydrocarbon group having 6 to 50 carbon atoms, a substituted or unsubstituted aromatic heterocyclic group having 5 to 50 carbon atoms, or a substituted or unsubstituted, saturated or unsaturated alkylene group having 1 to 50 carbon atoms; Ar₁ to Ar₃ each independently represent a substituted or unsubstituted aromatic hydrocarbon group having 6 to 50 carbon atoms, or a substituted or unsubstituted aromatic heterocyclic group having 5 to 50 carbon atoms; Y represent a substituted or unsubstituted fused ring group or fused heterocyclic group having 4 to 50 carbon atoms; k and p each represent an integer of 0 to 10; and at least one bond between X, Ar and Y is a meta bond or an ortho bond;

Examples of the aromatic hydrocarbon group include a phenyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthryl group, a 1-naphthacenyl group, a 2-naphthacenyl group, a 9-naphthacenyl group, a 1-pyrenyl group, a 2-pyrenyl group, a 4-pyrenyl group, a 2-biphenylyl group, a 3-biphenylyl group, a 4-biphenylyl group, a p-terphenyl-4-yl group, a p-terphenyl-3-yl group, a p-terphenyl-2-yl group, an m-terphenyl-4-yl group, an m-terphenyl-3-yl group, anm-terphenyl-2-yl group, an o-tolyl group, an m-tolyl group, a p-tolyl group, a p-t-butylphenyl group, a p-(2-phenylpropyl)phenyl group, a 3-methyl-2-naphthyl group, a 4-methyl-1-naphthyl group, a 4-methyl-l-anthryl group, a 4'-methylbiphenylyl group, a 4"-t-butyl-p-terphenyl-4-yl group, and bivalent groups thereof.

Examples of the heterocyclic ring group include, a 1-pyrrolyl group, a 2-pyrrolyl group, a 3-pyrrolyl group, a pyrazinyl group, a 2-pyridinyl group, a 3-pyridinyl group, a 4-pyridinyl group, a 1-indolyl group, a 2-indolyl group, a 3-indolyl group, a 4-indolyl group, a 5-indolyl group, a 6-indolyl group, a 7-indolyl group, a 1-isoindolyl group, a 2-isoindolyl group, a 3-isoindolyl group, a 4-isoindolyl group, a 5-isoindolyl group, a 6-isoindolyl group, a 7-isoindolyl group, a 2-furyl group, a 3-furyl group, a 2-benzofuranyl group, a3-benzofuranyl group, a 4-benzofuranyl group, a 5-benzofuranyl group, a 6-benzofuranyl group, a 7-benzofuranyl group, a 1-isobenzofuranyl group, a 3-isobenzofuranyl group, a 4-isobenzofuranyl group, a 5-isobenzofuranyl group, a 6-isobenzofuranyl group, a 7-isobenzofuranyl group, a quinolyl group, a 3-quinolyl group, a 4-quinolyl group, a 5-quinolyl group, a 6-quinolyl group, a 7-quinolyl group, an 8-quinolyl group, a 1-isoquinolyl group, a 3-isoquinolyl group, a 4-isoquinolyl group, a 5-isoquinolyl group, a 6-isoquinolyl group, a 7-isoquinolyl group, an 8-isoquinolyl group, a 2-quinoxalinyl group, a 5-quinoxalinyl group, a 6-quinoxalinyl group, a1-carbazolyl group, a 2-carbazolyl group, a 3-carbazolyl group, a 4-carbazolyl group, a 9-carbazolyl group, a 1-phenanthridinyl group, a 2-phenanthridinyl group, a 3-phenanthridinyl group, a 4-phenanthridinyl group, a 6-phenanthridinyl group, a 7-phenanthridinyl group, an 8-phenanthridinyl group, a 9-phenanthridinyl group, a 10-phenanthridinyl group, a 1-acridinyl group, a 2-acridinyl group, a 3-acridinyl group, a 4-acridinyl group, a 9-acridinyl group, a 1,7-phenanthrolin-2-yl group, a 1,7-phenanthrolin-3-yl group, a 1,7-phenanthrolin-4-yl group, a 1,7-phenanthrolin-5-yl group, a 1,7-phenanthrolin-6-yl group, a 1,7-phenanthrolin-8-yl group, a 1,7-phenanthrolin-9-yl group, a 1,7-phenanthrolin-10-yl group, a 1,8-phenanthrolin-2-yl group, a 1,8-phenanthrolin-8-yl group, a 1,8-phenanthrolin-4-yl group, a 1,8-phenanthrolin-5-yl group, a 1,8-phenanthrolin-6-yl group, a 1,8-phenanthrolin-7-yl group, a 1,8-phenanthrolin-9-yl group, a 1,8-phenanthrolin-10-yl group, a 1,9-phenanthrolin-2-yl group, a 1,9-phenanthrolin-3-yl group, a 1,9-phenanthrolin-4-yl group, a 1,9-phenanthrolin-5-yl group, a 1,9-phenanthrolin-6-yl group, a 1,9-phenanthrolin-7-yl group, a 1,9-phenanthrolin-8-yl group, a 1,9-phenanthrolin-10-yl group, a 1,10-phenanthrolin-2-yl group, a 1,10-phenanthrolin-3-yl group, a 1,10-phenanthrolin-4-yl group, a 1,10-phenanthrolin-5-yl group, a 2,9-phenanthrolin-1-yl group, a 2,9-phenanthrolin-3-yl group, a 2,9-phenanthrolin-4-yl group, a 2,9-phenanthrolin-5-yl group, a 2,9-phenanthrolin-6-yl group, a 2,9-phenanthrolin-7-yl group, a 2,9-phenanthrolin-8-yl group, a 2,9-phenanthrolin-10-yl group, a 2,8-phenanthrolin-1-yl group, a 2,8-phenanthrolin-3-yl group, a 2,8-phenanthrolin-4-yl group, a 2,8-phenanthrolin-5-yl group, a 2,8-phenanthrolin-6-yl group, a 2,8-phenanthrolin-7-yl group, a 2,8-phenanthrolin-9-yl group, a 2,8-phenanthrolin-10-yl group, a 2,7-phenanthrolin-1-yl group, a 2,7-phenanthrolin-3-yl group, a 2,7-phenanthrolin-4-yl group, a 2,7-phenanthrolin-5-yl group, a 2,7-phenanthrolin-6-yl group, a 2,7-phenanthrolin-8-yl group, a 2,7-phenanthrolin-9-yl group, a 2,7-phenanthrolin-10-yl group, a 1-phenazinyl group, a 2-phenazinyl group, a 1-phenothiazinyl group, a 2-phenothiazinyl group, a 3-phenothiazinyl group, a 4-phenothiazinyl group, a 10-phenothiazinyl group, a 1-phenoxazinyl group, a 2-phenoxazinyl group, a 3-phenoxazinyl group, a 4-phenoxazinyl group, a 10-phenoxazinyl group, a 2-oxazolyl group, a 4-oxazolyl group, a 5-oxazolyl group, a 2-oxadiazolyl group, a 5-oxadiazolyl group, a 3-furazanyl group, a 2-thienyl group, a 3-thienyl group, a 2-methylpyrrol-1-yl group, a 2-methylpyrrol-3-yl group, a 2-methylpyrrol-4-yl group, a 2-methylpyrrol-5-yl group, a 3-methylpyrrol-1-yl group, a 3-methylpyrrol-2-yl group, a 3-methylpyrrol-4-yl group, a 3-methylpyrrol-5-yl group, a 2-t-butylpyrrol-4-yl group, a 3-(2-phenylpropyl)pyrrol-1-yl group, a 2-methyl-1-indolyl group, a 4-methyl-1-indolyl group, a 2-methyl-3-indolyl group, a 4-methyl-3-indolyl group, a 2-t-butyl-1-indolyl group, a 4-t-butyl-1-indolyl group, a 2-t-butyl-3-indolyl group, a 4-t-butyl-3-indolyl group, and bivalent groups thereof.

Representative examples of Ar and Ar₁-Ar₂-Ar₃ in the general formulae (1) and (3) are shown below. However, the present invention is not limited to the examples.

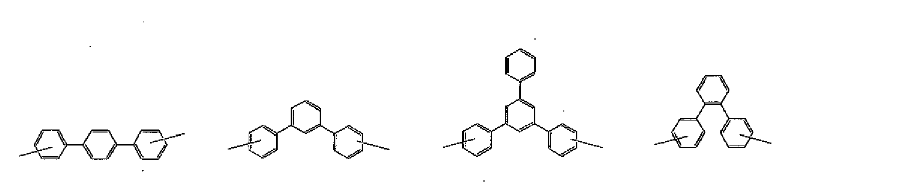

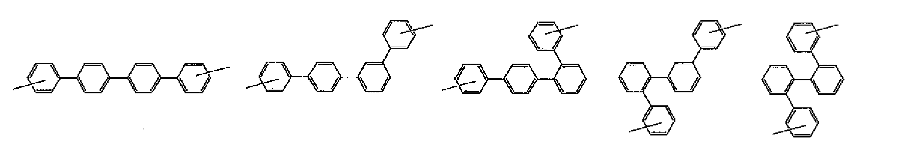

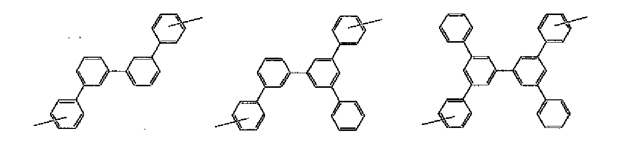

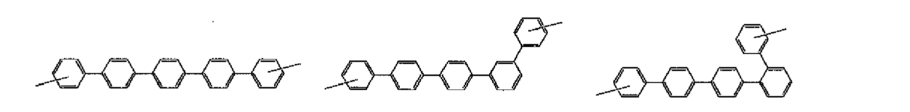

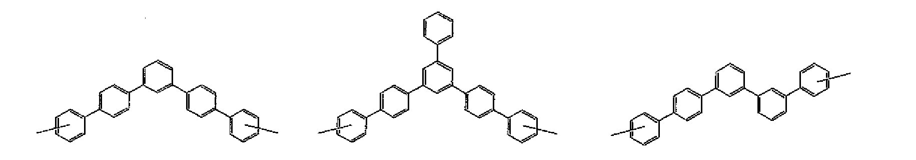

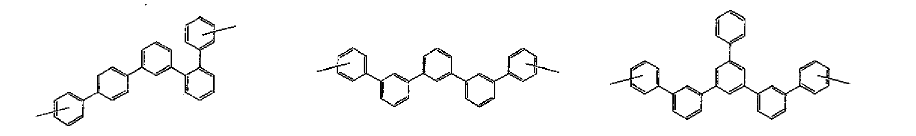

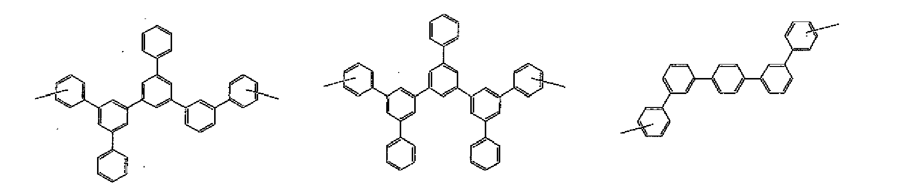

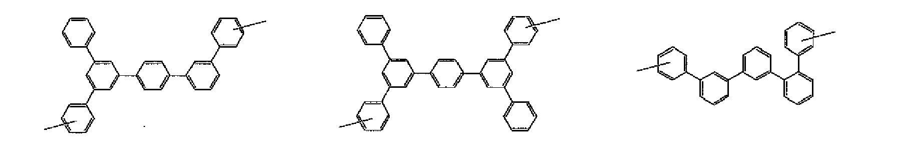

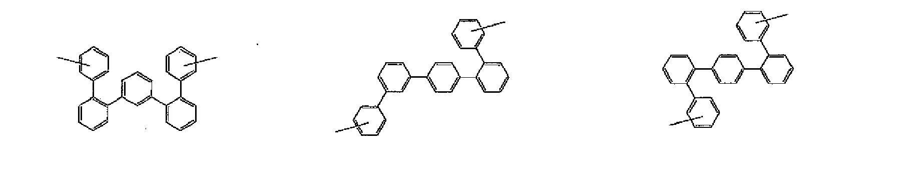

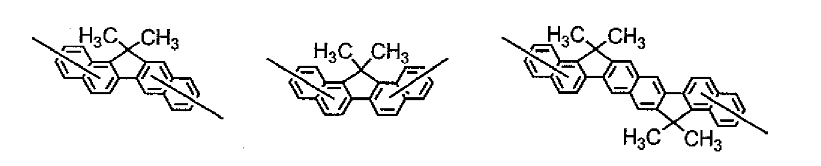

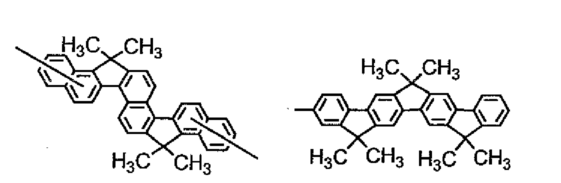

Examples of X in each of the general formulae (1) and (3) are shown below. However, the present invention is not limited to the examples.

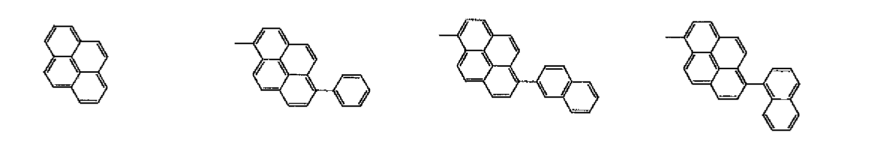

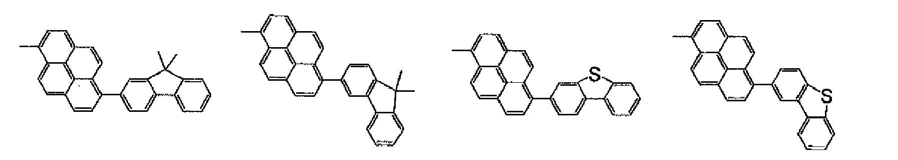

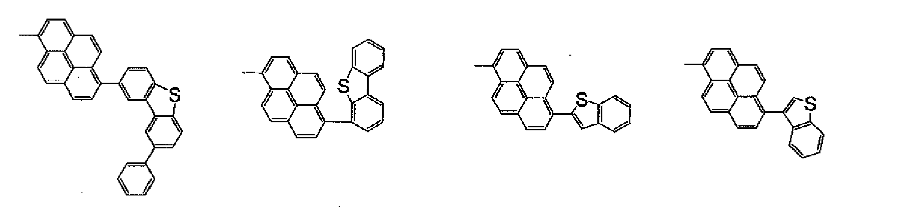

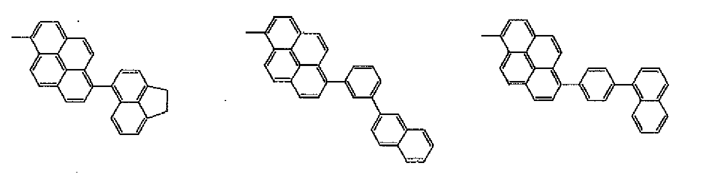

Next, in the general formula (1) or (3), examples of the fused ring group and fused heterocyclic group represented by Y include pyrene, anthracene, benzanthracene, naphthalene, fluoranthene, fluorene, benzfluorene, phenanthrene, tetracene, coronene, chrysene, fluoresceine, perylene, phthaloperylene, naphthaloperylene, perynone, phthaloperynone, naphthaloperynone, diphenylbutadiene, tetraphenylbutadiene, coumarin, oxadiazole, aldazine, bisbenzoxazoline, bisstyryl, pyrazine, cyclopentadiene, imine, diphenylethylene, vinylanthracene, diaminocarbazole, pyrane, thiopyrane, polymethine, merocyanine, imidazole-chelated oxynoid compounds, quinacridone, rubrene, stilbene-based derivatives, and fluorescent dyes. The pyrene, anthracene, and fluoranthene are preferred.

Representative examples of the pyrene derivative represented by the general formula (1) are shown below. However, the present invention is not limited to the representative examples.

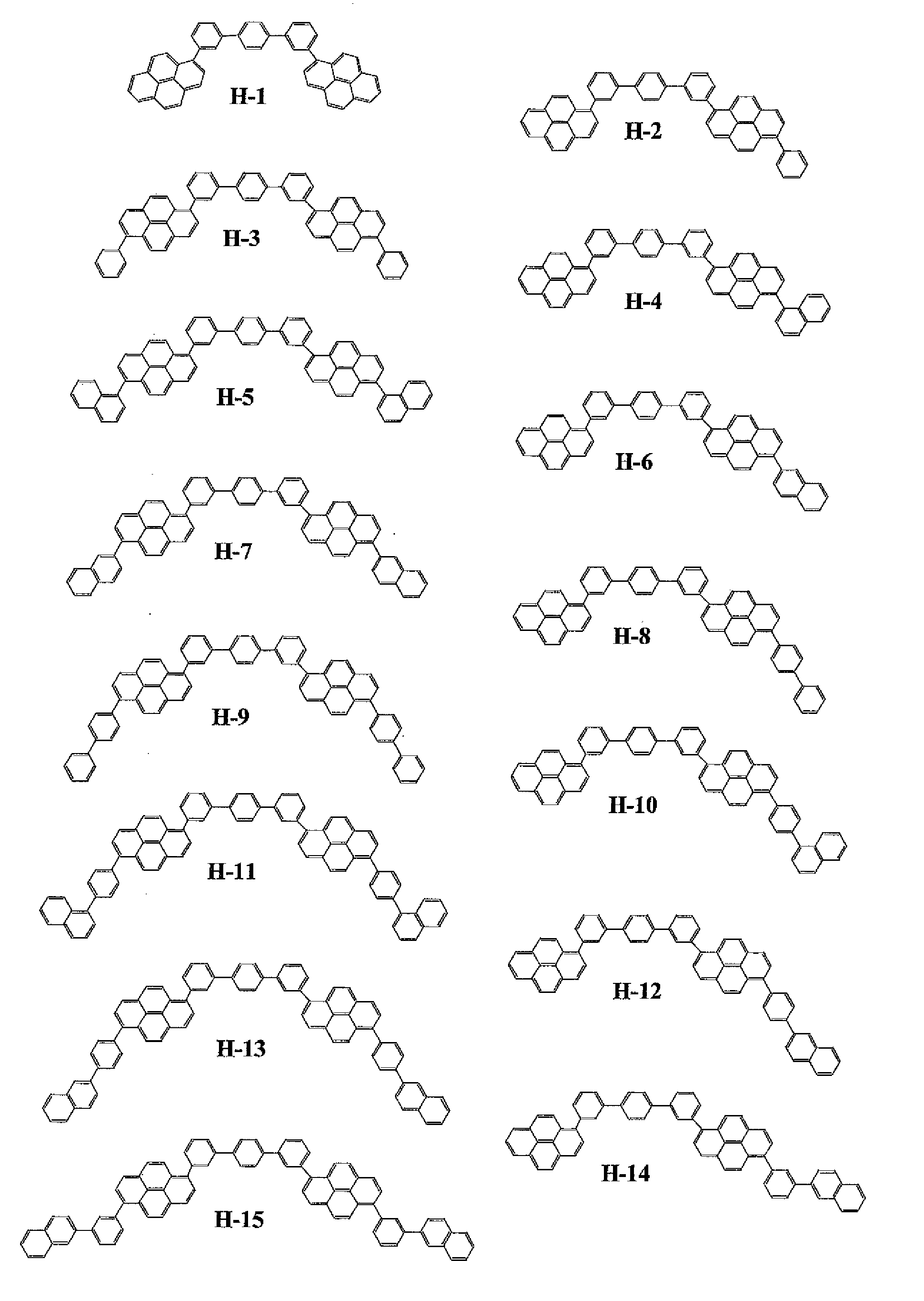

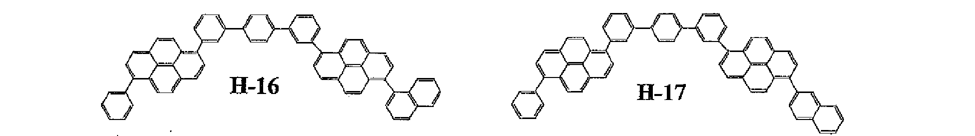

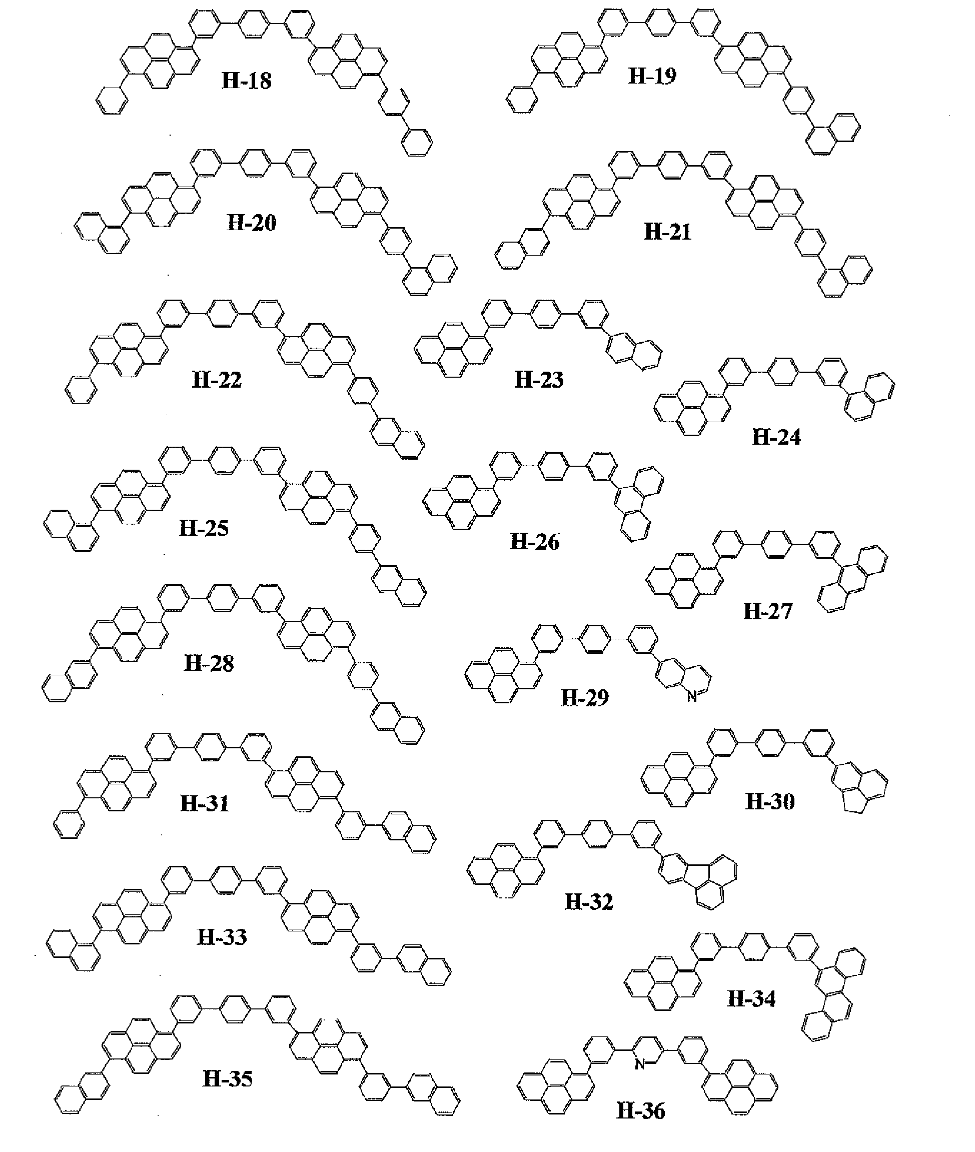

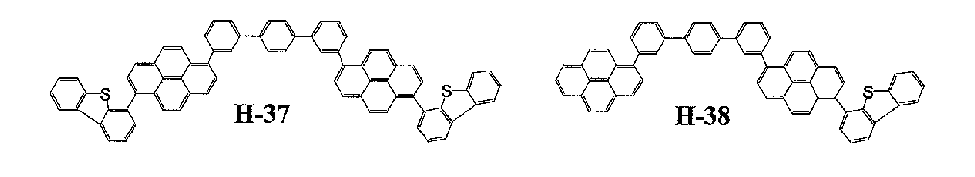

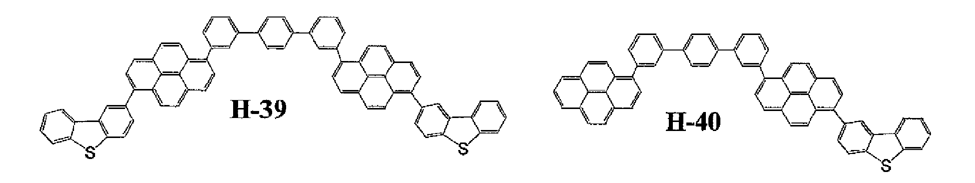

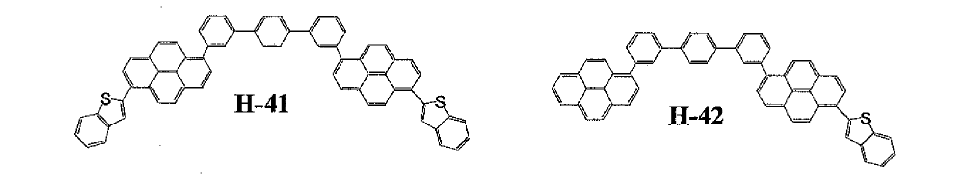

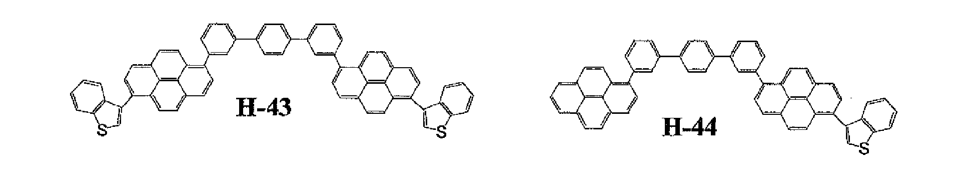

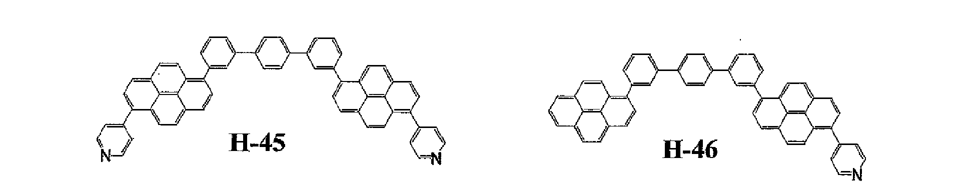

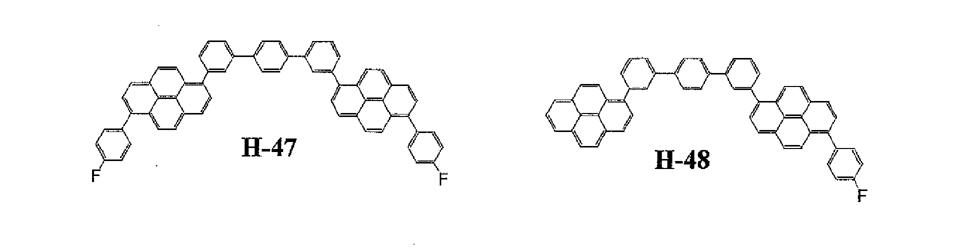

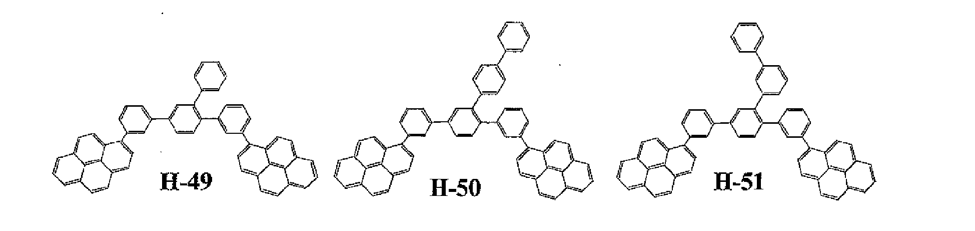

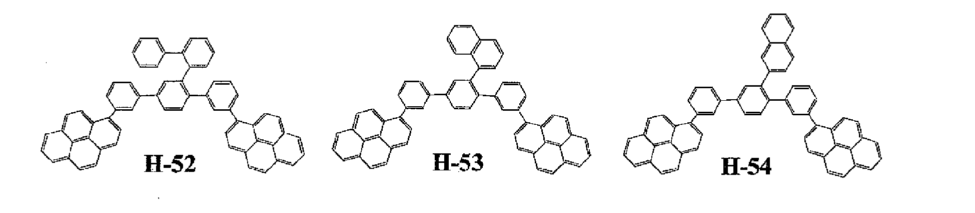

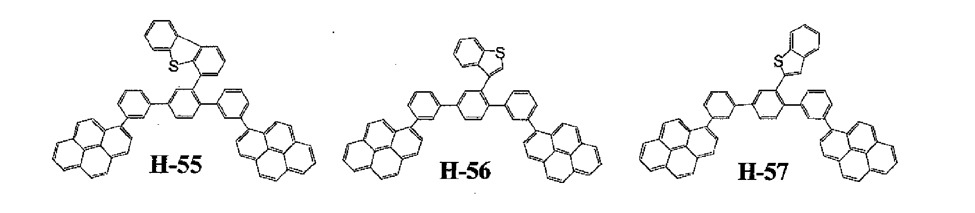

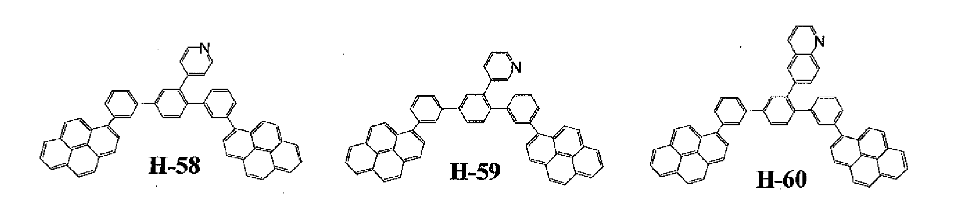

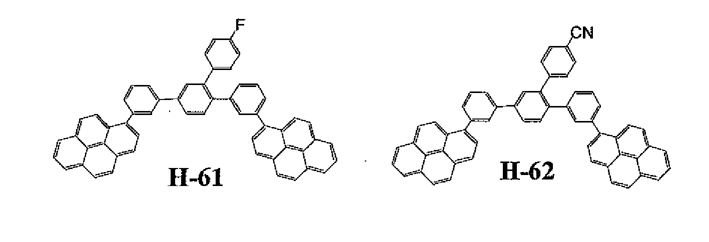

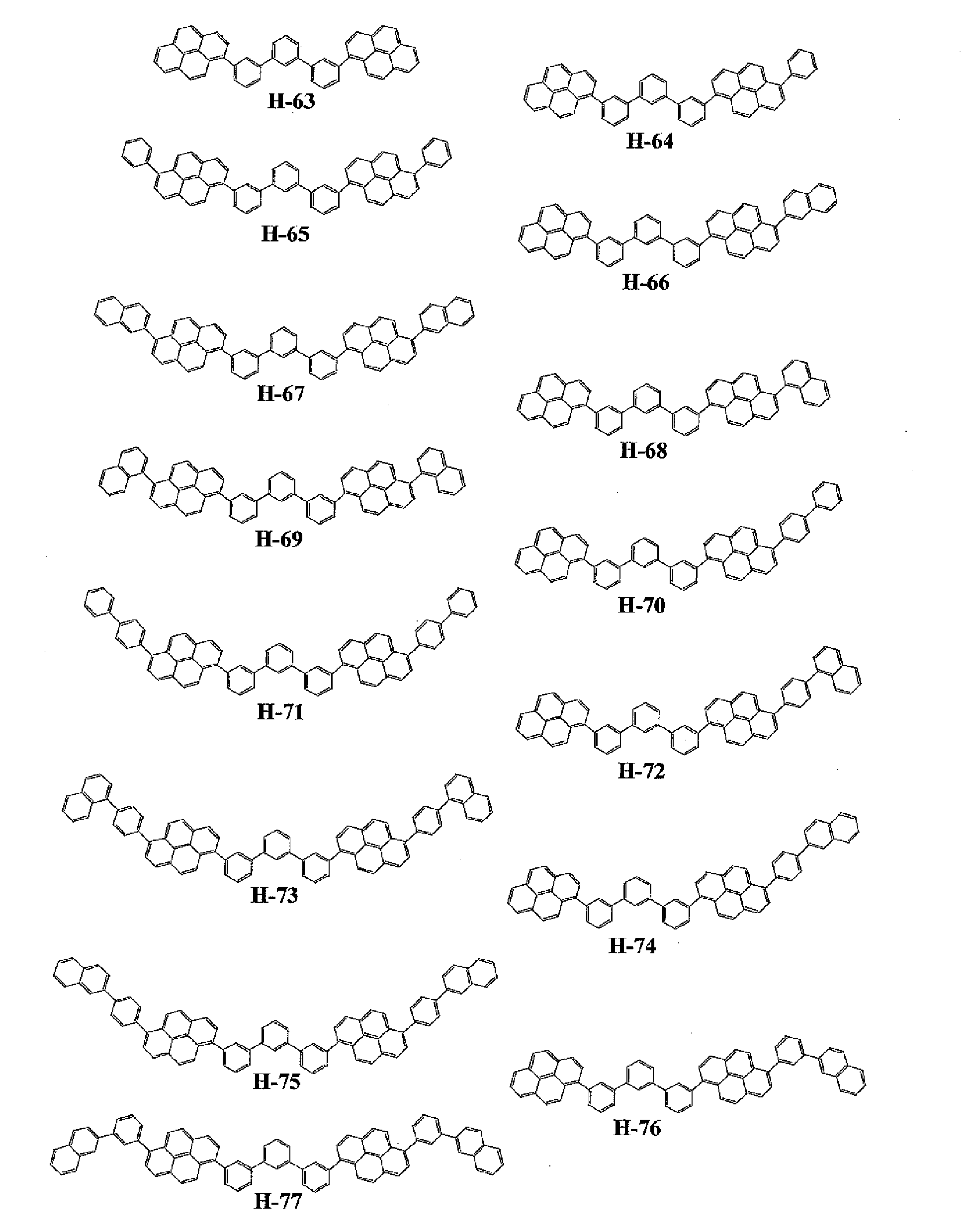

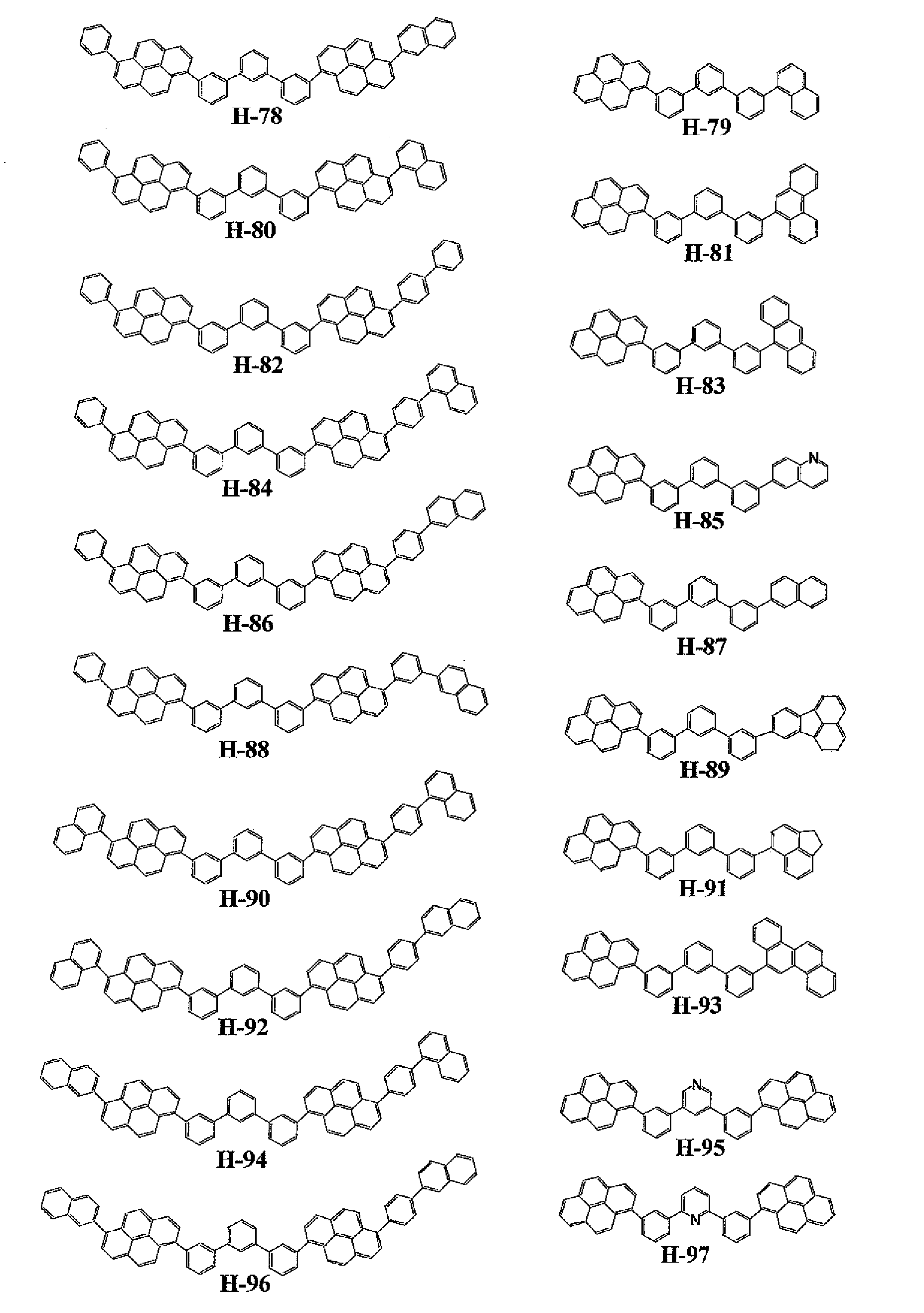

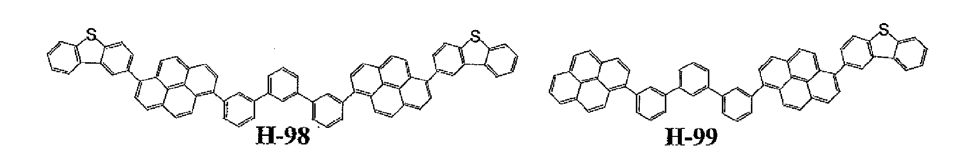

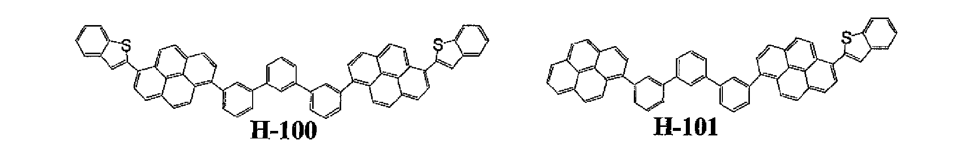

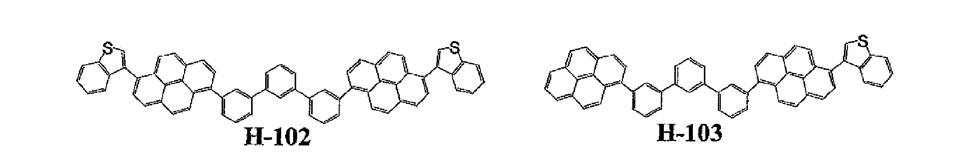

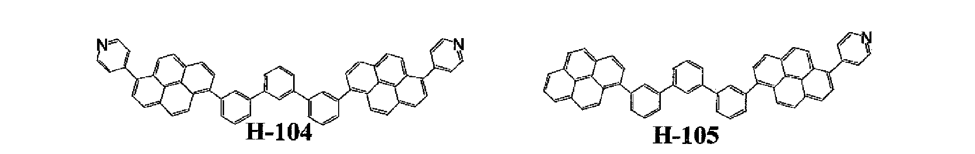

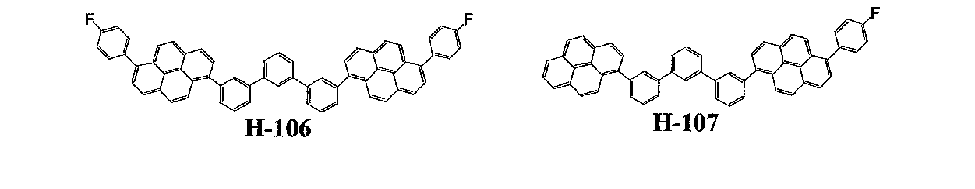

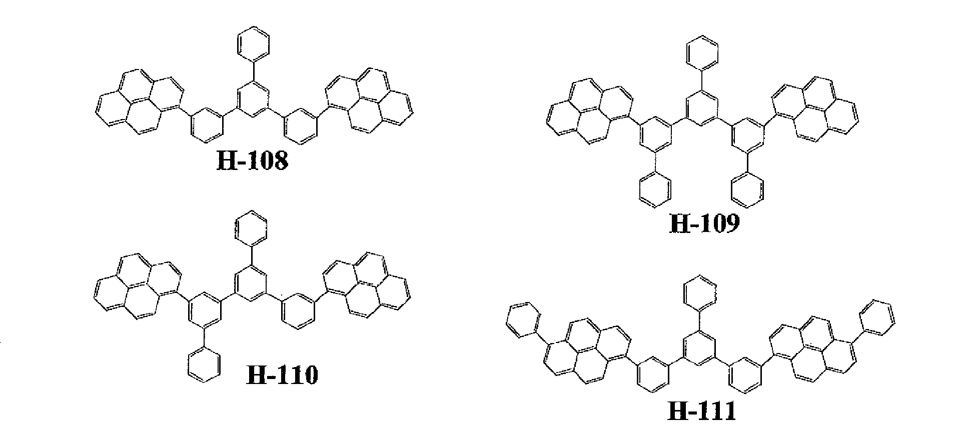

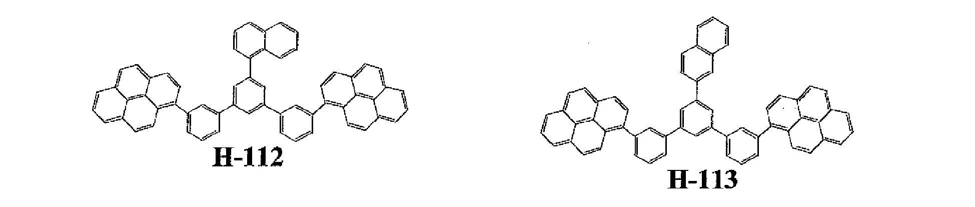

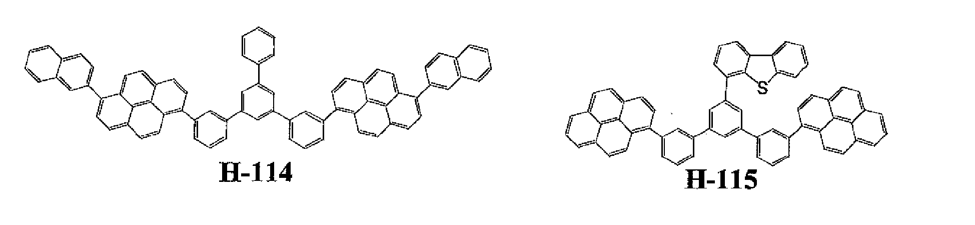

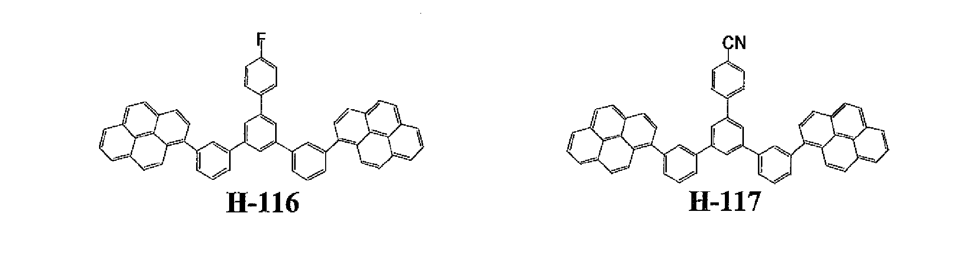

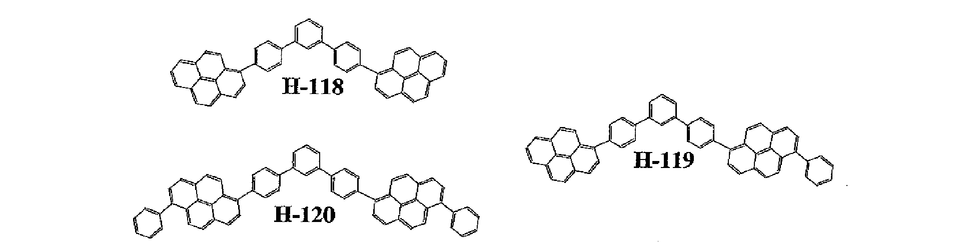

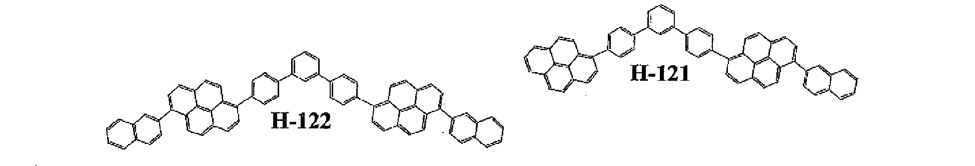

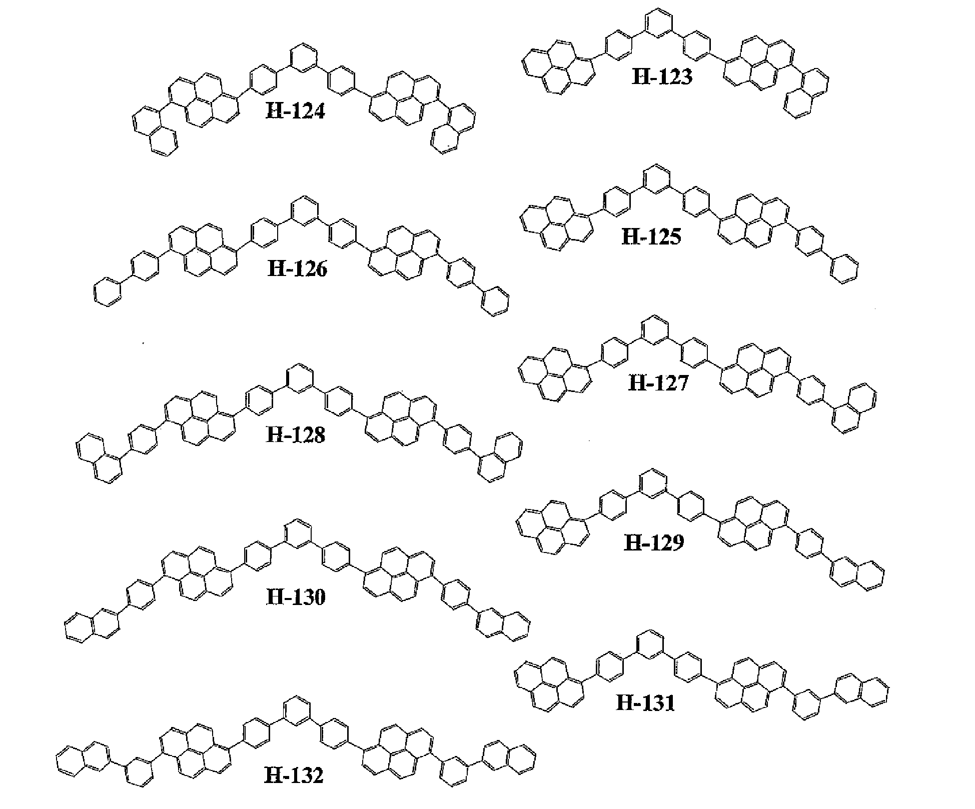

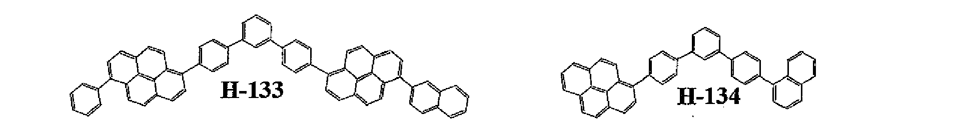

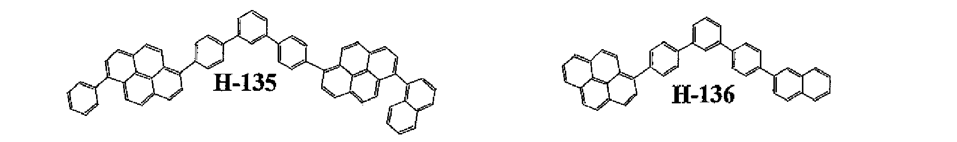

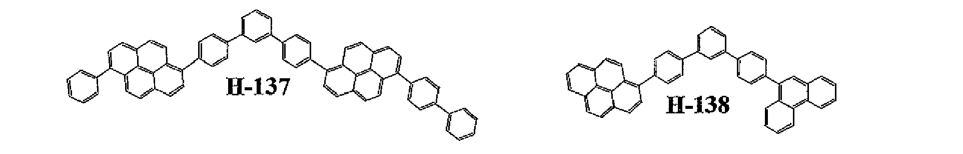

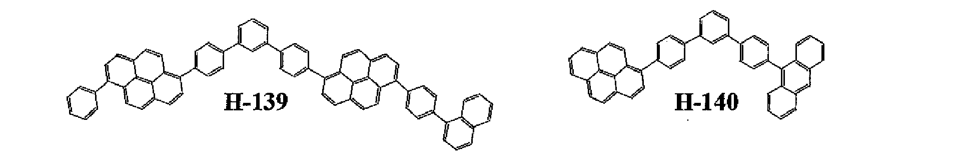

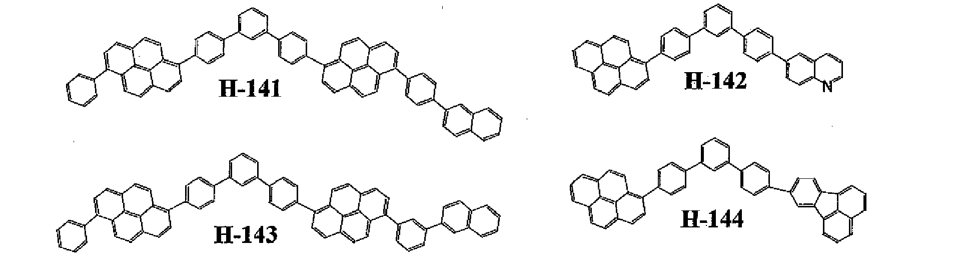

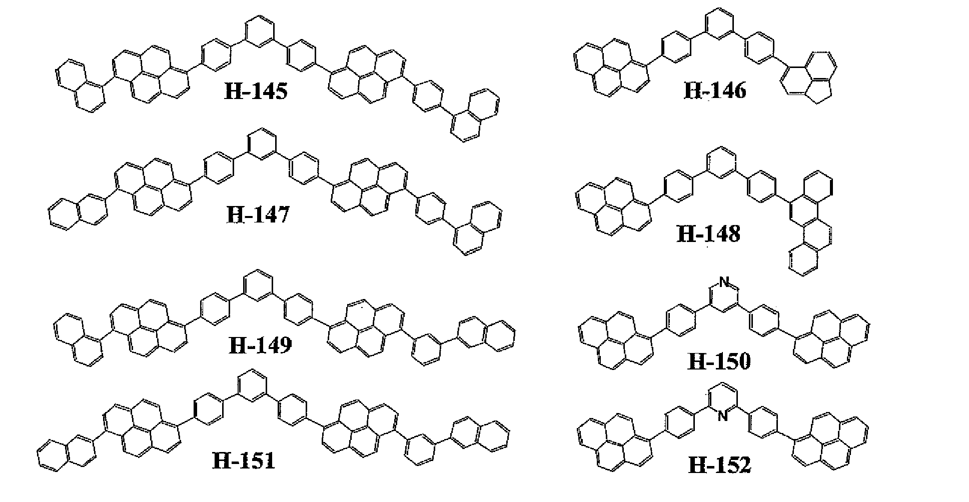

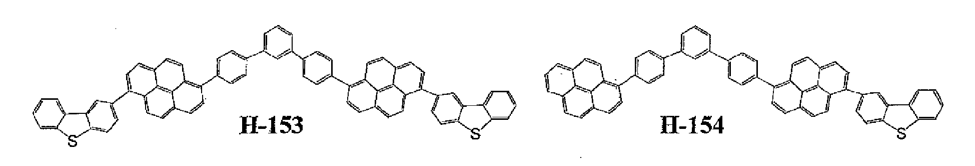

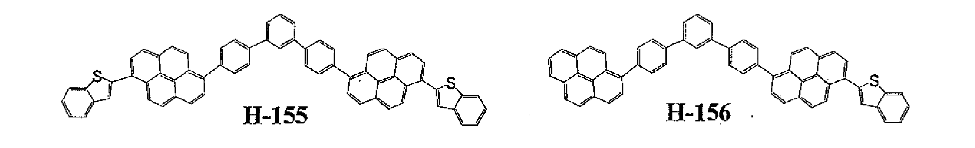

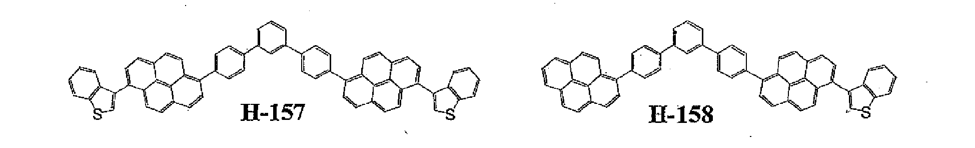

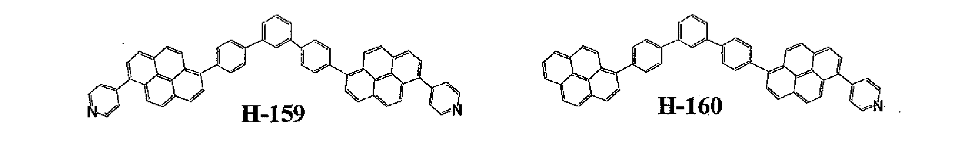

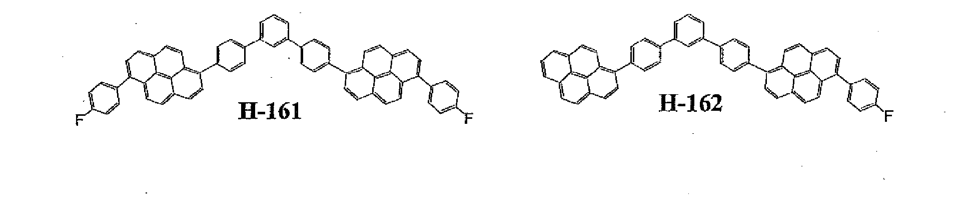

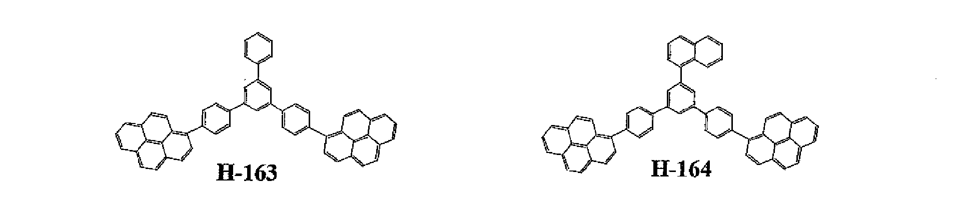

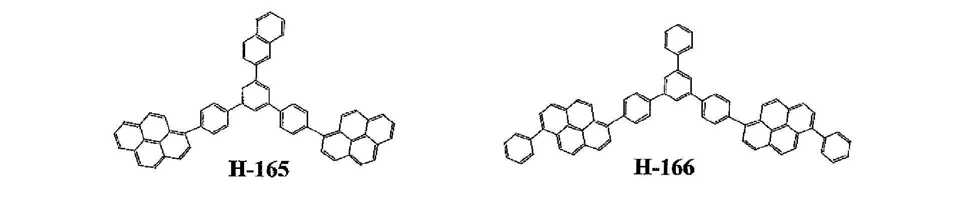

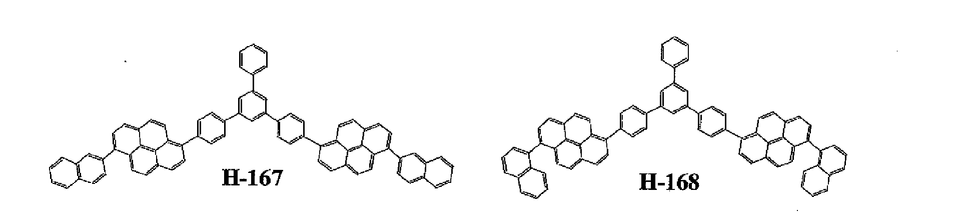

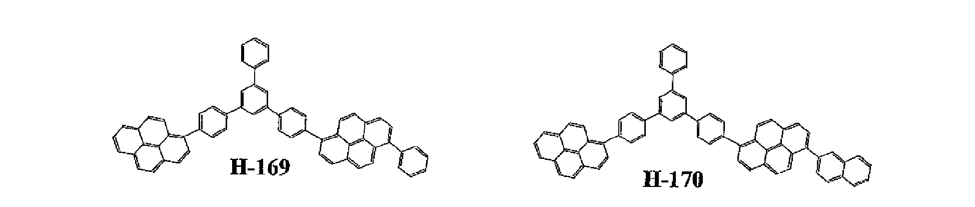

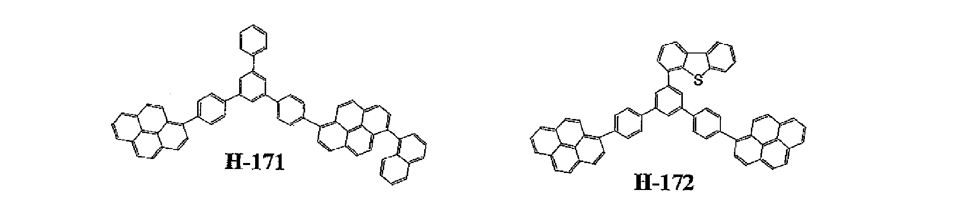

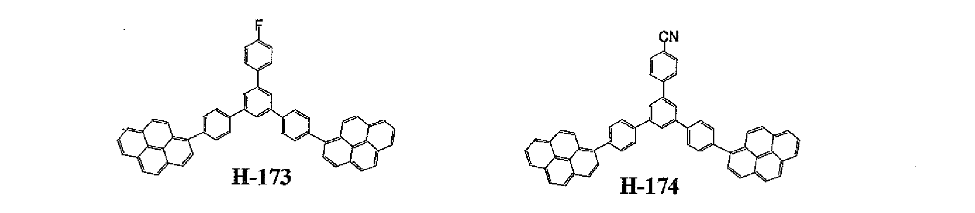

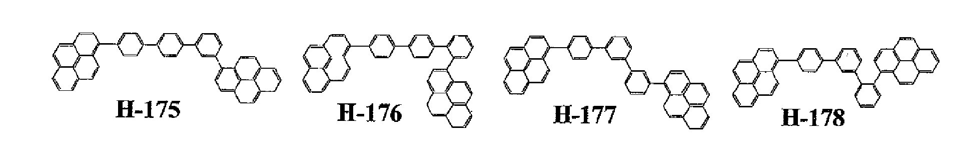

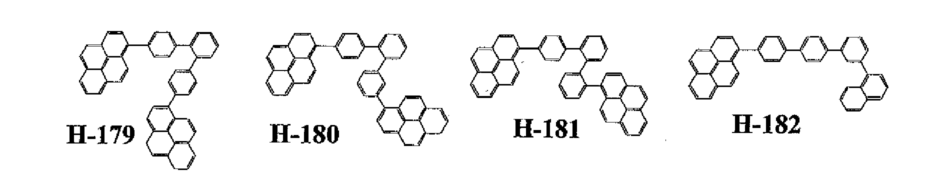

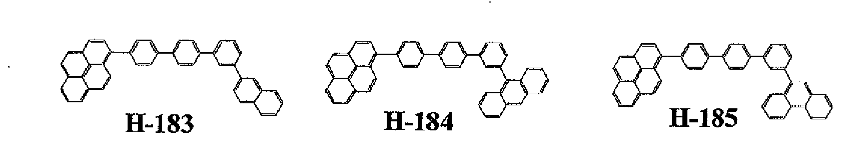

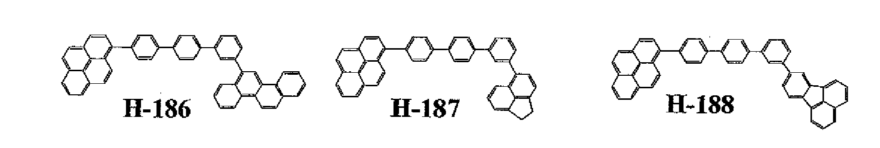

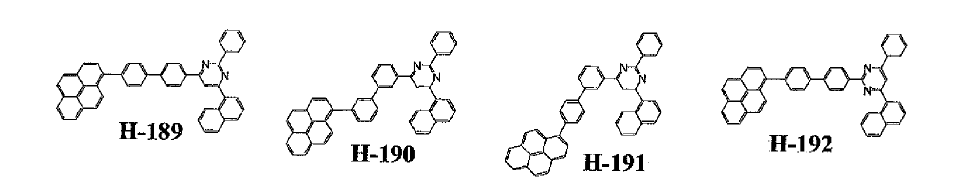

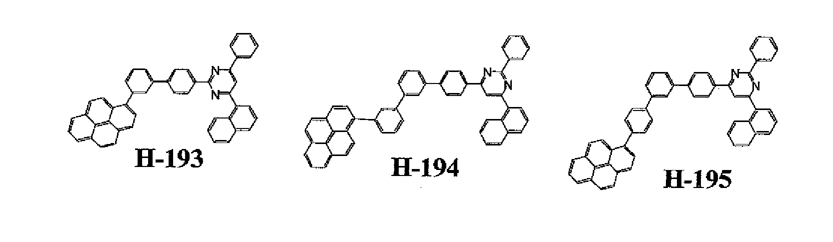

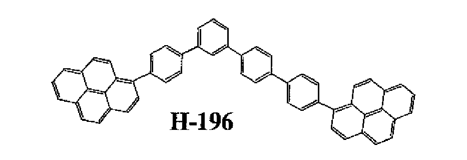

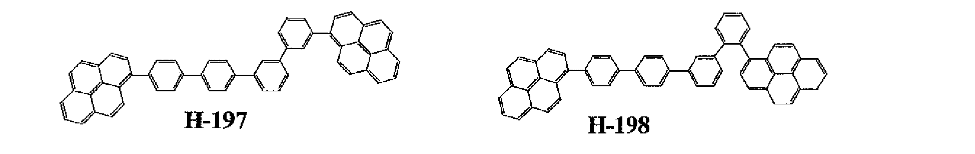

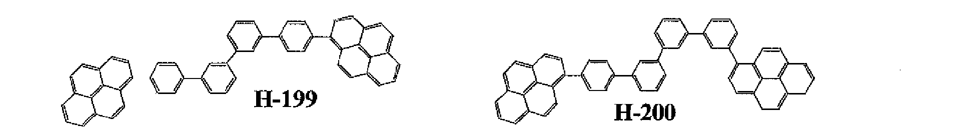

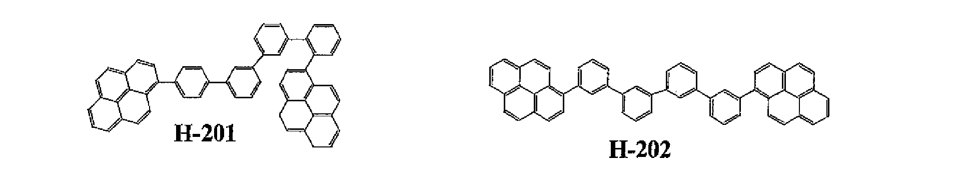

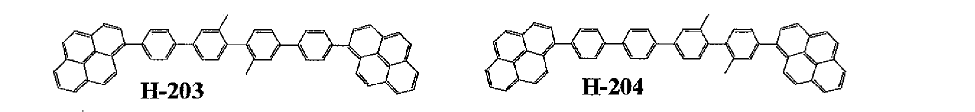

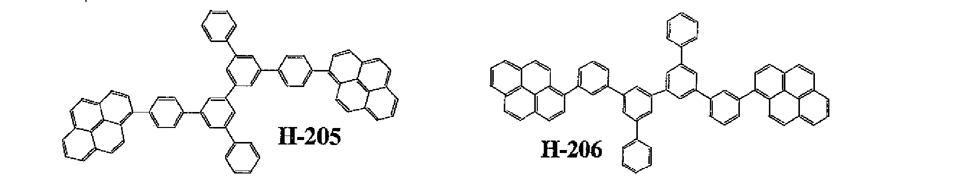

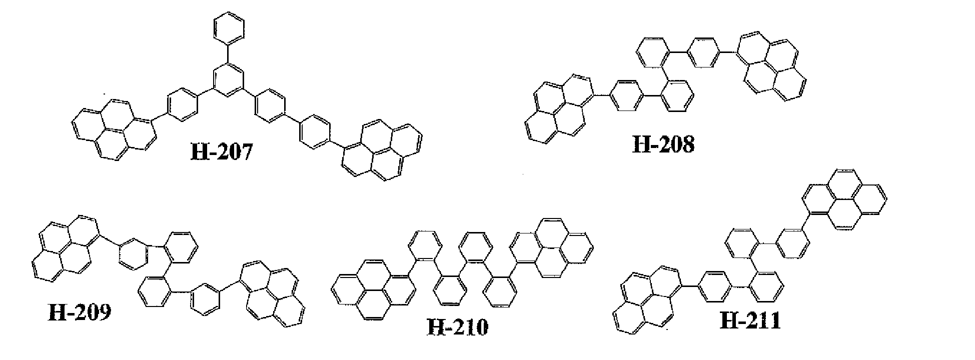

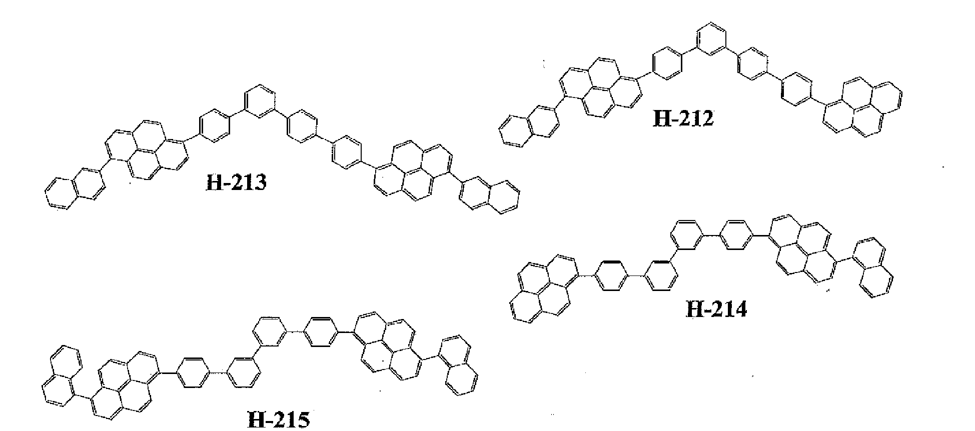

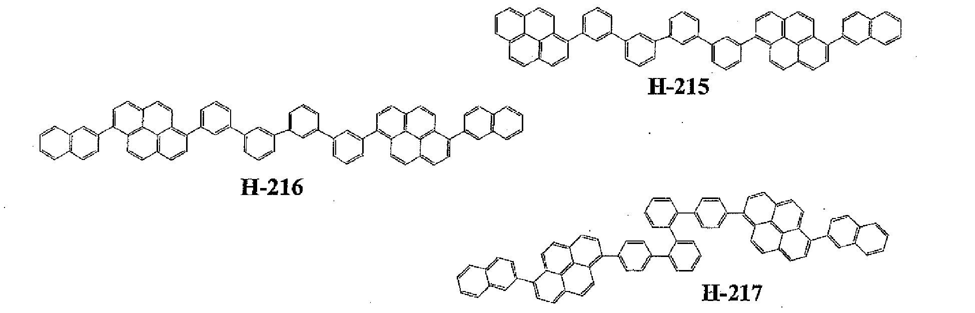

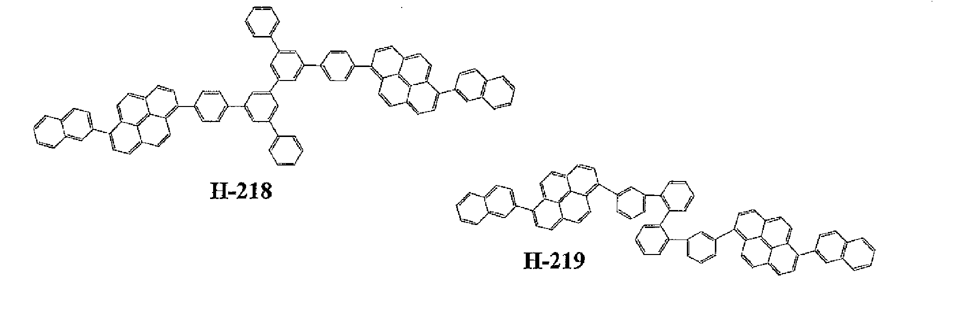

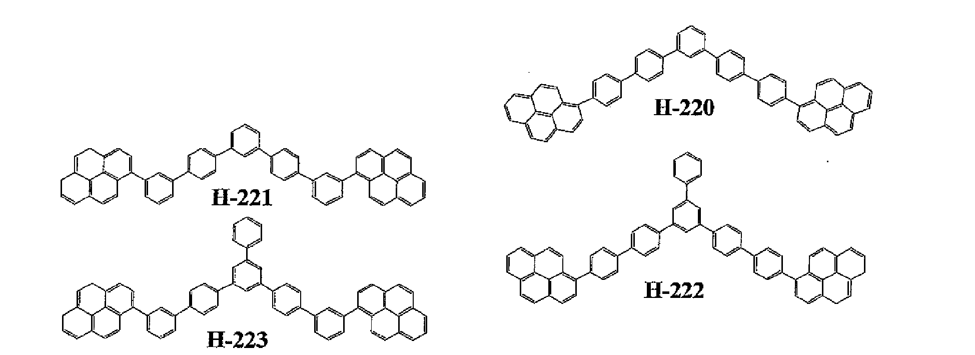

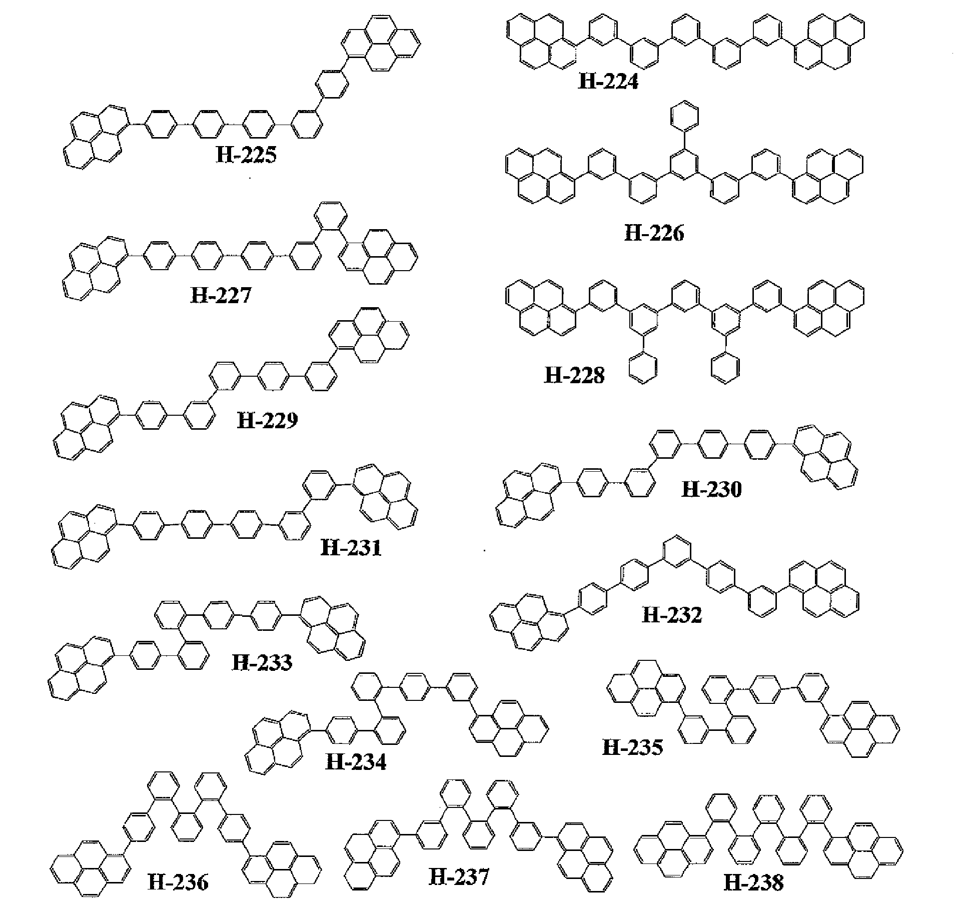

The amine compound of the present invention is represented by the following general formula (2): 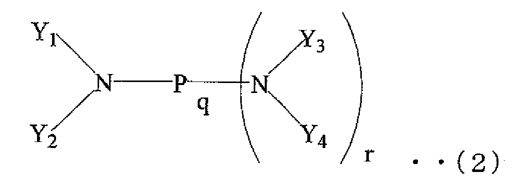 where: P represents a substituted or unsubstituted aromatic hydrocarbon group having 6 to 40 carbon atoms, a substituted or unsubstituted heterocyclic group having 3 to 40 carbon atoms, a substituted or unsubstituted styryl group, or a substituted or unsubstituted fused aromatic ring group having 10 to 40 carbon atoms; Y₁ to Y₄ each independently represent a group selected from the group consisting of a substituted or unsubstituted alkylene group, aralkylene group, alkenylene group, amino group, and silyl group, and an unsubstituted carbonyl group, ether group, and thioether group each having a linking group composed of a substituted or unsubstituted arylene group or divalent heterocyclic group, and may be identical to or different from one another; when r represents 2 or more, Y₃s or Y₄s may be identical to or different from each other; q represents an integer of 1 to 20; and r represents an integer of 0 to 3.

In addition, the amine compound of the present invention is preferably such that P in the above general formula (2) is represented by the following general formula (4): 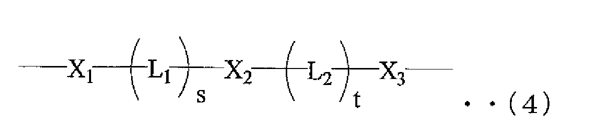 where: X₁, X₂, and X₃ each independently represent a divalent group selected from the group consisting of a single bond, a substituted or unsubstituted alkylene group, aralkylene group, arylene group, and heterocyclic group, may be identical to or different from one another, and may each represent any one of an alkenylene group, an amino group, a silyl group, a carbonyl group, an ether group, and a thioether group; each of X₁, X₂, and X₃ may be bonded to each of Y₁, Y₂, Y₃, and Y₄ to form a ring; L₁ and L₂ each independently represent a divalent group selected from the group consisting of a substituted or unsubstituted alkyl group, aralkyl group, aryl group, and heterocyclic group, and may be identical to or different from each other; and s and t each represent an integer of 0 to 10 provided that s + t ≥ 1.
In particular, mentioned as a preferable structure as P, L₁ and L₂ in the general formulae (2) and (4) represent a residue of fluorene, anthracene, naphthalene, phenanthrene, fluoranthene, pyrene, perylene, chrysene, or phenylanthracene.

Preferred specific examples of the amine compound represented by the general formula (2) will be further described with reference to the following general formulae (10) to (17): 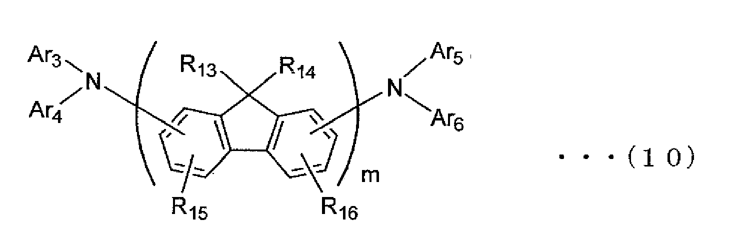 where: R₁₃ and R₁₄ each represent a hydrogen atom, a substituted or unsubstituted alkyl group, a substituted or unsubstituted aralkyl group, a substituted or unsubstituted aryl group, or a substituted or unsubstituted heterocyclic group, R₁₃s or R₁₄s bonded to different fluorene groups may be identical to or different from each other, and R₁₃ and R₁₄ bonded to the same fluorene group may be identical to or different from each other;
R₁₅ and R₂₆ each represent a hydrogen atom, a substituted or unsubstituted alkyl group, a substituted or unsubstituted aralkyl group, a substituted or unsubstituted aryl group, a substituted or unsubstituted heterocyclic group, a cyano group, or a halogen atom, R₁₅s or R₁₆s bonded to different fluorene groups may be identical to or different from each other, and R₁₅ and R₁₆ bonded to the same fluorene group may be identical to or different from each other;
Ar₃, Ar₄, Ar₅, and Ar₆ each represent a substituted or unsubstituted aromatic hydrocarbon group, a substituted or unsubstituted heterocyclic group, a substituted or unsubstituted fused polycyclic aromatic group, or a substituted or unsubstituted fused polycyclic heterocyclic group, Ar₃, Ar₄, Ar₅, and Ar₆ may be identical to or different from one another, and two arbitrary adj acent groups of Ar₃, Ar₄, Ar₅, and Ar₆ may be bonded to each other to form a ring; and
m represents an integer of 1 to 10;

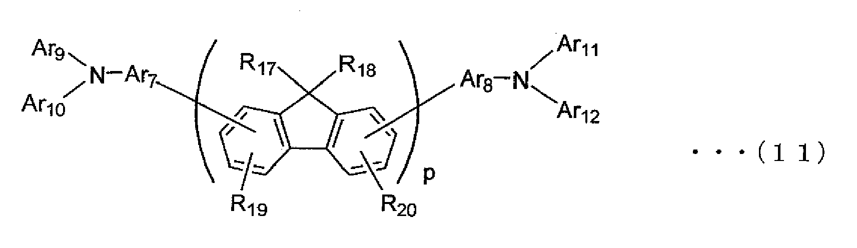

where: R₁₇ and R₁₈ each represent a hydrogen atom, a substituted or unsubstituted alkyl group, a substituted or unsubstituted aralkyl group, a substituted or unsubstituted aryl group, or a substituted or unsubstituted heterocyclic group, R₁₇s or R₁₈s bonded to different fluorene groups may be identical to or different from each other, and R₁₇ and R₁₈ bonded to the same fluorene group may be identical to or different from each other;
R₁₉ and R₂₀ each represent a hydrogen atom, a substituted or unsubstituted alkyl group, a substituted or unsubstituted aralkyl group, a substituted or unsubstituted aryl group, a substituted or unsubstituted heterocyclic group, a cyano group, or a halogen atom, R₁₉s or R₂₀s bonded to different fluorene groups may be identical to or different from each other, and R₁₉ and R₂₀ bonded to the same fluorene group may be identical to or different from each other;
Ar₇ and Ar₈ each represent a divalent, substituted or unsubstituted aromatic group, or a divalent, substituted or unsubstituted heterocyclic group, and Ar₇ and Ar₈ may be identical to or different from each other;
Ar₉, Ar₁₀, Ar₁₁, and Ar₁₂ each represent a substituted or unsubstituted aromatic hydrocarbon group, a substituted or unsubstituted heterocyclic group, a substituted or unsubstituted fused polycyclic aromatic group, or a substituted or unsubstituted fused polycyclic heterocyclic group, Ar₉, Ar₁₀, Ar₁₁, and Ar₁₂ may be identical to or different from one another, and two arbitrary adjacent groups of Ar₉, Ar₁₀, Ar₁₁, and Ar₁₂ may be bonded to each other to form a ring; and
p represents an integer of 1 to 10;

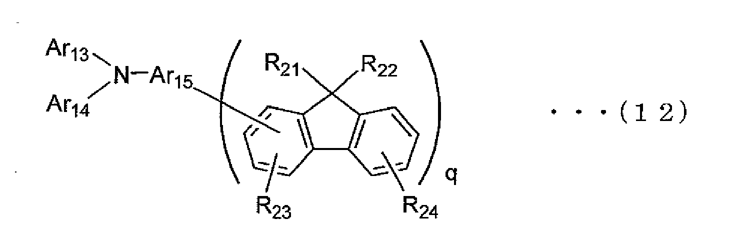

where: R₂₁ and R₂₂ each represent a hydrogen atom, a substituted or unsubstituted alkyl group, a substituted or unsubstituted aralkyl group, a substituted or unsubstituted aryl group, or a substituted or unsubstituted heterocyclic group, R₂₁s or R₂₂s bonded to different fluorene groups may be identical to or different from each other, and R₂₁ and R₂₂ bonded to the same fluorene group may be identical to or different from each other;
R₂₃ and R₂₄ each represent a hydrogen atom, a substituted or unsubstituted alkyl group, a substituted or unsubstituted aralkyl group, a substituted or unsubstituted aryl group, a substituted or unsubstituted heterocyclic group, a cyano group, or a halogen atom, R₂₃s or R₂₄s bonded to different fluorene groups may be identical to or different from each other, and R₂₃ and R₂₄ bonded to the same fluorene group may be identical to or different from each other;
Ar₁₃ and Ar₁₄ each represent a substituted or unsubstituted aromatic hydrocarbon group, a substituted or unsubstituted heterocyclic group, a substituted or unsubstituted fused polycyclic aromatic group, or a substituted or unsubstituted fused polycyclic heterocyclic group, Ar₁₃ and Ar₁₄ may be identical to or different from each other, and Ar₁₃ and Ar₁₄ may be bonded to each other to form a ring;
Ar₁₅ represents a divalent, substituted or unsubstituted aromatic hydrocarbon group, or a divalent, substituted or unsubstituted heterocyclic group; and
q represents an integer of 1 to 10;

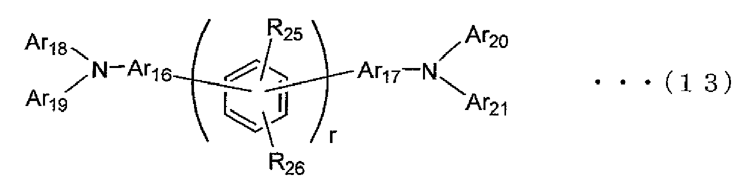

where: R₂₅ and R₂₆ each represent a hydrogen atom, a substituted or unsubstituted alkyl group, a substituted or unsubstituted aralkyl group, a substituted or unsubstituted aryl group, a substituted or unsubstituted heterocyclic group, a cyano group, or a halogen atom, R₂₅s or R₂₆s bonded to different phenylene groups may be identical to or different from each other, and R₂₅ and R₂₆ bonded to the same phenylene group may be identical to or different from each other;
Ar₁₆ and Ar₁₇ each represent a divalent, substituted or unsubstituted aromatic hydrocarbon group,or a divalent, substituted or unsubstituted heterocyclic group, and Ar₁₆ and Ar₁₇ may be identical to or different from each other;
Ar₁₈, Ar₁₉, Ar₂₀, and Ar₂₁ each represent a substituted or unsubstituted aromatic hydrocarbon group, a substituted or unsubstituted heterocyclic group, a substituted or unsubstituted fused polycyclic aromatic hydrocarbon group, or a substituted or unsubstituted fused polycyclic heterocyclic group, Ar₁₈, Ar₁₉, Ar₂₀, and Ar₂₁ may be identical to or different from one another, and two arbitrary adjacent groups of Ar₁₈, Ar₁₉, Ar₂₀, and Ar₂₁ may be bonded to each other to form a ring; and
r represents an integer of 1 to 10;

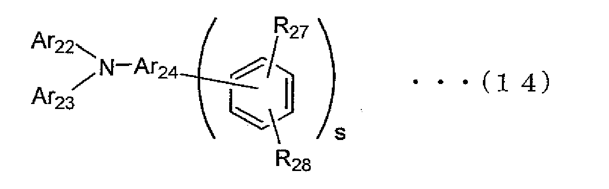

where: R₂₇ and R₂₈ each represent a hydrogen atom, a substituted or unsubstituted alkyl group, a substituted or unsubstituted aralkyl group, a substituted or unsubstituted aryl group, a substituted or unsubstituted heterocyclic group, a cyano group, or a halogen atom, R₂₇s or R₂₈s bonded to different phenylene groups maybe identical to or different from each other, and R₂₇ and R₂₈ bonded to the same phenylene group may be identical to or different from each other;
Ar₂₂ and Ar₂₃ each represent a substituted or unsubstituted aromatic hydrocarbon group, a substituted or unsubstituted heterocyclic group, a substituted or unsubstituted fused polycyclic aromatic hydrocarbon group, or a substituted or unsubstituted fused polycyclic heterocyclic group, Ar₂₂ and Ar₂₃ may be identical to or different from each other, and Ar₂₂ and Ar₂₃ may be bonded to each other to form a ring;
Ar₂₄ represents a divalent, substituted or unsubstituted aromatic hydrocarbon group, or a divalent, substituted or unsubstituted heterocyclic group; and
s represents an integer of 1 to 10;

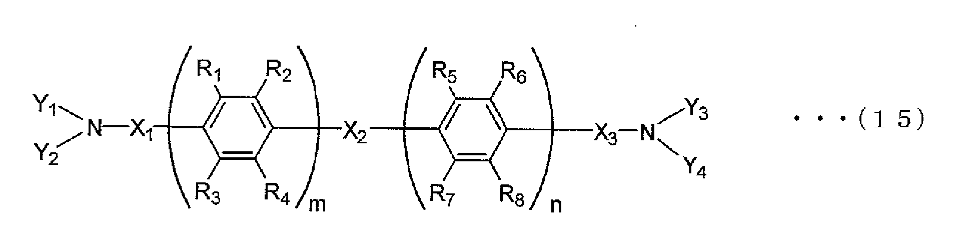

where: X₁, X₂, and X₃ each represent a divalent group selected from the group consisting of a direct bond, a substituted or unsubstituted alkylene group, aralkylene group, arylene group, and heterocyclic group, may be identical to or different from one another, and may each represent any one of alkylene, aralkylene, alkenylene, amino, silyl, carbonyl, ether, and thioether groups each having a linking group composed of a substituted or unsubstituted arylene group or a substituted or unsubstituted divalent heterocyclic group;
Y₁ to Y₄ each represent a group selected from the group consisting of a substituted or unsubstituted alkyl group, aralkyl group, aryl group, and heterocyclic group, a substituted or unsubstituted alkylene group, aralkylene group, alkenylene group, amino group, and silyl group each having a linking group composed of a substituted or unsubstituted arylene group or divalent heterocyclic group, and an unsubstituted carbonyl group, or ether group, and thioether group each having a linking group composed of a substituted or unsubstituted arylene group or divalent heterocyclic group, and may be identical to or different from one another, and Y₁ and Y₂, or Y₃ and Y₄ may be bonded to each other to form a ring, or X₁, Y₁, and Y₂, or X₃, Y₃, and Y₄ may be bonded to one another to form a ring;
R₁ to R₈ each represent a group selected from the group consisting of a hydrogen atom, a halogen, a substituted or unsubstituted alkyl group, aralkyl group, and aryl group, and may be identical to or different from one another; and
m + n represents an integer of 0 to 10;

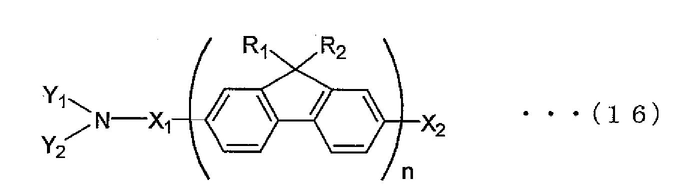

where: X₁ represents a divalent group selected from the group consisting of a substituted or unsubstituted alkylene group, aralkylene group,arylene group,heterocyclic group,alkylene group, aralkylene group, alkenylene group, amino group, silyl group, carbonyl group, ether group, and thioether group each having a linking group composed of a substituted or unsubstituted arylene group or divalent heterocyclic group, and may represent a direct bond;
X₂ represents a group selected from the group consisting of a hydrogen atom, a halogen, a substituted or unsubstituted alkyl group, aralkyl group, alkenyl group, alkynyl group, alkoxy group, aryl group, heterocyclic group, sulfide group, a substituted silyl group, and a cyano group;
Y₁ and Y₂ each represent a group selected from the group consisting of a substituted or unsubstituted alkyl group, aralkyl group, aryl group, and heterocyclic group, a substituted or unsubstituted alkylene group, aralkylene group, alkenylene group, amino group, and silyl group each having a linking group composed of a substituted or unsubstituted arylene group or divalent heterocyclic group, and an unsubstituted carbonyl group, or ether group, and thioether group each having a linking group composed of a substituted or unsubstituted arylene group or a substituted or unsubstituted divalent heterocyclic group, and may be identical to or different from each other, and Y₁ and Y₂, or X₁, Y₁, and Y₂ may be bonded to each other to form a ring;
R₁ and R₂ each represent a group selected from the group consisting of a hydrogen atom, a substituted or unsubstituted alkyl group, aralkyl group, and aryl group, and may be identical to or different from each other; and
n represents an integer of 2 to 10 in the case where X₁ represents a single bond and X₂ represents a hydrogen atom, or represents an integer of 1 to 10 in any other case; and

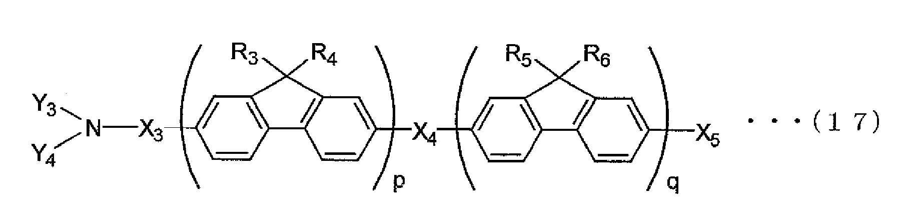

where: X₃ and X₄ each represent a divalent group selected from the group consisting of a substituted or unsubstituted alkylene group, aralkylene group, arylene group, and heterocyclic group, a substituted or unsubstituted alkylene group, aralkylene group, alkenylene group, amino group, and silyl group each having a linking group composed of a substituted or unsubstituted arylene group or divalent heterocyclic group, and an unsubstituted carbonyl group, ether group, and thioether group, and may be identical to or different from each other, and X₃ may represent a single bond;
X₅ represents a group selected from the group consisting of a hydrogen atom, a halogen, a substituted or unsubstituted alkyl group, aralkyl group, alkenyl group, alkynyl group, alkoxy group, aryl group, heterocyclic group, and sulfide group, a substituted silyl group, and a cyano group;
Y₃ and Y₄ each represent a group selected from the group consisting of a substituted or unsubstituted alkyl group, aralkyl group, aryl group, and heterocyclic group, a substituted or unsubstituted alkylene group, aralkylene group, alkenylene group, amino group, and a substituted or unsubstituted silyl group each having a linking group composed of a substituted or unsubstituted arylene group or divalent heterocyclic group, and an unsubstituted carbonyl group, or ether group, and thioether group each having a linking group composed of a substituted or unsubstituted arylene group or divalent heterocyclic group, and may be identical to or different from each other, and Y₃ and Y₄, or X₃, Y₃, and Y₄ may be bonded to each other to form a ring;
R₃ to R₆ each represent a group selected from the group consisting of a hydrogen atom, a substituted or unsubstituted alkyl group, aralkyl group, and aryl group, and may be identical to or different from one another; and
p and q each represent an integer of 1 or more, and p + q represents an integer of 2 to 10.
Specific examples of the amine compound represented by the general formula (2) are shown below. However, the compound is not limited to the examples.

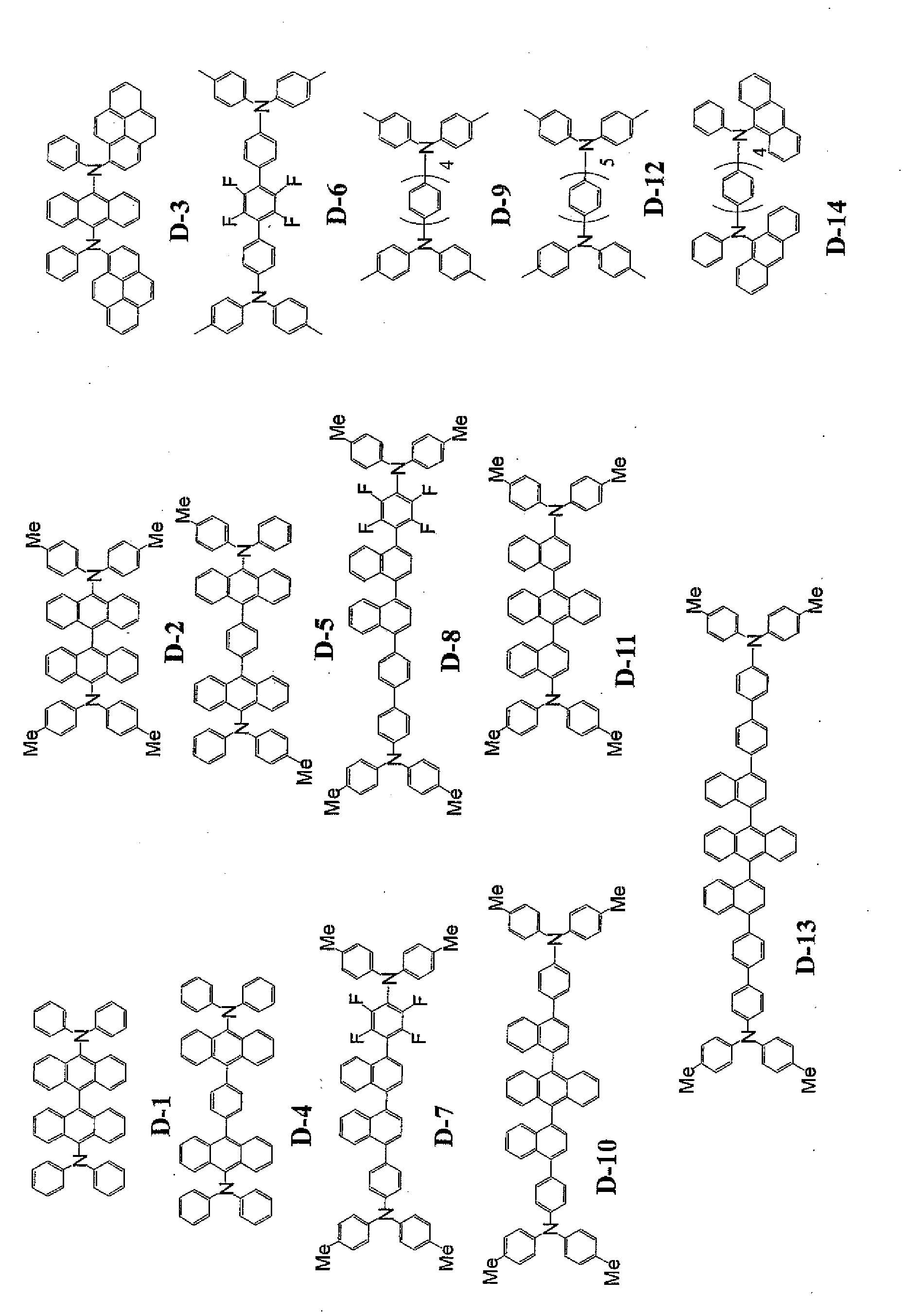

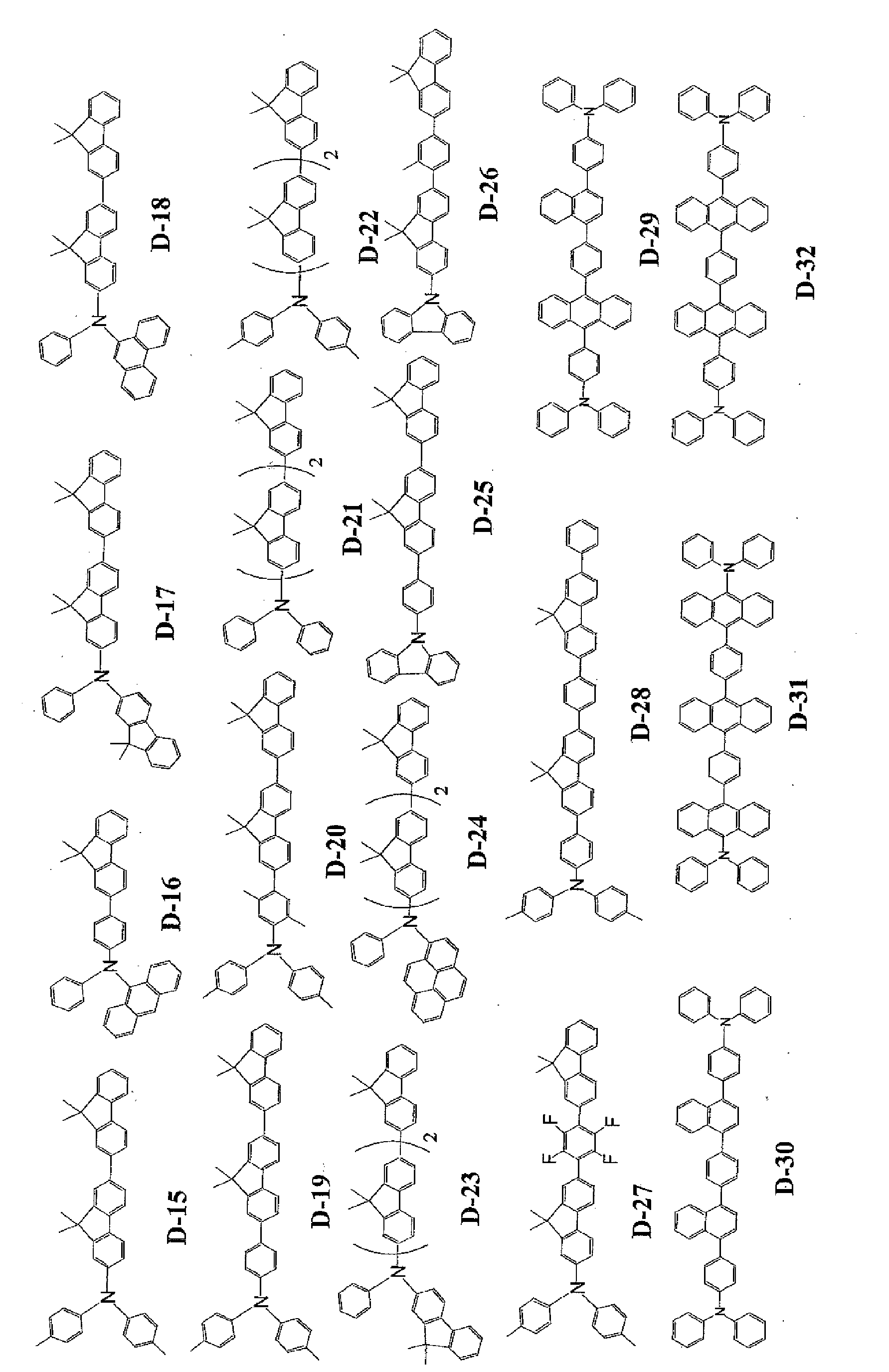

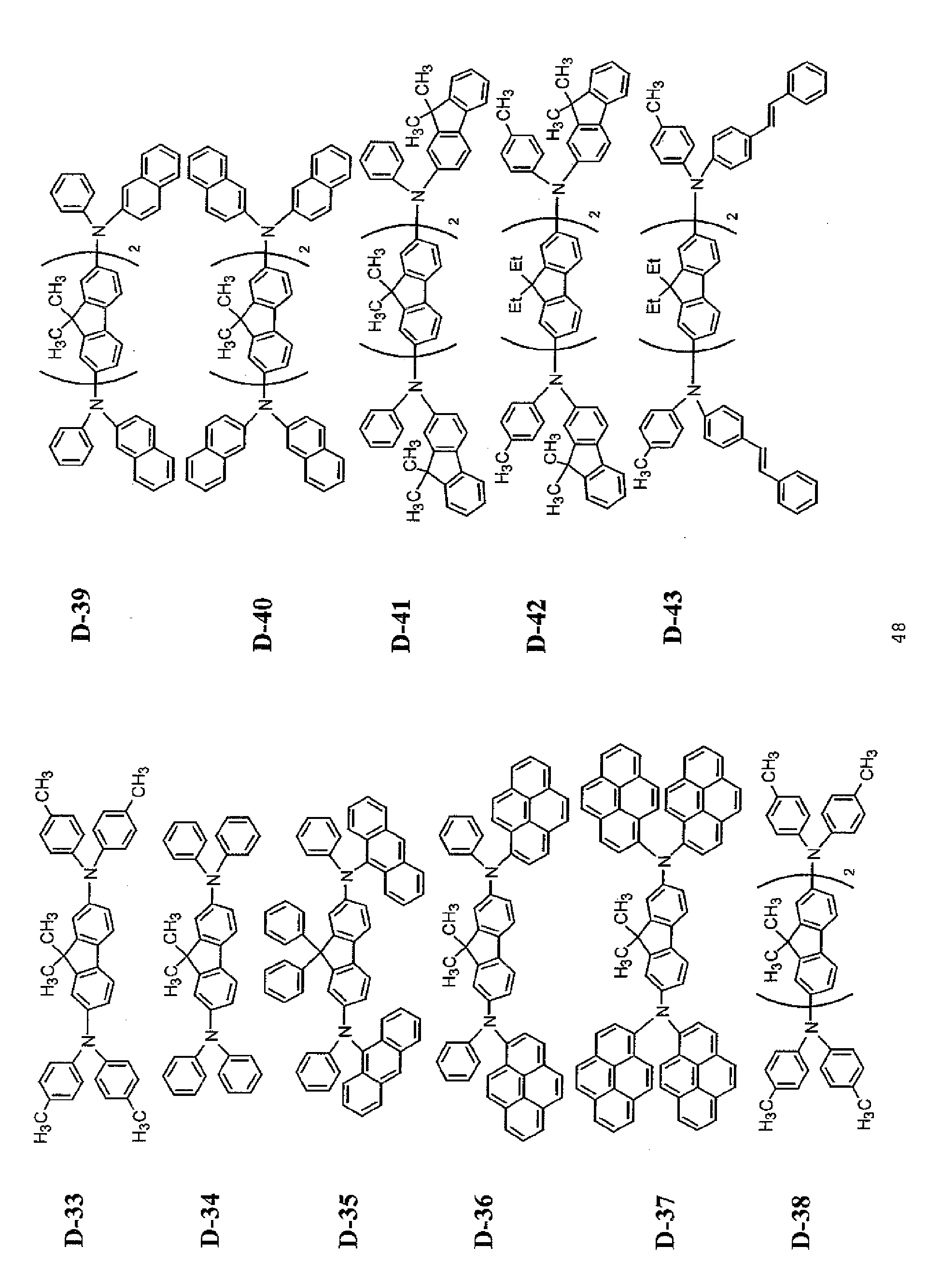

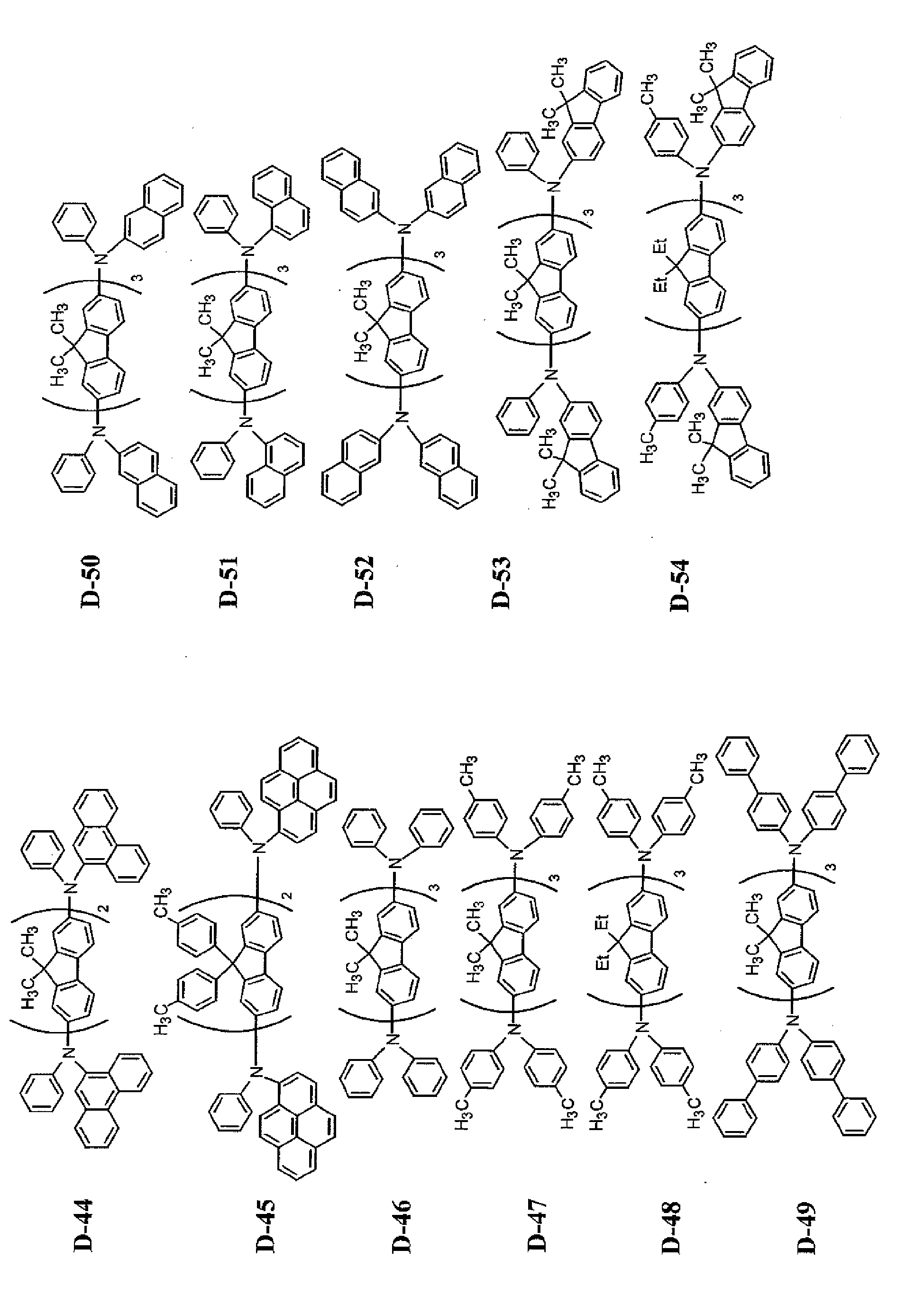

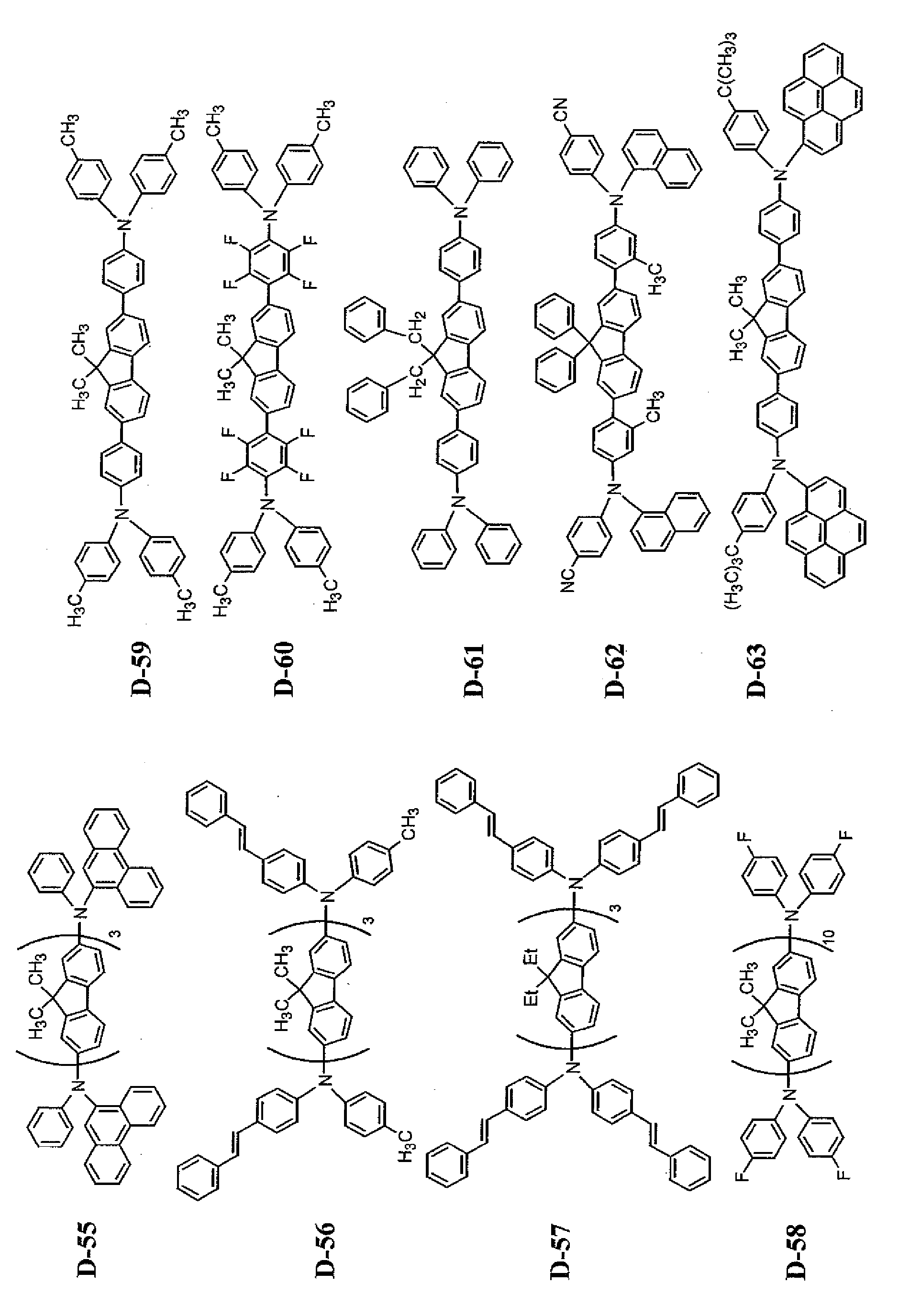

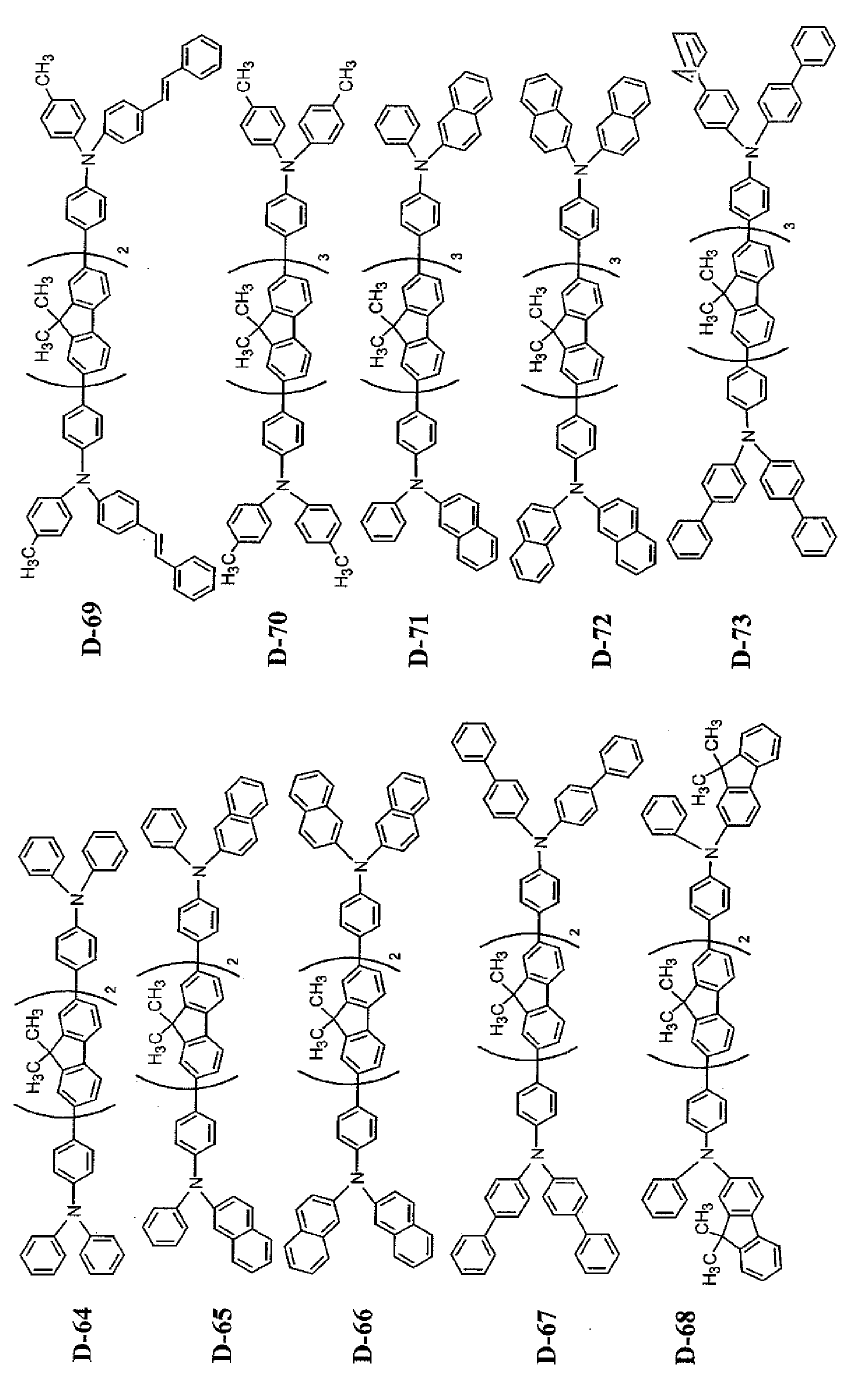

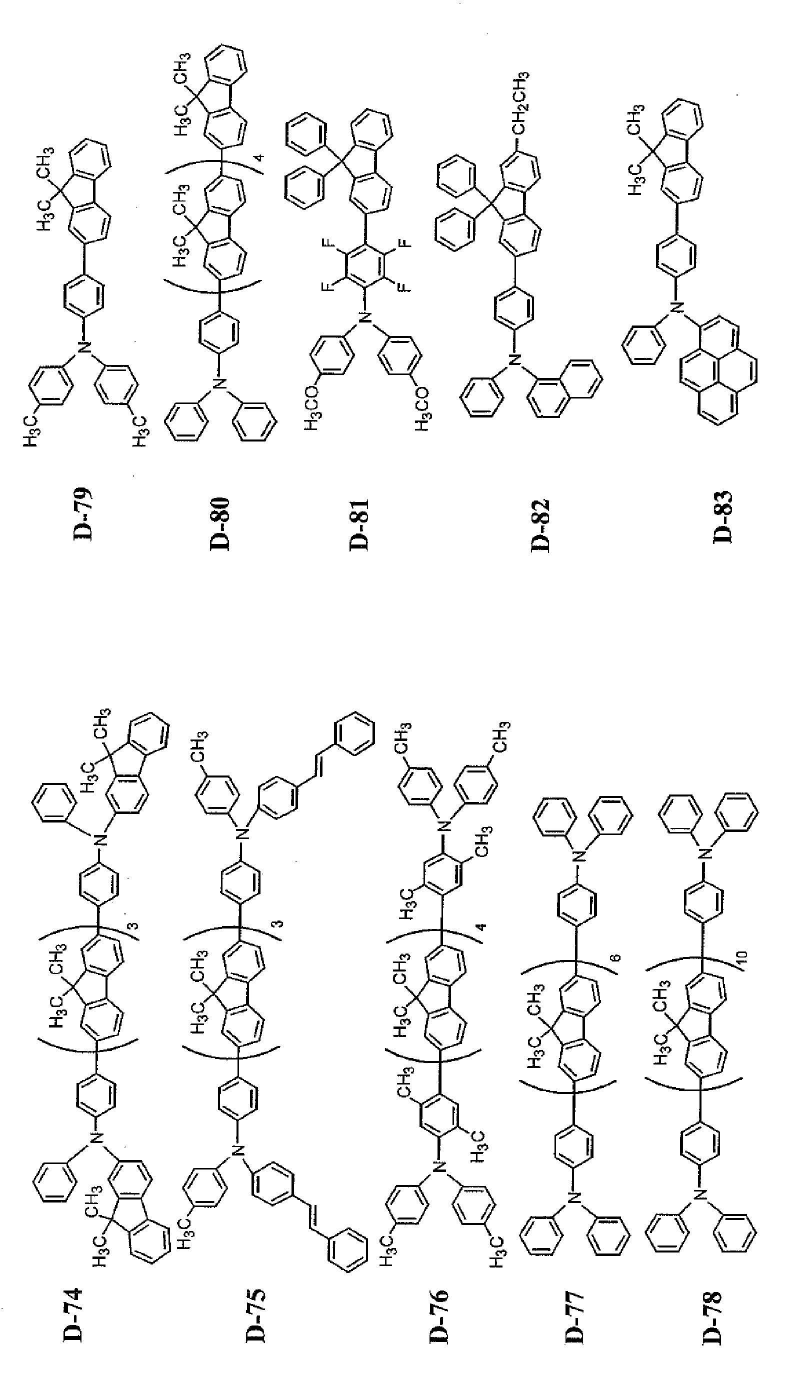

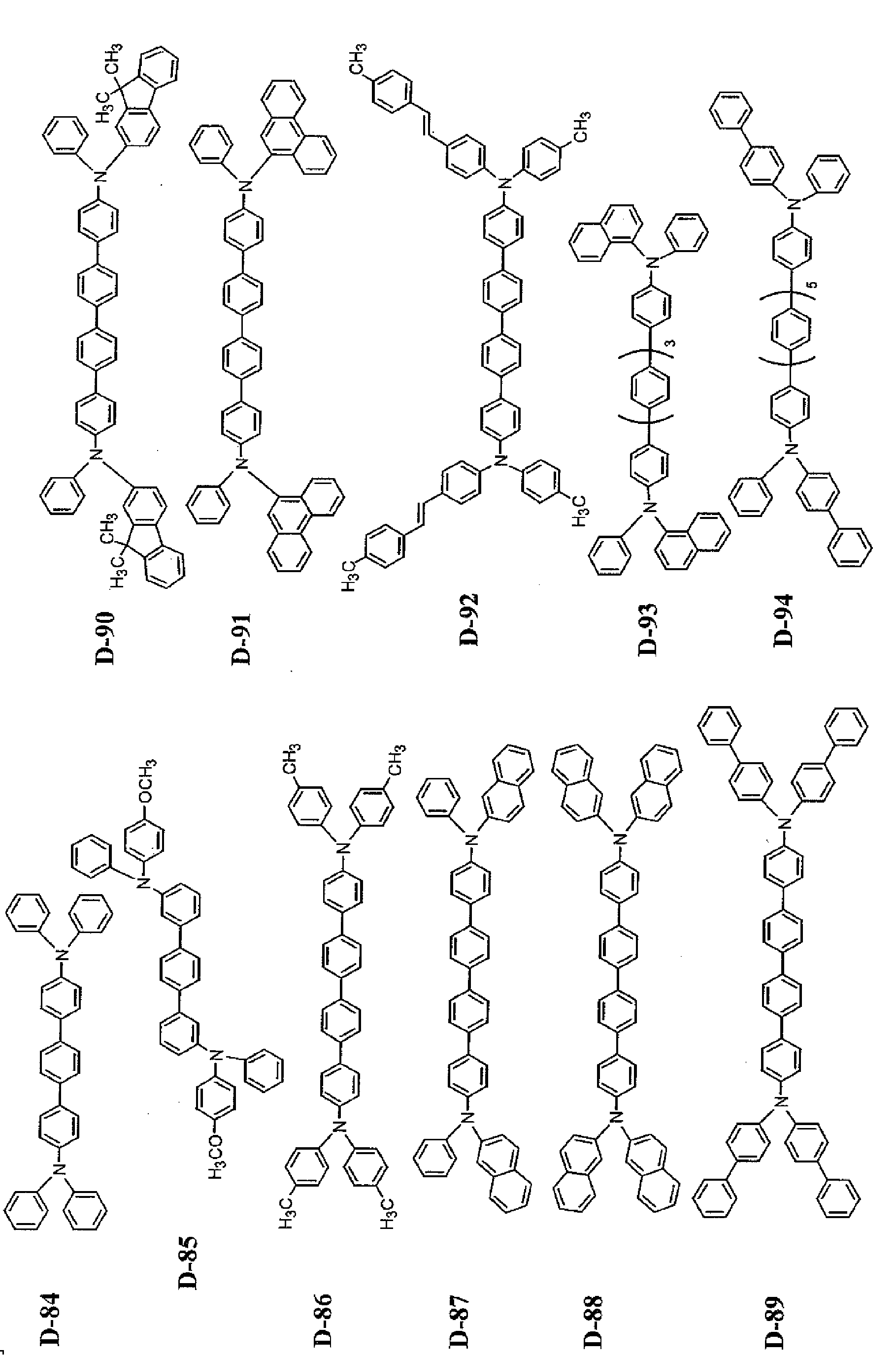

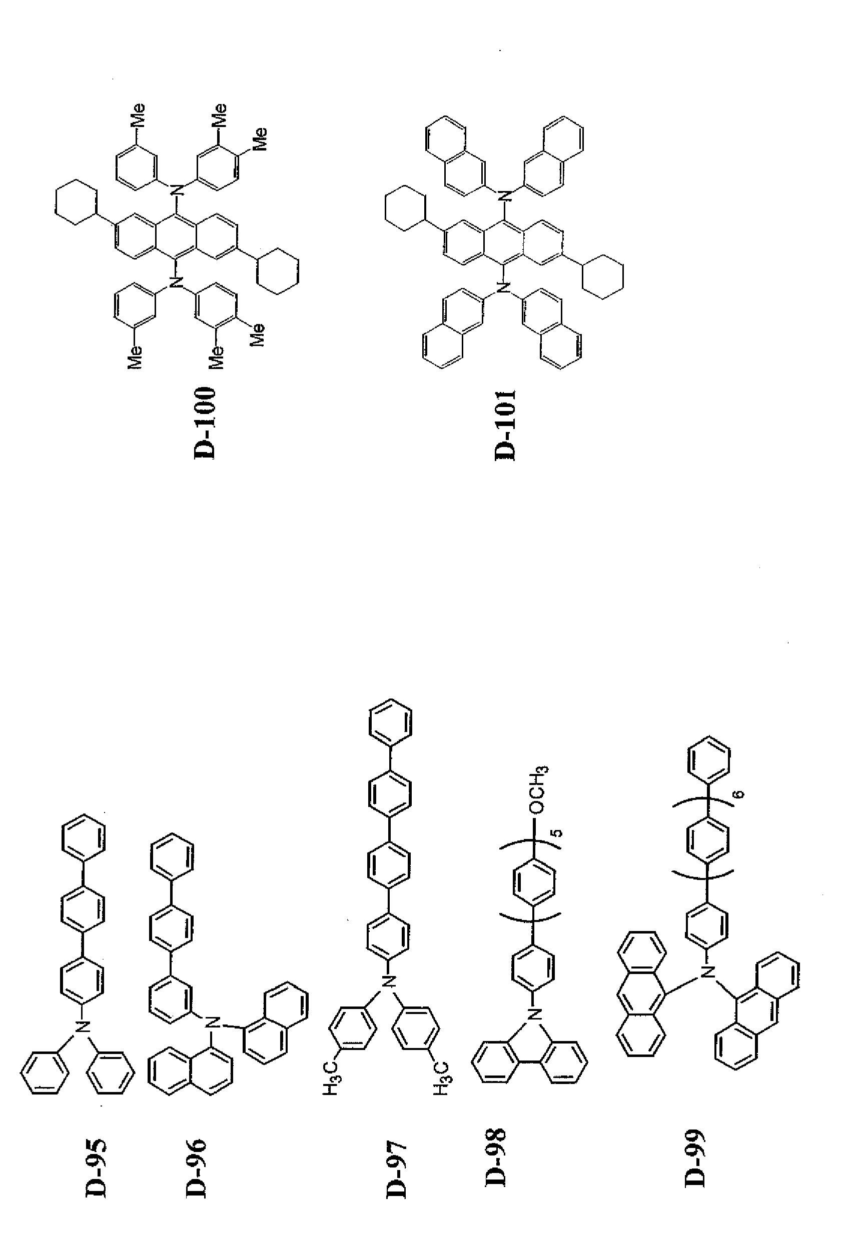

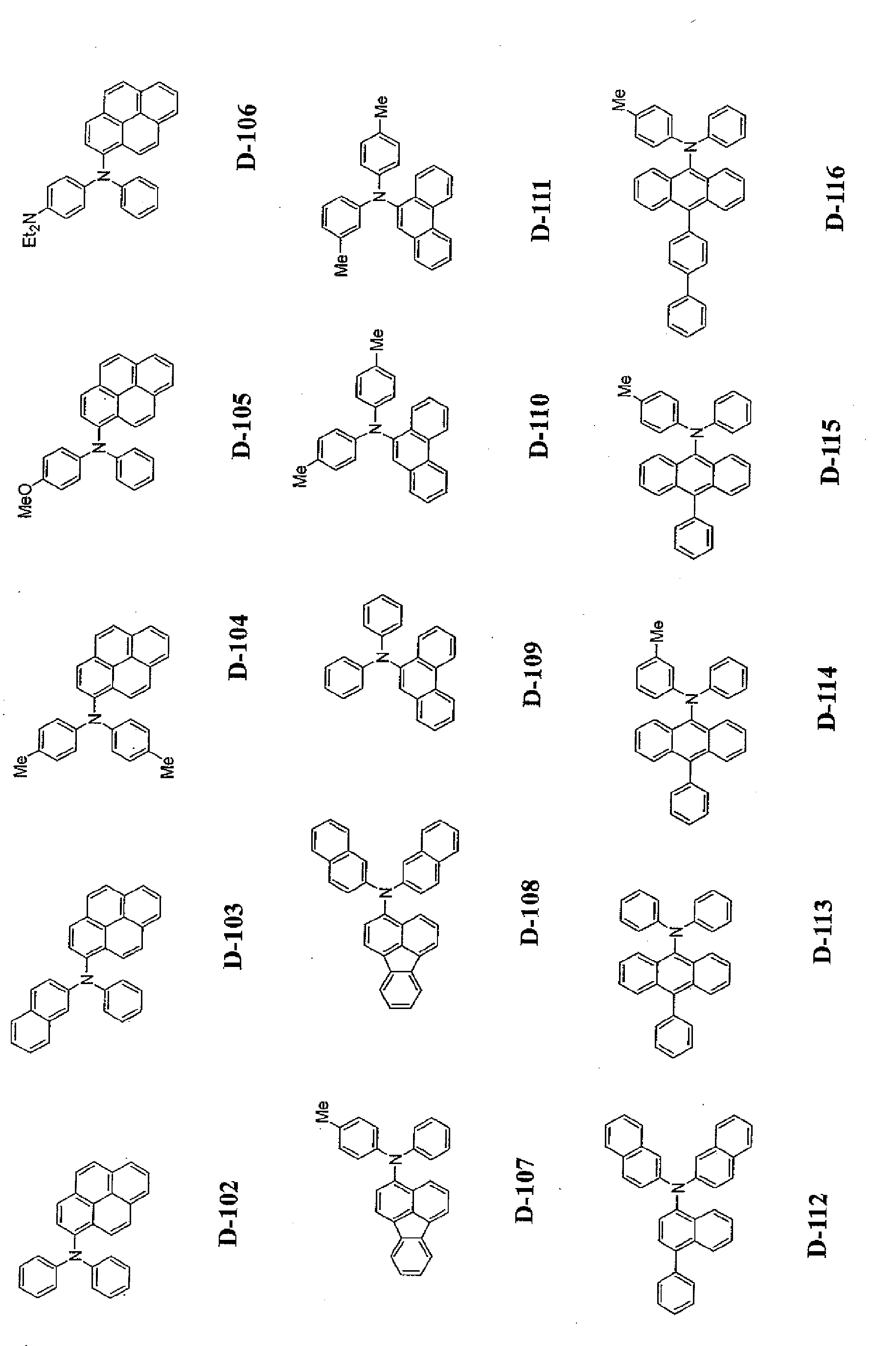

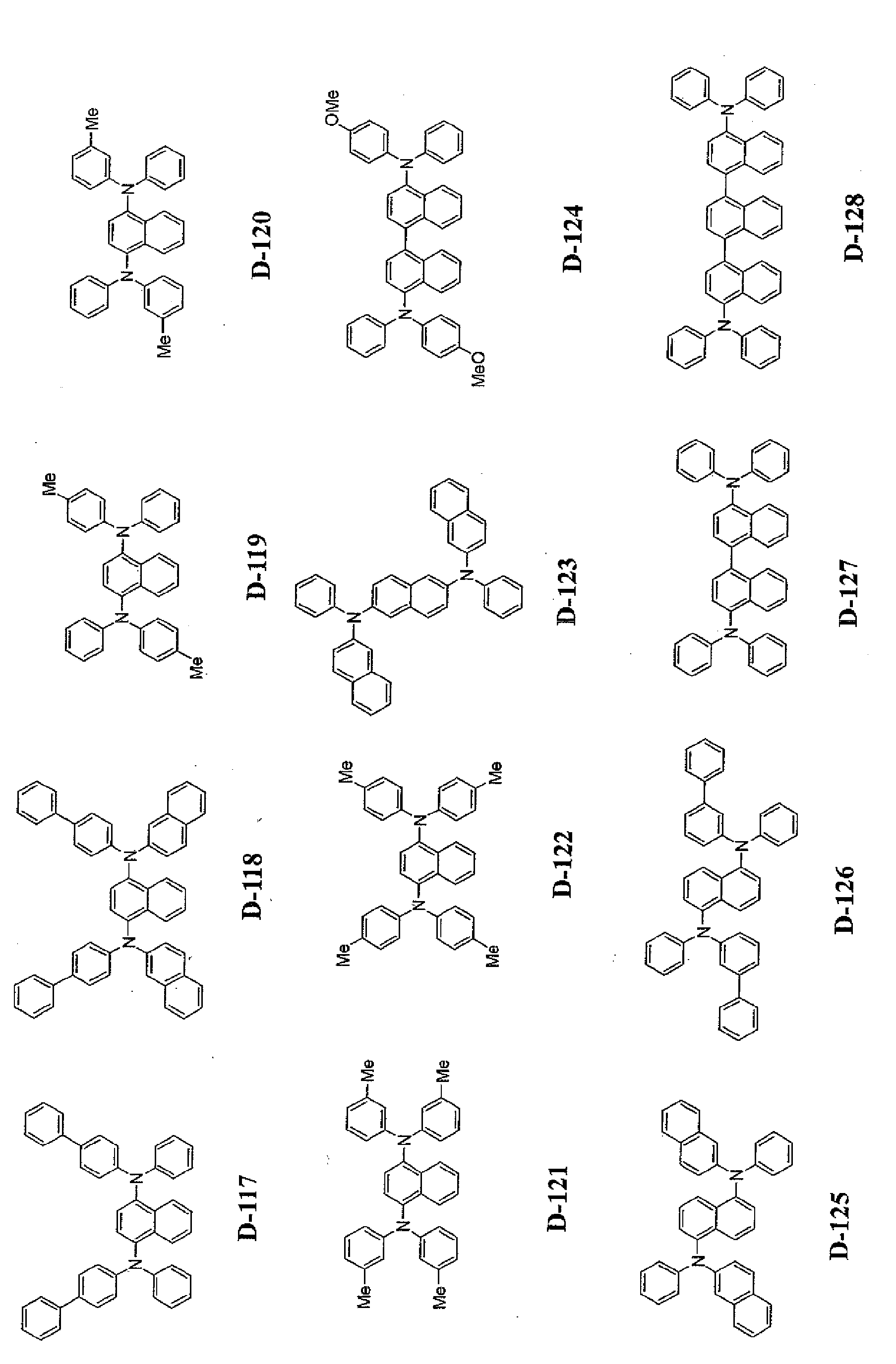

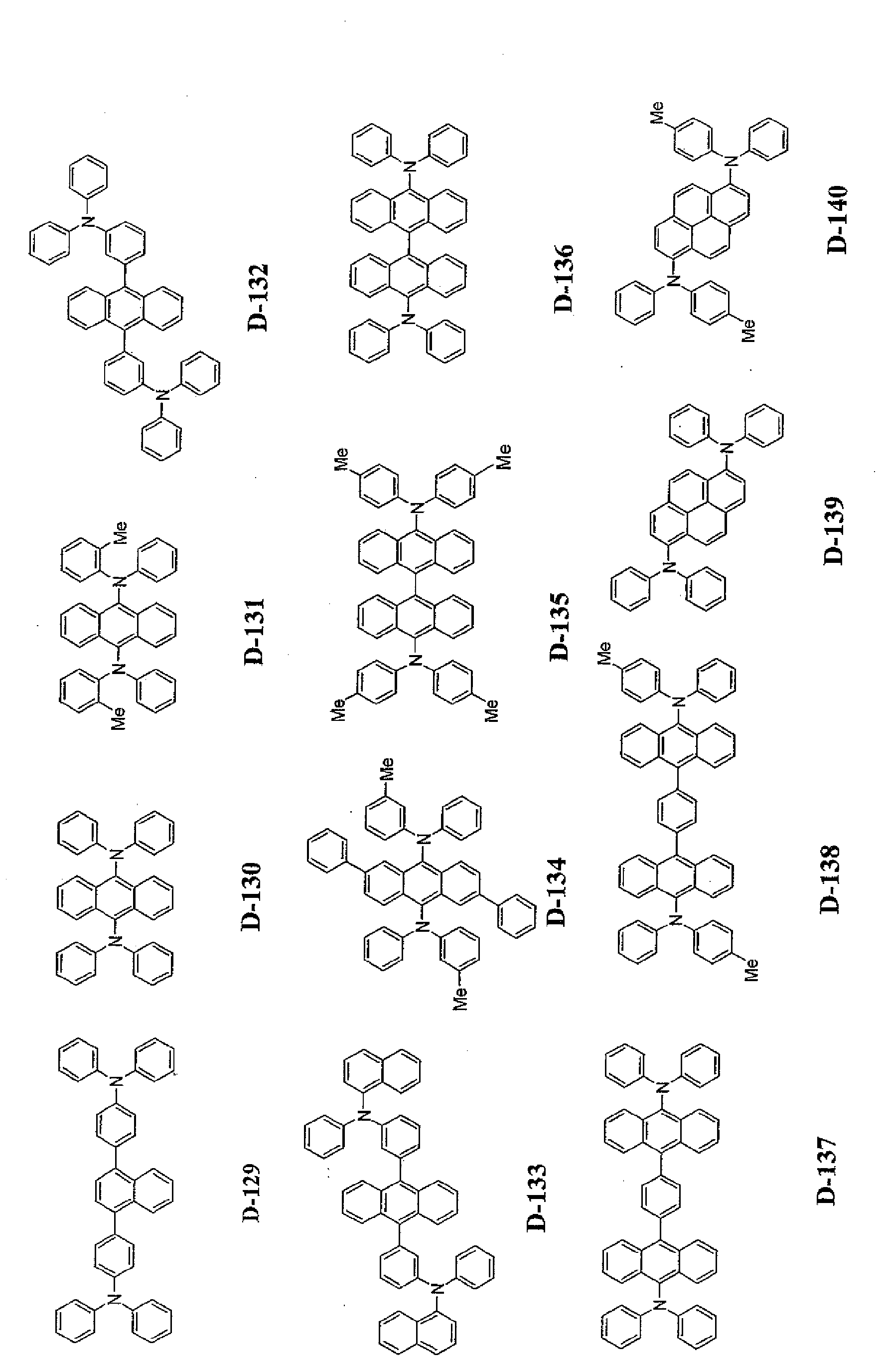

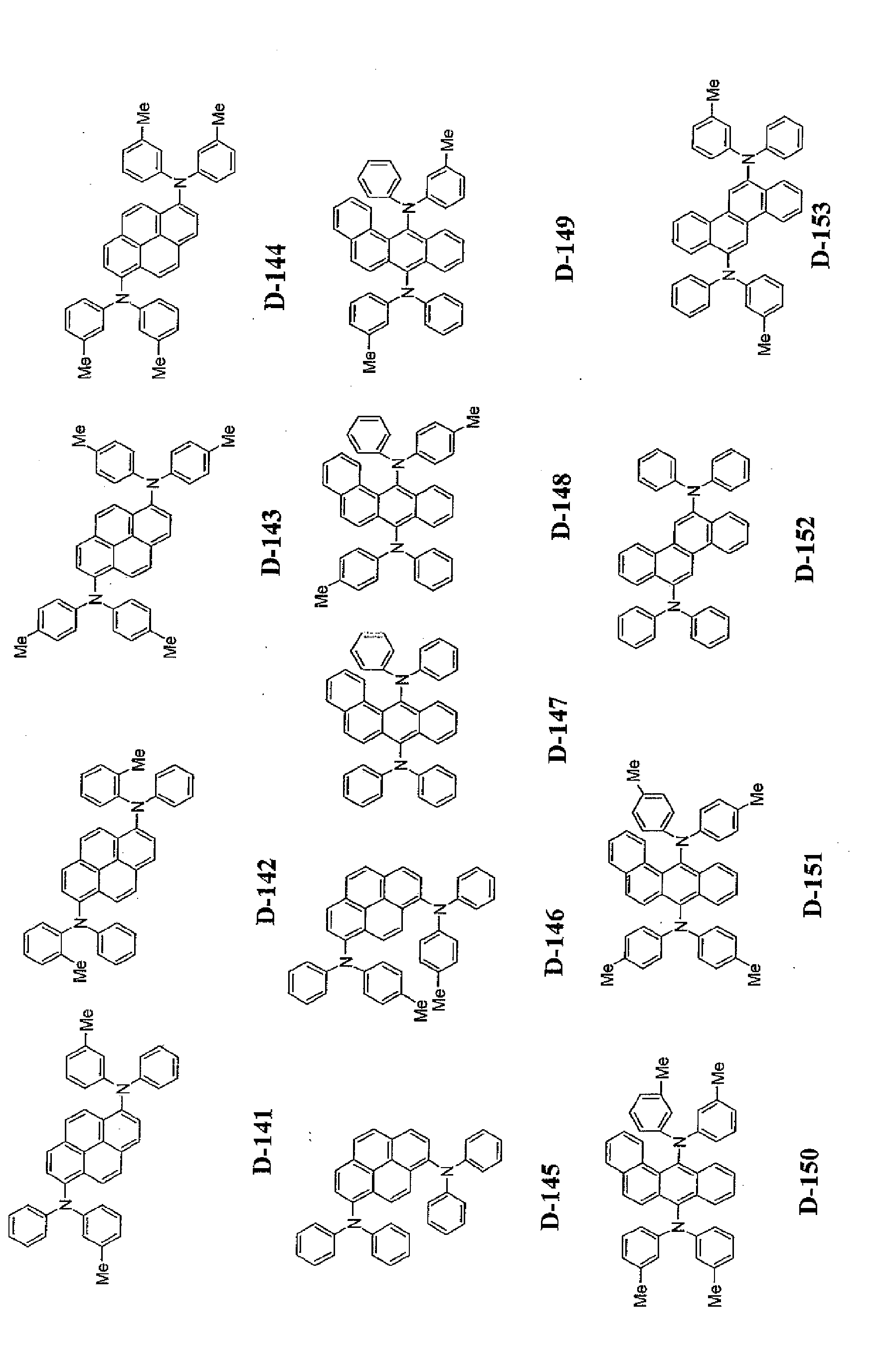

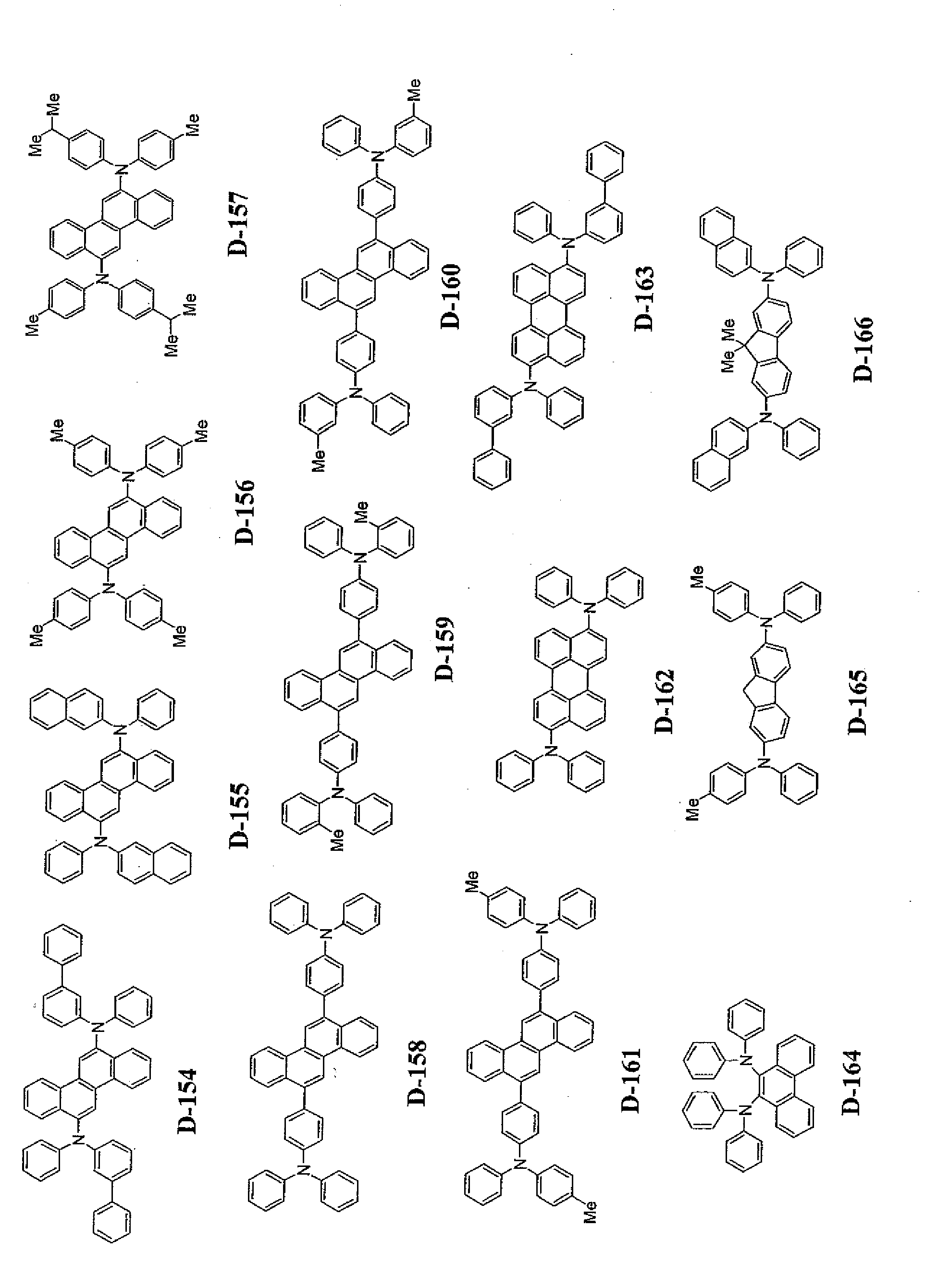

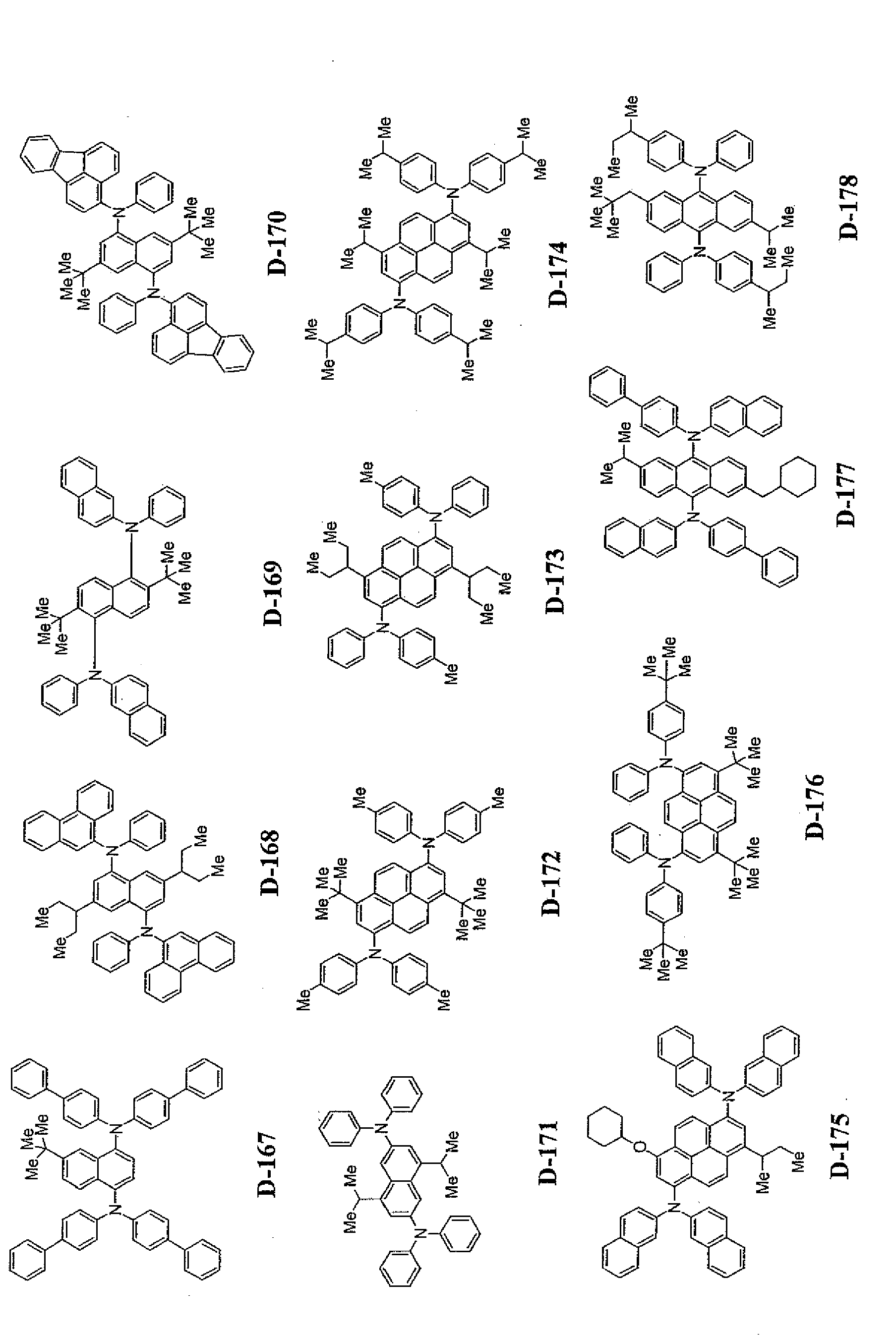

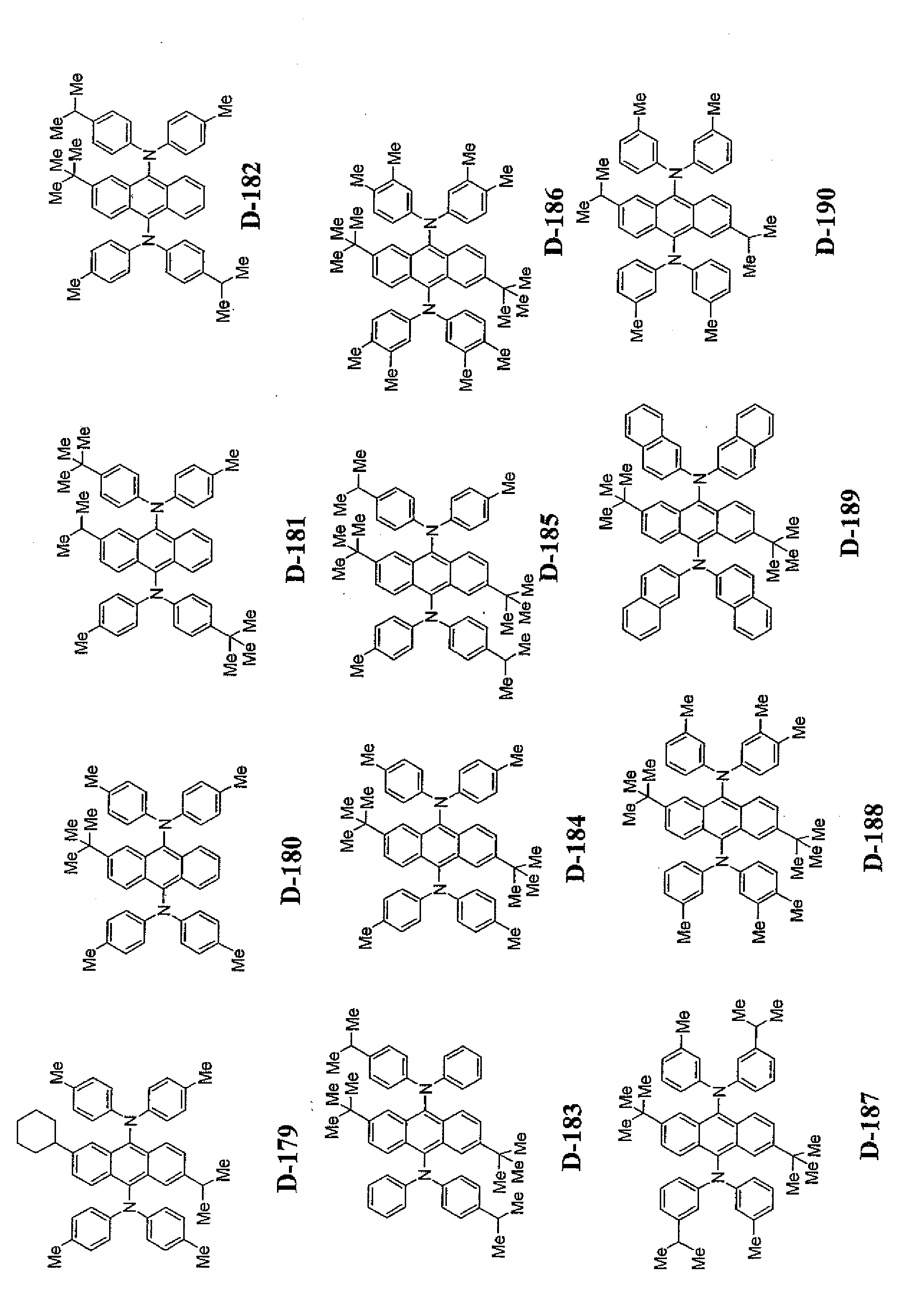

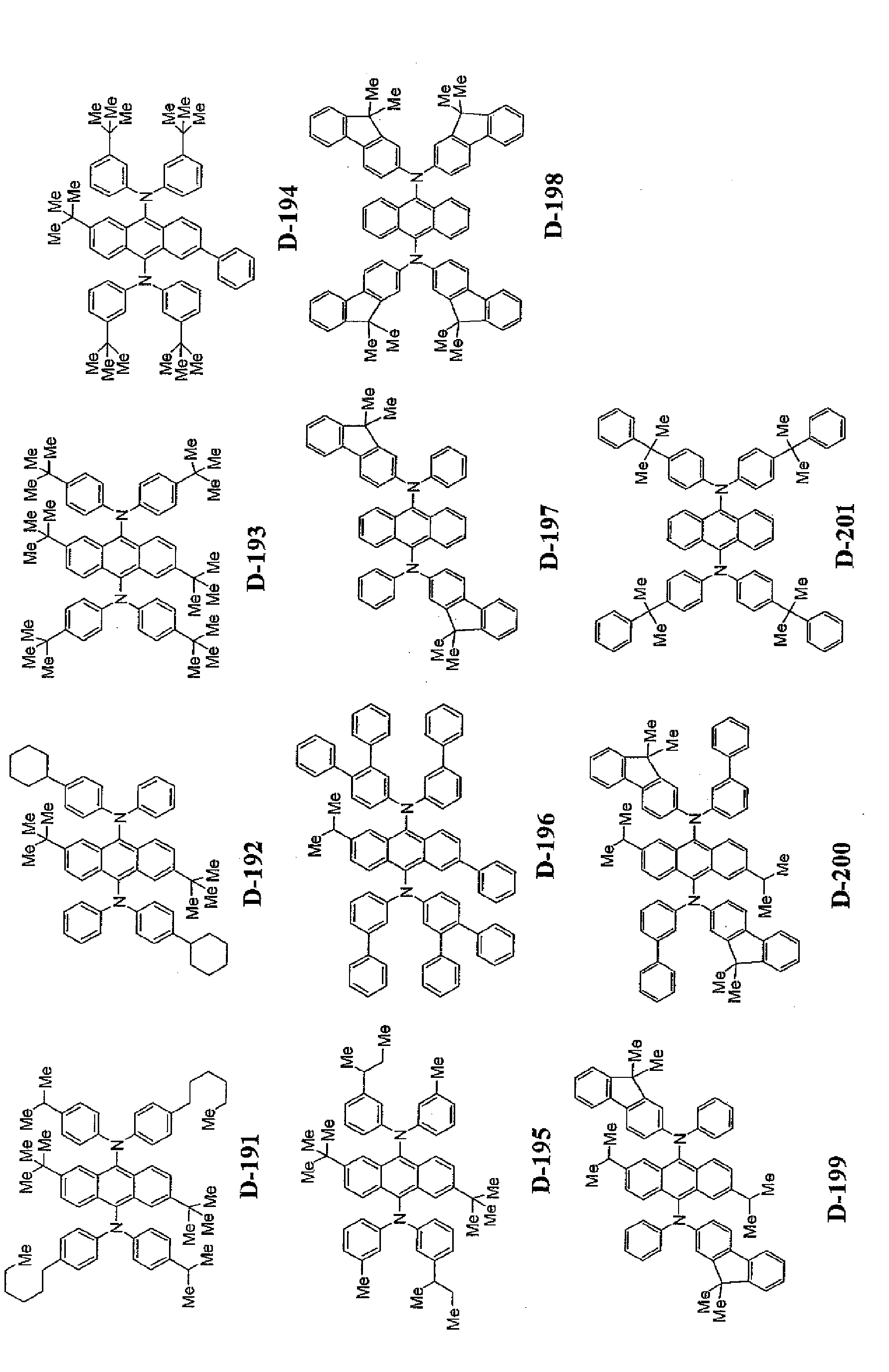

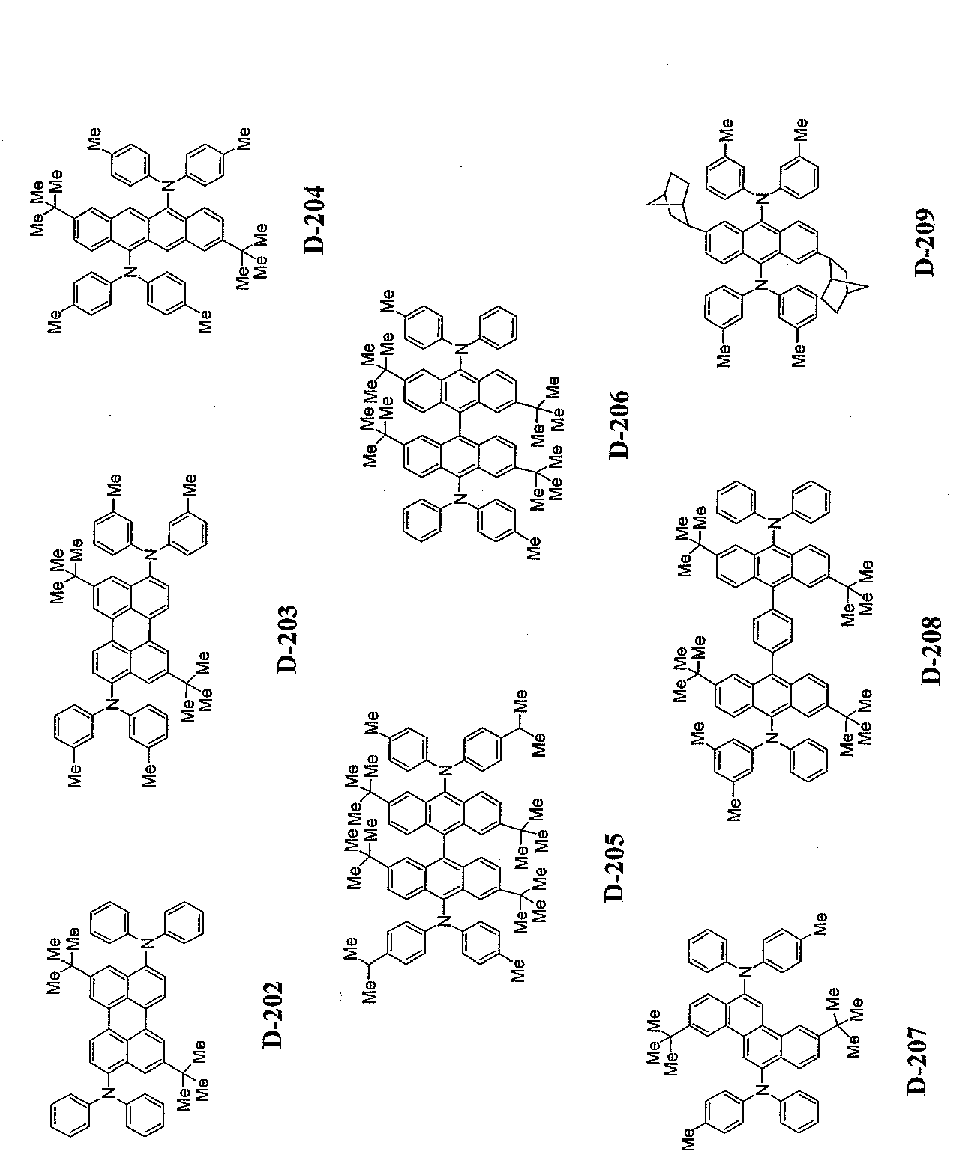

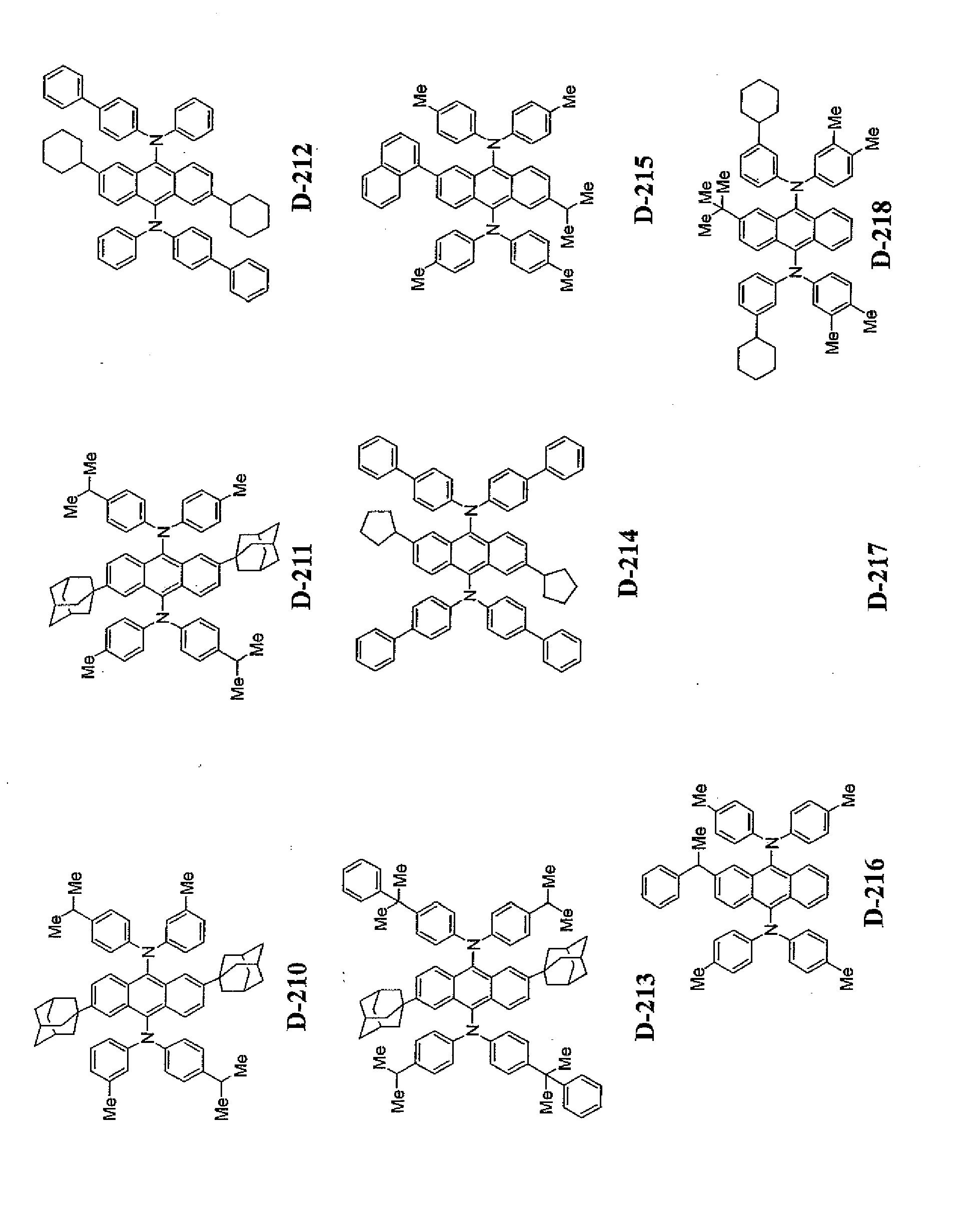

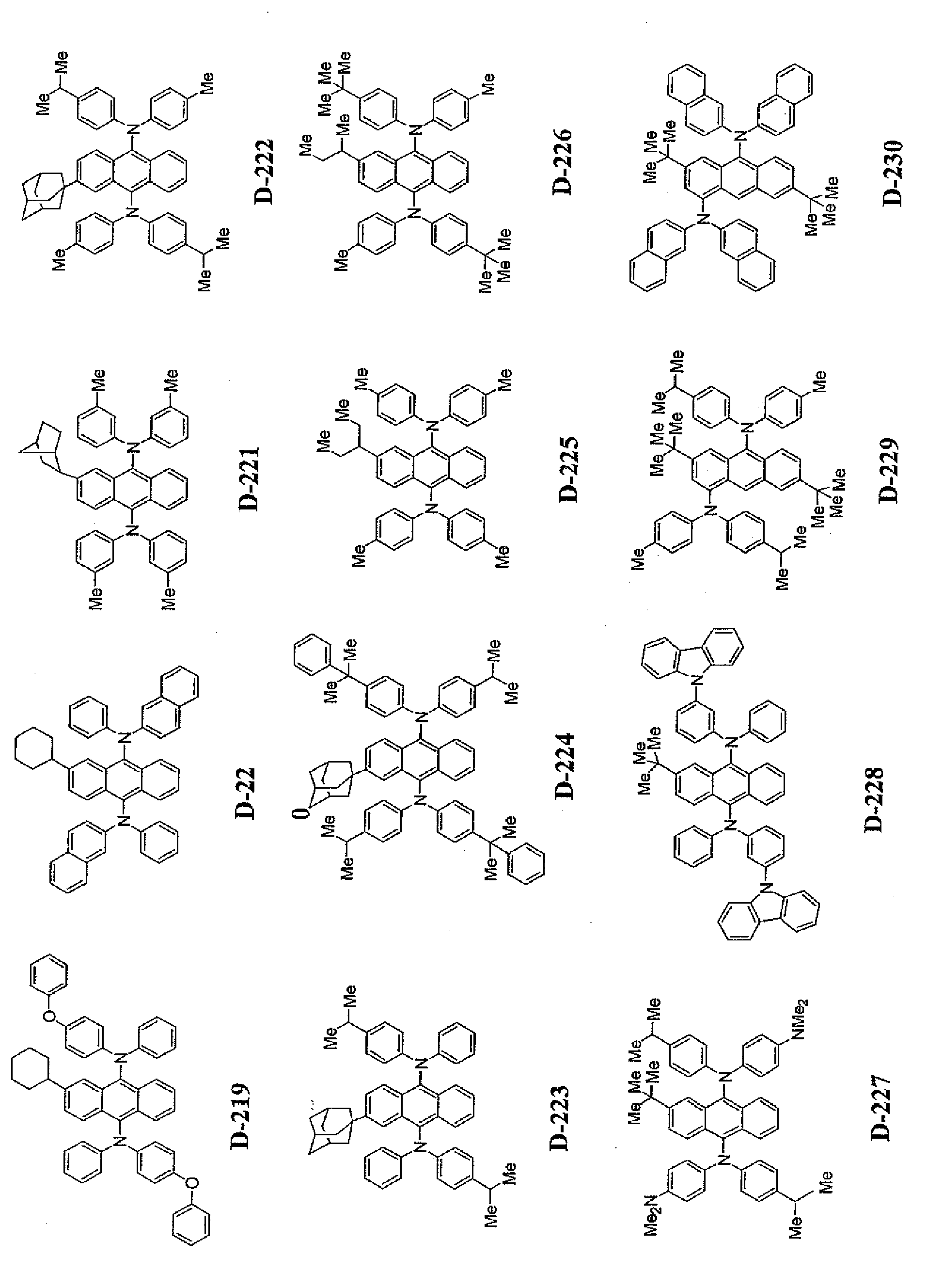

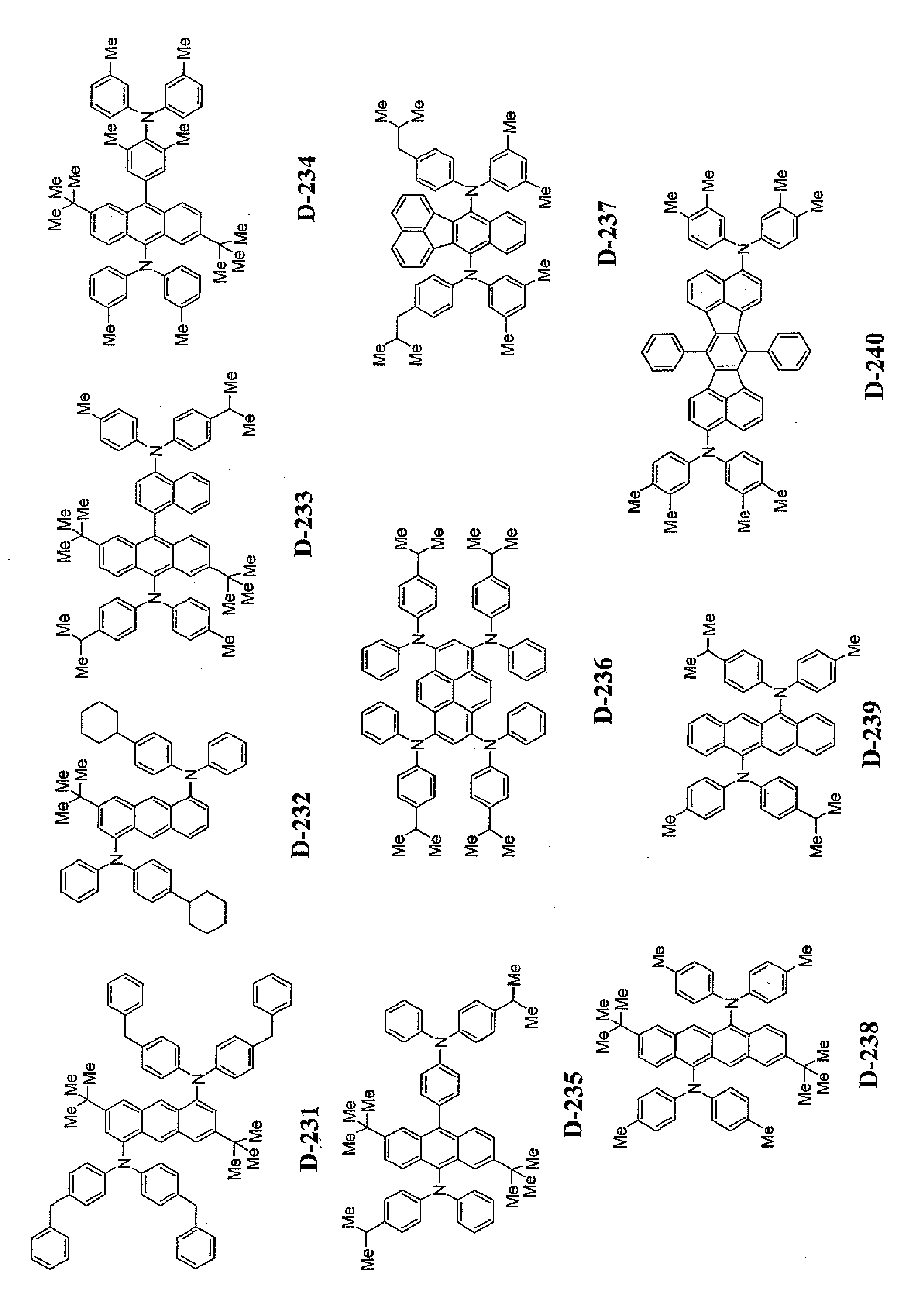

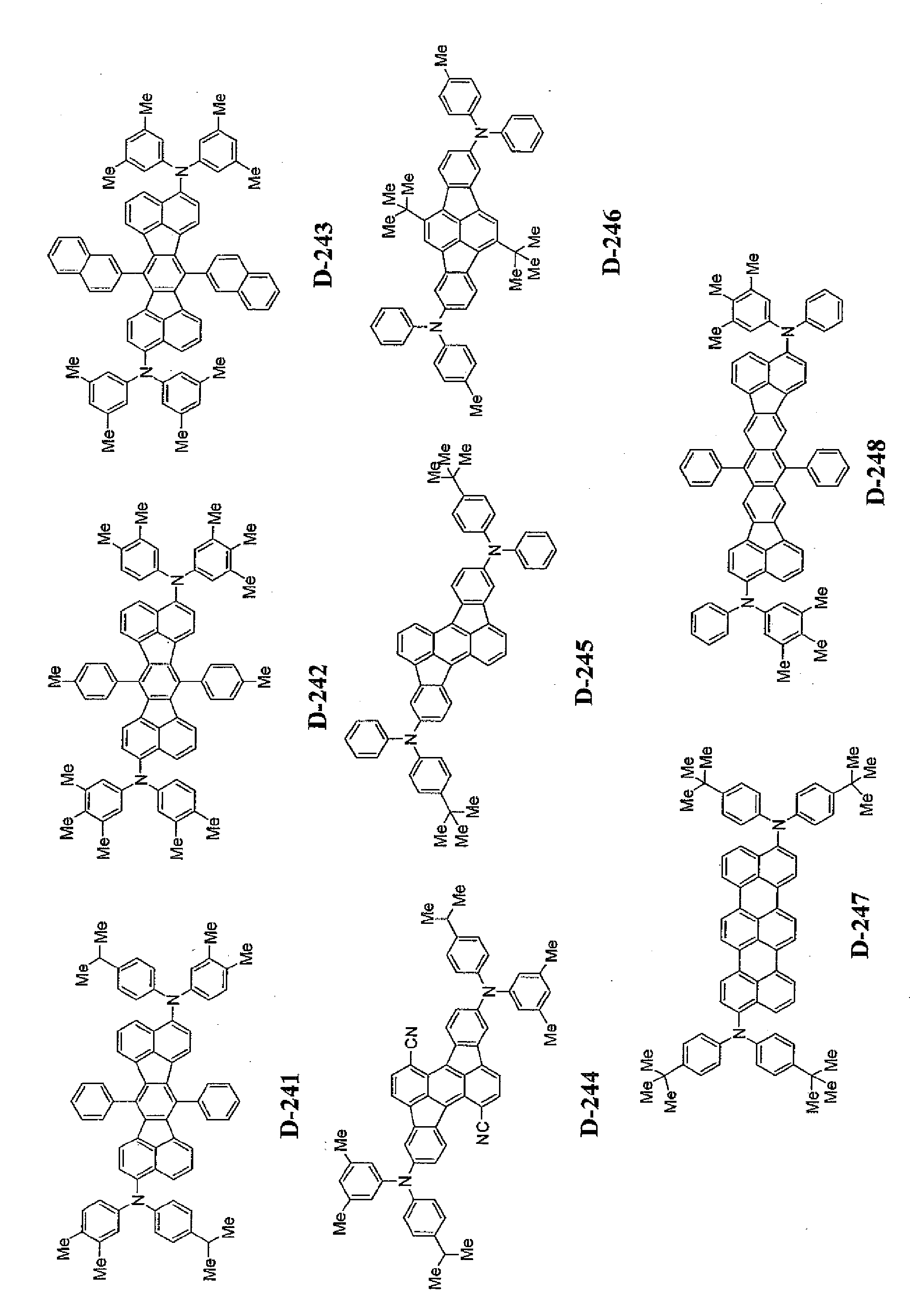

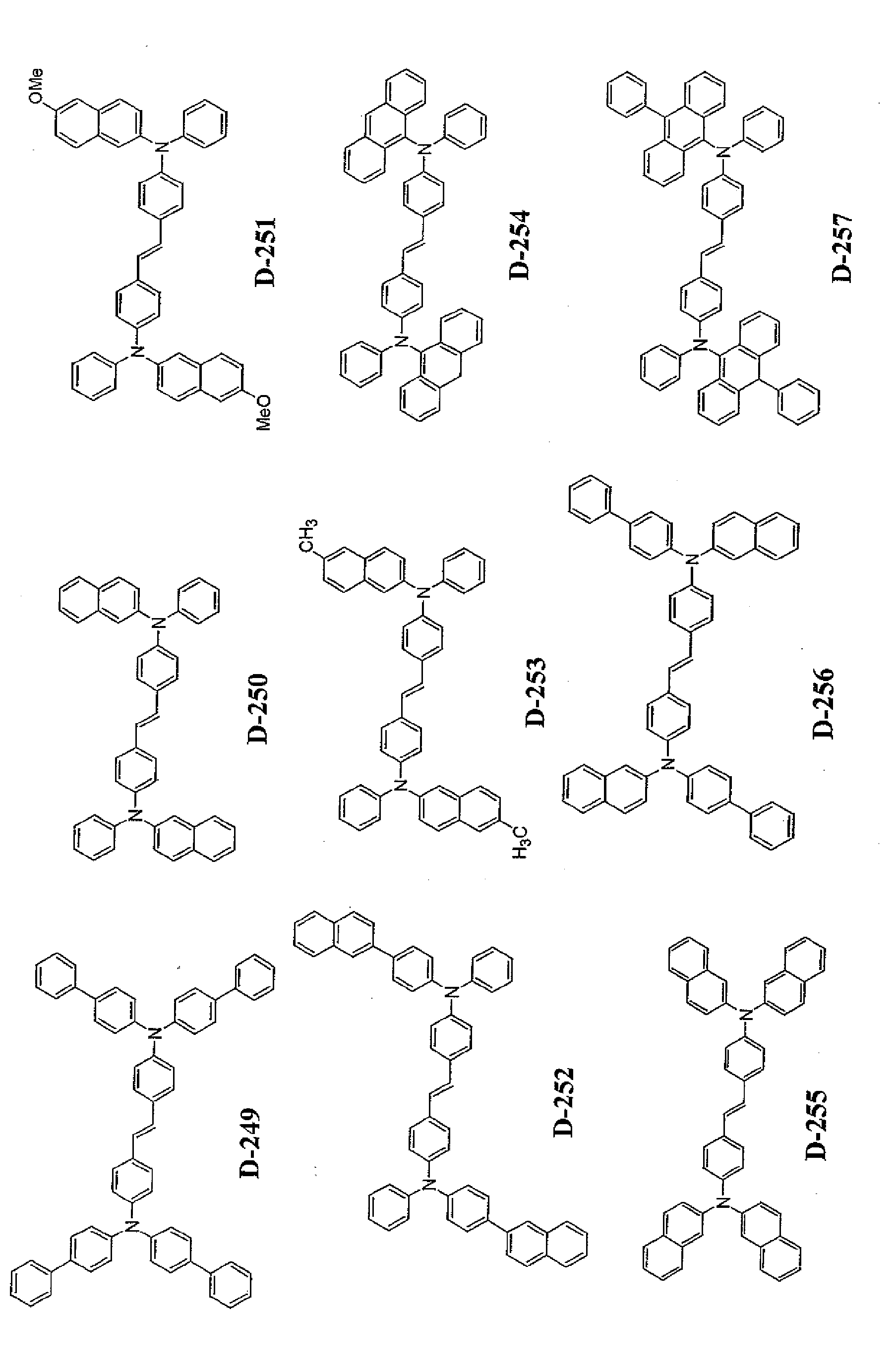

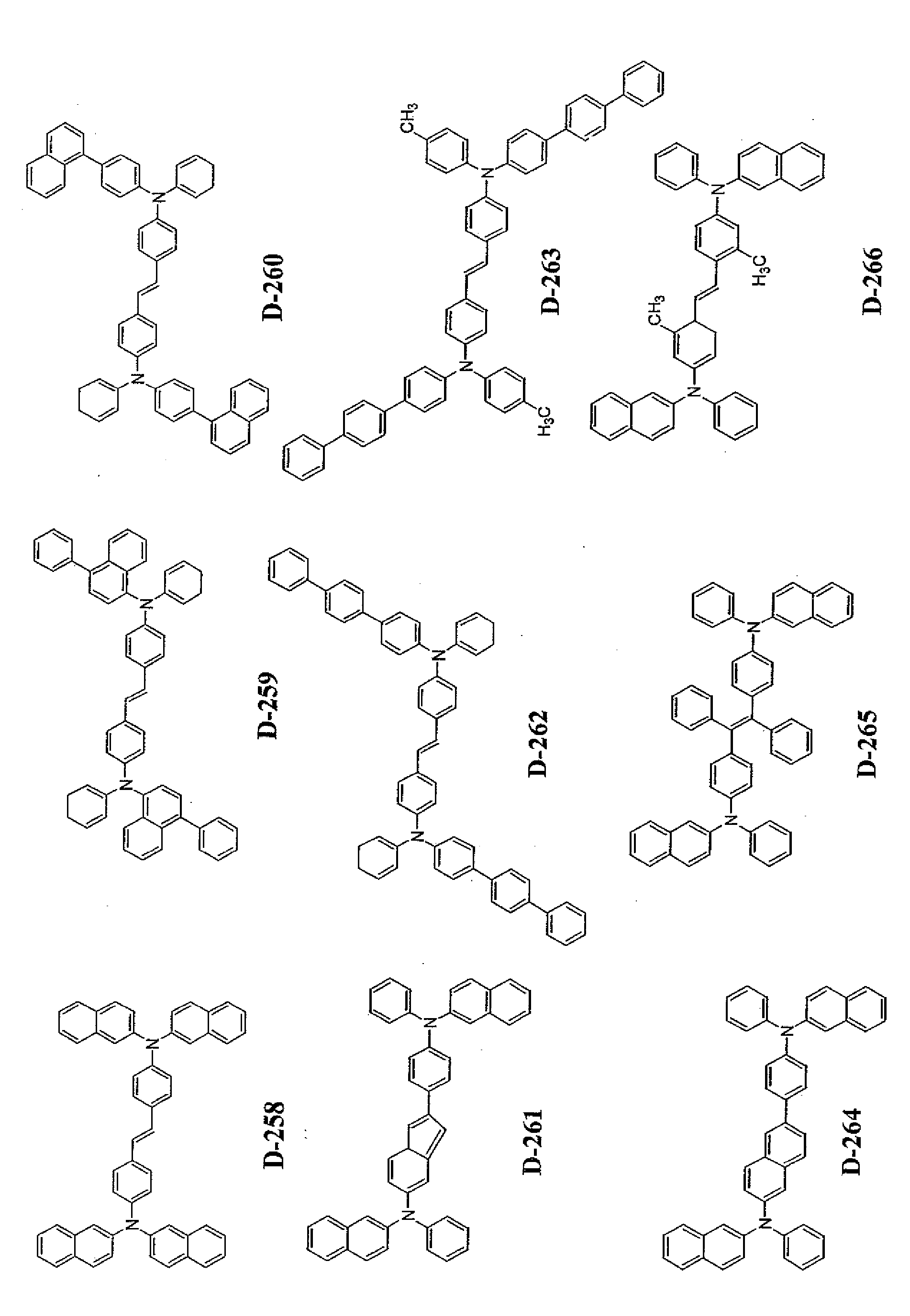

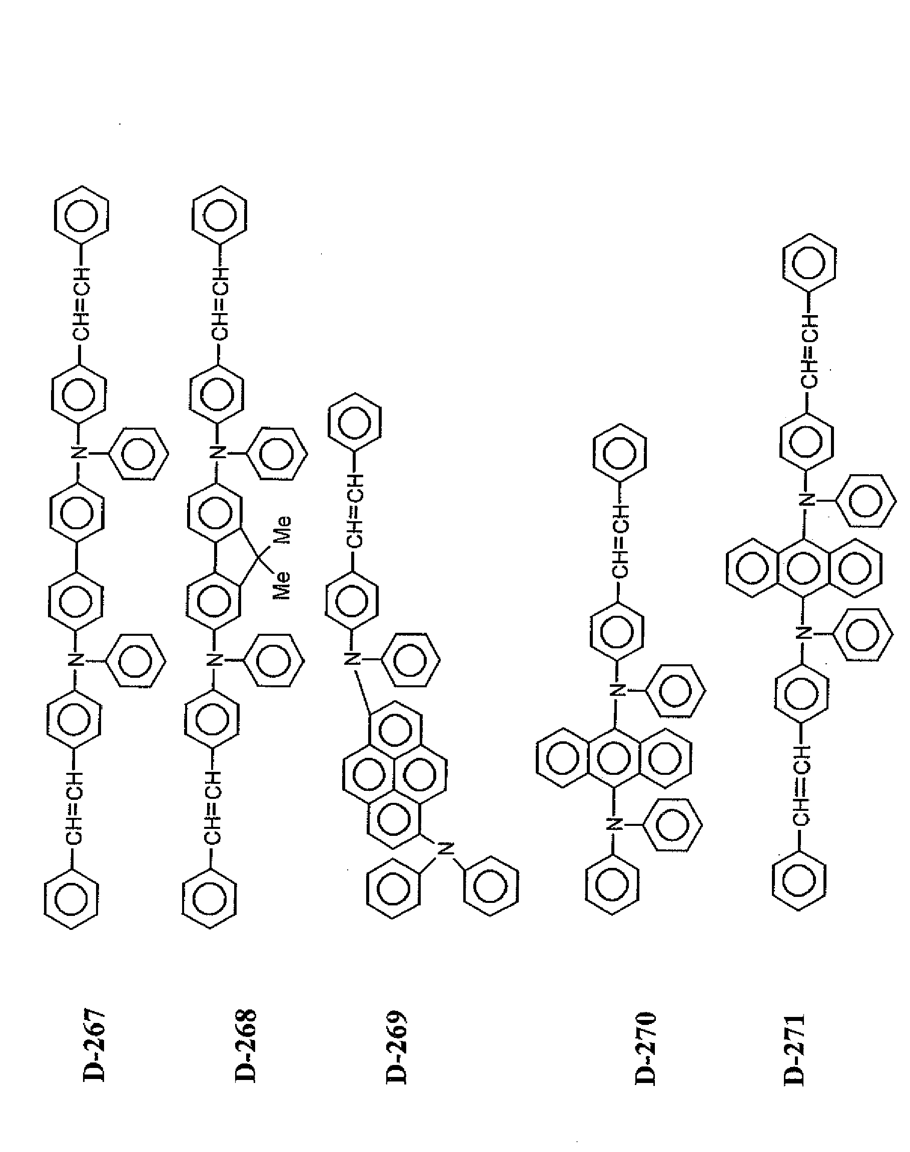

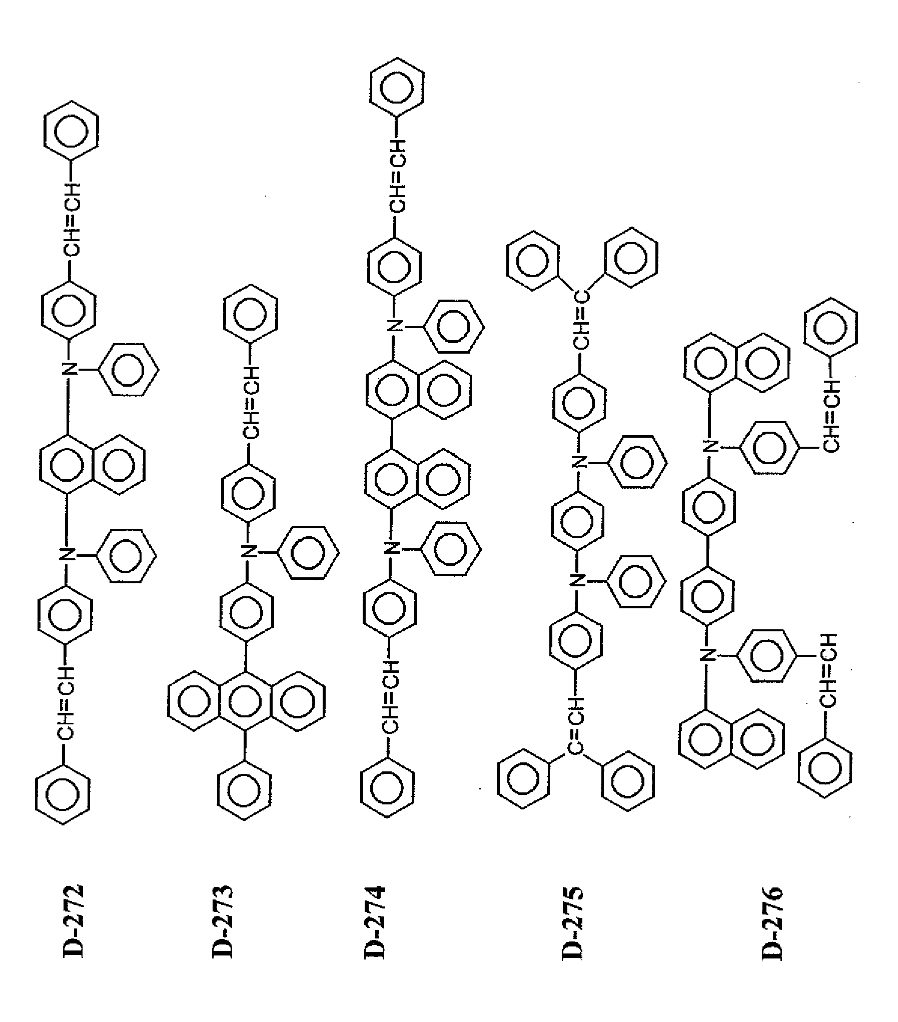

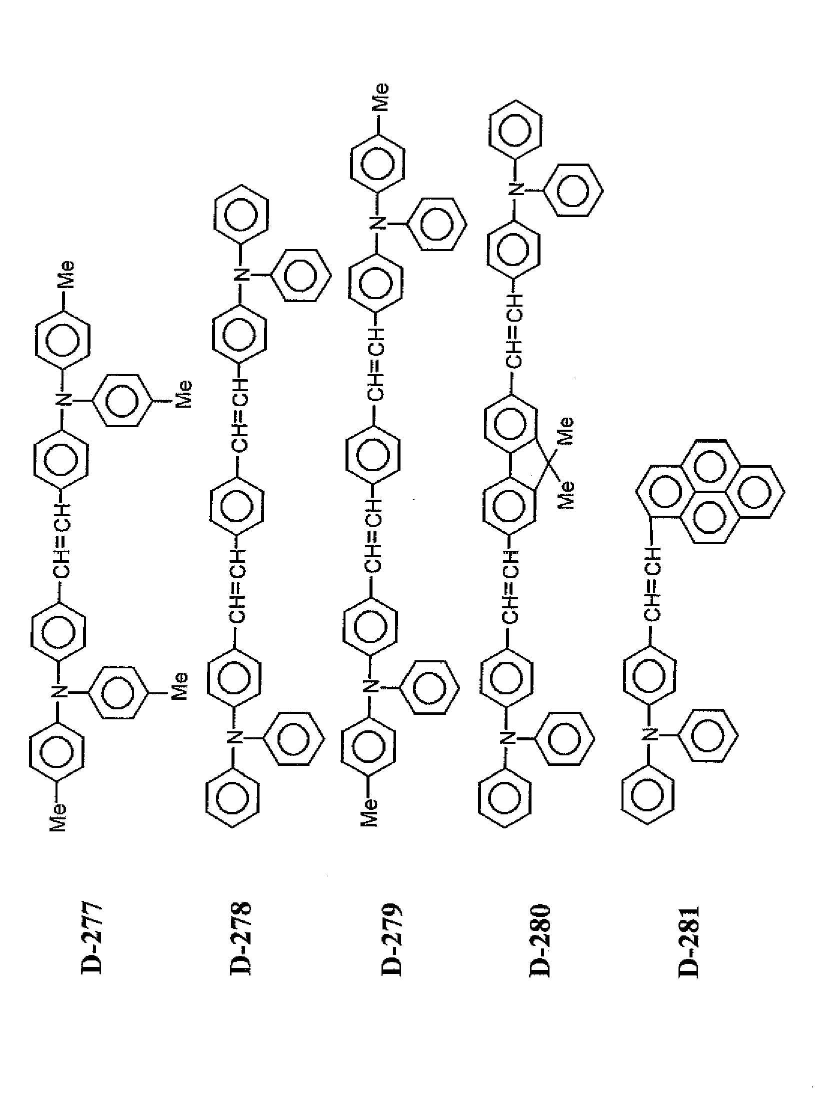

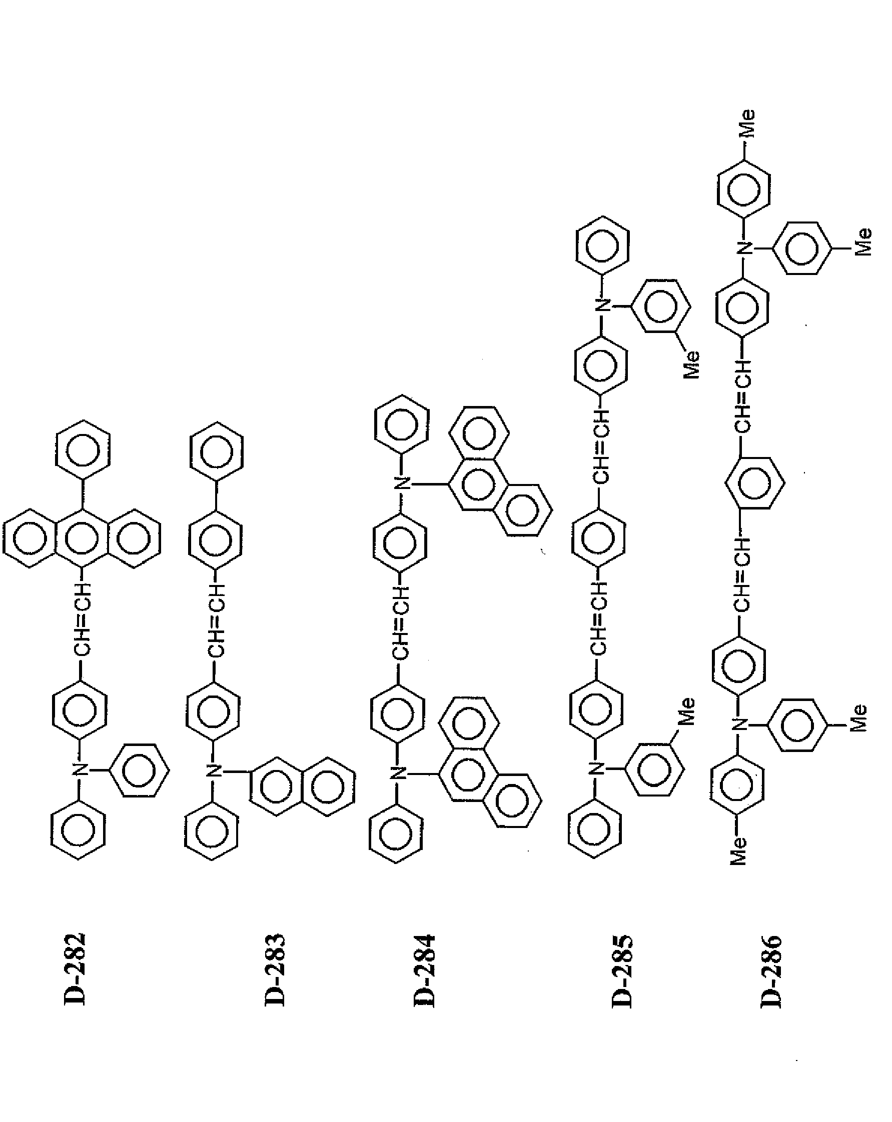

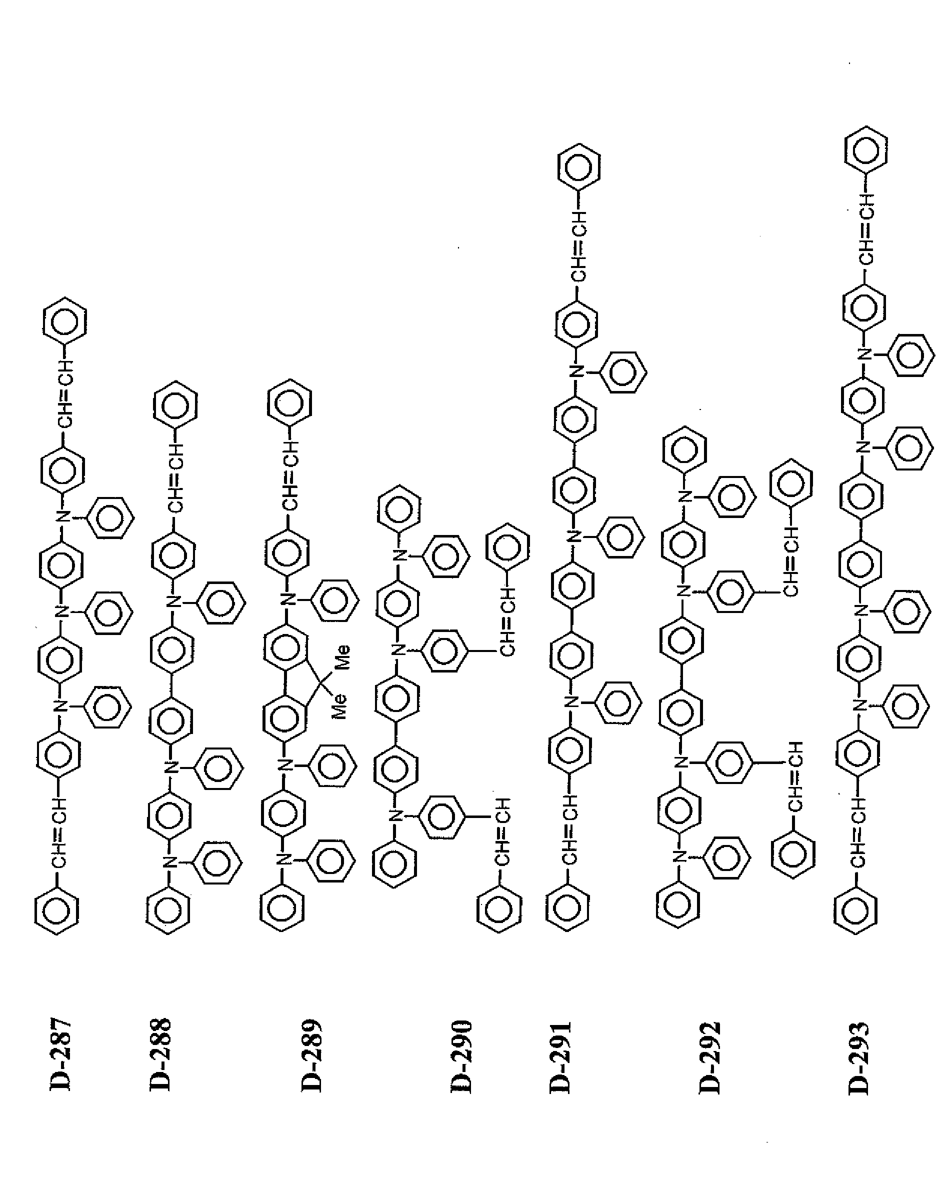

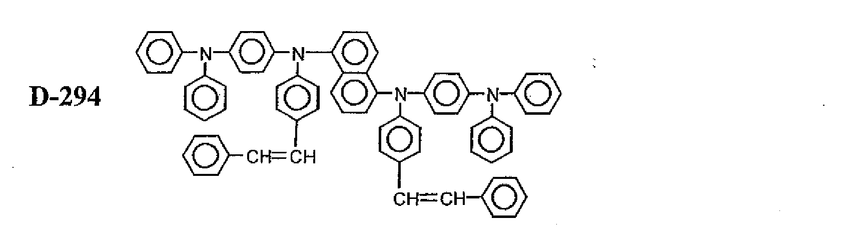

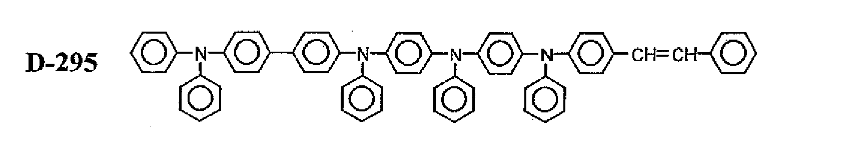

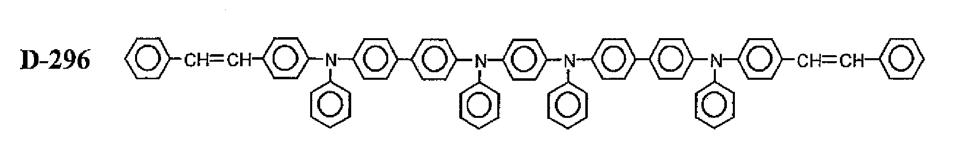

The present invention provides an organic electroluminescence device in which a chalcogenide layer, a halogenated metal layer, or a metal oxide layer is placed on at least one surface of a pair of electrodes. The light emitting layer of the organic electroluminescence device of the present invention contains the pyrene derivative and the amine compound. The light emitting layer contains the pyrene derivative and the amine compound at a ratio of 99.99 : 0.01 to 80.00 : 20.00 wt%. In the organic electroluminescence device of the present invention, the light emitting layer contains a metal complex compound.

Now, the structure of the organic EL device of the present invention will be described.
Typical examples of the structure of the organic EL device of the present invention include the following:
(1) an anode/light emitting layer/cathode;
(2) an anode/hole injecting layer/light emitting layer/cathode;
(3) an anode/light emitting layer/electron injecting layer/cathode;
(4) an anode/hole injecting layer/light emitting layer/electron injecting layer/cathode;
(5) an anode/organic semiconductor layer/light emitting layer/cathode;
(6) an anode/organic semiconductor layer/electron barrier layer/light emitting layer/cathode;
(7) an anode/organic semiconductor layer/light emitting layer/adhesion improving layer/cathode;
(8) an anode/hole injecting layer/hole transporting layer/light emitting layer/electron injecting layer/cathode;
(9) an anode/insulating layer/light emitting layer/insulating layer/cathode;
(10) an anode/inorganic semiconductor layer/insulating layer/light emitting layer/insulating layer/cathode;
(11) an anode/organic semiconductor layer/insulating layer/light emitting layer/insulating layer/cathode;
(12) an anode/insulating layer/hole injecting layer/hole transporting layer/light emitting layer/ insulating layer/cathode; and
(13) an anode/insulating layer/hole injecting layer/hole transporting layer/light emitting layer/electron injecting layer/cathode.
Of those, the structure (8) is preferably used in ordinary cases. However, the structure is not limited to the foregoing.
Further, in the organic EL device of the present invention, the biphenyl compound of the present invention is used in any one of the above organic layers. The biphenyl compound is preferably incorporated into a light emitting band or hole transporting band in those components, or is particularly preferably incorporated into a light emitting layer. The amount of the biphenyl compound to be contained is selected from 30 to 100 mol%.

The organic EL device of the present invention is generally prepared on a translucent substrate. Here, the translucent substrate is the substrate which supports the organic EL device. It is desirable that the translucent substrate have a transmittance of light of 50% or more in the visible region of the wavelength having 400 to 700 nm, and further, it is preferable to use the substrate which is flat and smooth.
Examples of the translucent substrate include preferably glass plates and synthetic resin plates. Specific examples of the glass plate include plates made of soda-lime glass, plates containing barium and strontium, lead glass, aluminosilicate glass, borosilicate glass, barium borosilicate glass, and quartz. Specific examples of the synthetic resin plate include plates formed of a polycarbonate resin, an acrylic resin, a polyethylene terephthalate resin, a polyether sulfide resin, and a polysulfone resin.

Next, the anode serves to inject a hole into the hole transporting layer or the light emitting layer, and an anode having a work function of 4.5 eV or more is effective. Specific examples of an anode material applicable to the present invention include an indium tin oxide (ITO), a mixture of indium oxide and zinc oxide (IZO), a mixture of ITO and cerium oxide (ITCO), a mixture of IZO and cerium oxide (IZCO), a mixture of indium oxide and cerium oxide (ICO), a mixture of zinc oxide and aluminum oxide (AZO), tin oxide (NESA), gold, silver, platinum, and copper.
The anode can be prepared by forming a thin film of the electrode material described above in accordance with a process such as the vapor deposition process and the sputtering process.
When the light emitted from the light emitting layer is obtained through the anode, it is preferable that the anode have a transmittance of the emitted light greater than 10%. It is also preferable that the sheet resistance of the anode be several hundred Ω/square or smaller. The thickness of the anode is, in general, selected in the range of 10 nm to 1 µm and preferably in the range of 10 to 200 nm although the preferable range may be different depending on the used material.

The light emitting layer in the organic EL device of the present invention has:
(i) the injecting function: the function of injecting holes from the anode or the hole injecting layer and injecting electrons from the cathode or the electron injecting layer when an electric field is applied;
(ii) the transporting function: the function of transporting injected charges (i.e., electrons and holes) by the force of the electric field; and
(iii) the light emitting function: the function of providing the place for recombination of electrons and holes and leading to the emission of light.
For the process for forming the light emitting layer, a known process such as the vapor deposition process, the spin coatingprocess, and the LB process can be used. It is particularly preferable that the light emitting layer be a molecular deposit film. The molecular deposit film is a thin film formed by deposition of a material compound in the gas phase or a film formed by solidification of a material compound in a solution or in the liquid phase. In general, the molecular deposit film can be distinguished from the thin film formed in accordance with the LB process (i.e., molecular accumulation film) based on the differences in aggregation structure and higher order structure and functional differences caused by those structural differences.
Further, as disclosed in JP-A-57-51781, the light emitting layer can also be formed by dissolving a binder such as a resin and the material compounds into a solvent to prepare a solution, followed by forming a thin film from the prepared solution by the spin coating process or the like.
In the present invention, where desired, the light emitting layer may include other known metal complex compounds other than the light emitting material composed of a pyrene derivative and an amine compound, or a light emitting layer including other known metal complex compounds may be laminated to the light emitting layer including the compound according to the present invention as long as the object of the present invention is not adversely affected.
The metal complex compound is preferably a metal complex compound containing at least one metal selected from the group consisting of Ir, Ru, Pd, Pt, Os, and Re. The ligand of the metal complex compound preferably include at least one skeleton selected from phenylpyridine skeleton, bipyridyl skeleton, and phenanthroline skeleton. Specific examples of the metal complex include tris(2-phenylpyridine) iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethyl platinum porphyrin, octaphenyl platinum porphyrin, octaethyl palladium porphyrin, and octaphenyl palladium porphyrin. However, the metal complex is not limited thereto, and the appropriate complex is selected in terms of a desired luminescent color, a device performance, and a relationship with a host compound.

Next, the hole injecting and transporting layer is a layer which helps injection of holes into the light emitting layer and transports the holes to the light emitting region. The layer exhibits a great mobility of holes and, in general, has an ionization energy as small as 5.5 eV or smaller. For such a hole injecting and transporting layer, a material which transports holes to the light emitting layer under an electric field of a smaller strength is preferable. A material which exhibits, for example, a mobility of holes of at least 10⁻⁴ m²/V·see or more under application of an electric field of 10⁴ to 10⁶ V/cm is preferable.
The material which can be used for forming the hole injecting and transporting layer is not particularly limited as long as the material has a preferable property described above. The material can be arbitrarily selected from materials which are conventionally used as the charge transporting material of holes in photoconductive materials and known materials which are used for the hole injecting layer in organic EL devices. The compounds shown in the following general formula are examples of aromatic amine derivatives. 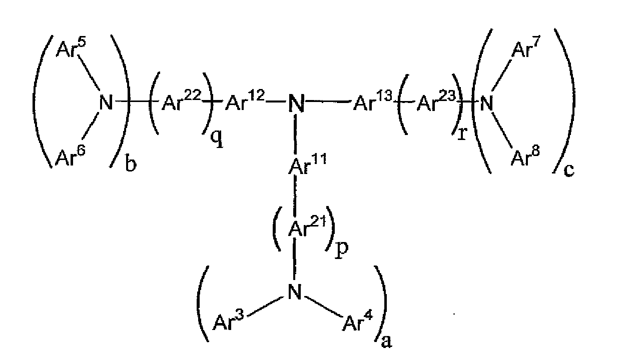 Ar¹¹ to Ar¹³, Ar²¹ to Ar²³, and Ar³ to Ar⁸ each represent a substituted or unsubstituted aromatic hydrocarbon group having 6 to 50 ring carbon atoms, or a substituted or unsubstituted aromatic heterocyclic group having 5 to 50 ring atoms, a to c and p to r each represent an integer of 0 to 3, and Ar³ and Ar⁴, Ar⁵ and Ar⁶, or Ar⁷ and Ar⁸ may be coupled with each other to form a saturated or unsaturated ring. As specific examples of the substituted or unsubstituted aromatic hydrocarbon group having 6 to 50 ring carbon atoms and the substituted or unsubstituted aromatic heterocyclic group having 5 to 50 ring atoms, there are exemplified similar ones as in the general formulae (1) and (3). 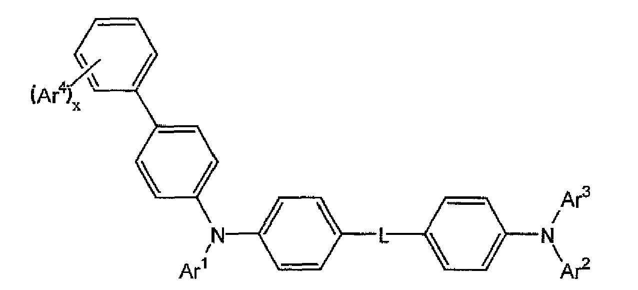 Ar¹ to Ar⁴ each represent a substituted or unsubstituted aromatic hydrocarbon group having 6 to 50 ring carbon atoms, or a substituted or unsubstituted aromatic heterocyclic group having 5 to 50 ring atoms, L represents a linking group, that is, a single bond, a substituted or unsubstituted aromatic hydrocarbon group having 6 to 50 ring carbon atoms, or a substituted or unsubstituted aromatic heterocyclic group having 5 to 50 ring atoms, x represents an integer of 0 to 5, and Ar² and Ar³ may be coupled with each other to form a saturated or unsaturated ring. As specific examples of the aromatic hydrocarbon group having 6 to 50 ring carbon atoms and the aromatic heterocyclic group having 5 to 50 ring atoms, there are exemplified similar ones as in the general formulae (1) and (3).

Specific examples include: a triazole derivative (see, for example, US 3,112,197); an oxadiazole derivative (see, for example, US 3, 189, 447) ; an imidazole derivative (see, for example, JP-B-37-16096); a polyarylalkane derivative (see, for example, US 3,615,402, US 3,820,989, US 3, 542, 544, JP-B-45-555, JP-B-51-10983, JP-A-51-93224, JP-A-55-17105, JP-A-56-4148, JP-A-55-108667, JP-A-55-156953, and JP-A-56-36656); a pyrazoline derivative and a pyrazolone derivative (see, for example, US 3, 180, 729, US 4,278, 746, JP-A-55-88064, JP-A-55-88065, JP-A-49-105537, JP-A-55-51086, JP-A-56-80051, JP-A-56-88141, JP-A-57-45545, JP-A-54-112637, and JP-A-55-74546); a phenylenediamine derivative (see, for example, US 3,615,404, JP-B-51-10105, JP-B-46-3712, JP-B-47-25336, JP-A-54-53435, JP-A-54-110536, and JP-A-54-119925); an arylamine derivative (see, for example, US 3,567,450, US 3,180,703, US 3,240,597, US 3,658,520, US 4, 232, 103, US 4,175,961, US 4,012,376, JP-B-49-35702, JP-B-39-27577, JP-A-55-144250, JP-A-56-119132, JP-A-56-22437, and DE 1,110,518); an amino-substituted chalcone derivative (see, for example, US 3, 526, 501) ; an oxazole derivative (those disclosed in US 3,257,203); a styrylanthracene derivative (see, for example, JP-A-56-45234) ; a fluorenone derivative (see, for example, JP-A-54-110837); a hydrazone derivative (see, for example, US3,717,462, JP-A-54-59143, JP-A-55-52063, JP-A-55-52064, JP-A-55-46760, JP-A-55-85495, JP-A-57-11350, JP-A-57-148749, and JP-A-2-311591); a stilbene derivative (see, for example, JP-A-61-210363, JP-A-61-228451, JP-A-61-14642, JP-A-61-72255, JP-A-62-47646, JP-A-62-36674, JP-A-62-10652, JP-A-62-30255, JP-A-60-93445, JP-A-60-94462, JP-A-60-174749, and JP-A-60-175052); a silazane derivative (US 4,950,950); a polysilane-based (JP-A-2-204996); an aniline-based copolymer (JP-A-2-282263); and a conductive high molecular weight oligomer (particularly a thiophene oligomer) disclosed in JP-A-1-211399.
In addition to the above-mentioned materials which can be used as the material for the hole injecting layer, a porphyrin compound (those disclosed in, for example, JP-A-63-2956965); an aromatic tertiary amine compound and a styrylamine compound (see, for example, US 4,127,412, JP-A-53-27033, JP-A-54-58445, JP-A-54-149634, JP-A-54-64299, JP-A-55-79450, JP-A-55-144250, JP-A-56-119132, JP-A-61-295558, JP-A-61-98353, and JP-A-63-295695) are preferable, and aromatic tertiary amine compounds are particularly preferable.
Further, there are also mentioned compounds having two fused aromatic rings in the molecule, such as 4,4'-bis(N-(1-naphthyl)-N-phenylamino)-biphenyl (hereinafter referred to as NPD) as disclosed in US 5,061,569, and a compound in which three triphenylamine units are bonded together in a star-burst shape, such as 4,4',4"-tris(N-(3-methylphenyl)-N-phenylamino)-triphenylamine (hereinafter referred to as MTDATA) as disclosed in JP-A-4-308688.

In addition to the foregoing, a nitrogen-containing compound represented by the following general formula disclosed in JP-B-3571977 can also be used: 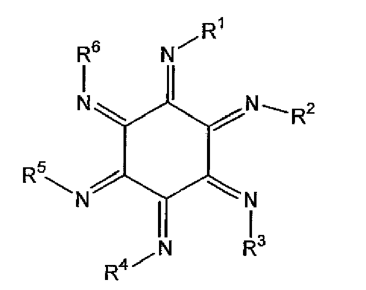 where R¹, R², R³, R⁴, R⁵, and R⁶ each represent a substituted or unsubstituted alkyl group, a substituted or unsubstituted aryl group, a substituted or unsubstituted aralkyl group, or a substituted or unsubstituted heterocyclic group, provided that R¹, R², R³, R⁴, R⁵, and R⁶ may be identical to or different from one another, and R¹ and R² R³ and R⁴, R⁵ and R⁶, R¹ and R⁶, R² and R³, or R⁴ and R⁵ may form a fused ring.
Further, a compound represented by the following general formula described in US 2004-0113547 can also be used: 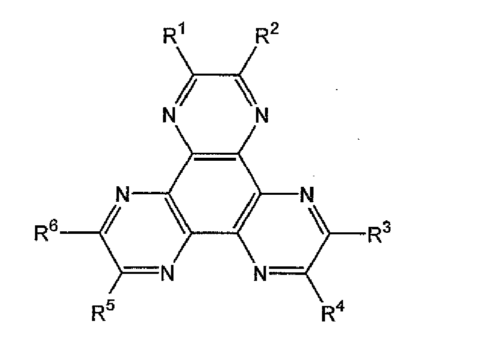 where R¹ to R⁶ each represent a substituent, or preferably an electron-withdrawing group such as a cyano group, a nitro group, a sulfonyl group, a carbonyl group, a trifluoromethyl group, or a halogen.
Further, inorganic compounds such as Si of the p-type and SiC of the p-type can also be used as the material for the hole injecting layer.
The hole injecting and transporting layer can be formed by forming a thin layer from the above-mentioned compounds in accordance with a known process such as the vacuum vapor deposition process, the spin coating process, the casting process, and the LB process. The thickness of the hole injecting and transporting layer is not particularly limited. In general, the thickness is 5 nm to 5 µm. The hole injecting and transporting layer may be formed of a single layer containing one or more materials described above or may be a laminate formed of hole injecting and transporting layers containing compounds different from the compounds of the hole injecting and transporting layer described above as long as the compound of the present invention is incorporated in the hole transporting zone.
Further, an organic semiconductor layer is a layer for helping the injection of holes or electrons into the light emitting layer and a layer having a conductivity of 10⁻¹⁰ S/cm or more is preferable. As the material for the organic semiconductor layer, oligomers containing thiophene, and conductive oligomers such as oligomers containing arylamine and conductive dendrimers such as dendrimers containing arylamine which are disclosed in JP-A-08-193191, can be used.

Next, the electron injecting and transporting layer is a layer which helps injection of electrons into the Light emitting layer, transports the holes to the light emitting region, and exhibits a great mobility of electrons. The adhesion improving layer is an electron injecting layer including a material exhibiting particularly improved adhesion with the cathode.
In addition, it is known that, in an organic EL device, emitted light is reflected by an electrode (cathode in this case), so emitted light directly extracted from an anode and emitted light extracted via the reflection by the electrode interfere with each other. The thickness of an electron transporting layer is appropriately selected from the range of several nanometers to several micrometers in order that the interference effect may be effectively utilized. When the thickness is particularly large, an electron mobility is preferably at least 10⁻⁵ m²/Vs or more upon application of an electric field of 10⁴ to 10⁶ V/cm in order to avoid an increase in voltage.
A metal complex of 8-hydroxyquinoline or of a derivative of 8-hydroxyquinoline, or an oxadiazole derivative is suitable as a material to be used in an electron injecting layer. Specific examples of the metal complex of 8-hydroxyquinoline or of a derivative of 8-hydroxyquinoline that can be used as an electron injecting material include metal chelate oxynoid compounds each containing a chelate of oxine (generally 8-quinolinol or 8-hydroxyquinoline) such as tris(8-quinolinolato)aluminum.

On the other hand, examples of the oxadiazole derivative include electron transfer compounds represented by the following general formulae: 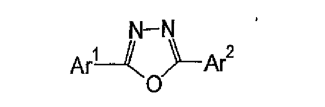 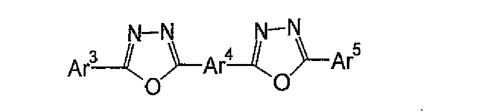 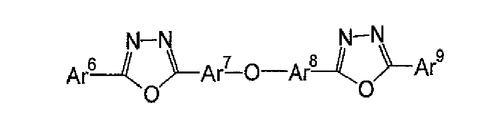 where: Ar¹, Ar², Ar³, Ar⁵, Ar⁶ and Ar⁹ each represent a substituted or unsubstituted aryl group and may be identical to or different from one another; and Ar⁴, Ar⁷ and Ar⁸ each represent a substituted or unsubstituted arylene group and may be identical to or different from one another.
Examples of the aryl group include a phenyl group, a biphenyl group, an anthranyl group, a perylenyl group, and a pyrenyl group. Examples of the arylene group include a phenylene group, a naphthylene group, a biphenylene group, an anthranylene group, a perylenylene group, and a pyrenylene group. Examples of the substituent include alkyl groups each having 1 to 10 carbon atoms, alkoxyl groups each having 1 to 10 carbon atoms, and a cyano group. As the electron transfer compound, compounds which can form thin films are preferable.

Examples of the electron transfer compounds described above include the following. 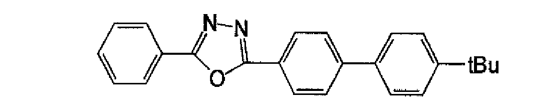 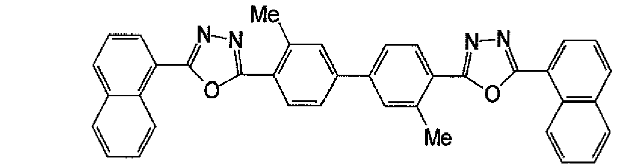 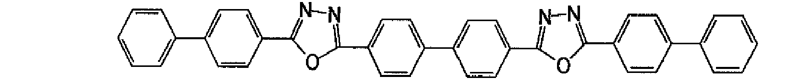 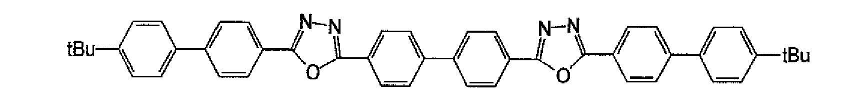 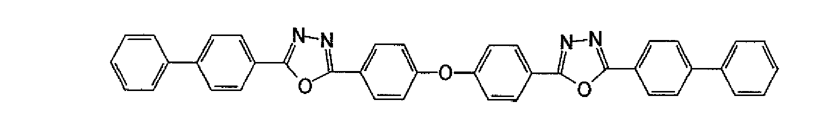 Further, materials represented by the following general formulae (E) to (J) can be used in an electron injecting layer and an electron transporting layer.

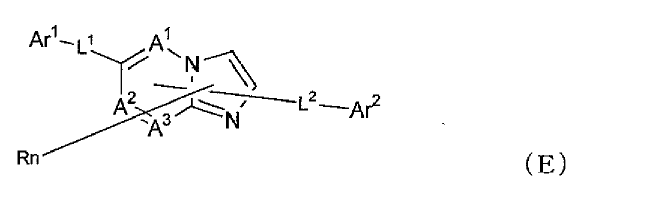

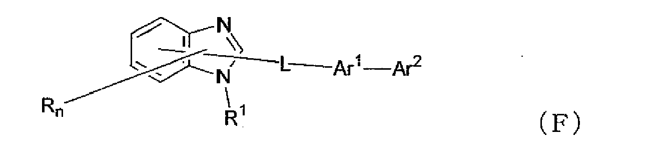

A nitrogen-containing heterocyclic derivative represented by the general formulae (E) and (F), where: A¹ to A³ each independently represent a nitrogen atom or a carbon atom;
Ar¹ represents a substituted or unsubstituted aryl group having 6 to 60 ring carbon atoms, or a substituted or unsubstituted heteroaryl group having 3 to 60 ring carbon atoms, Ar² represents a hydrogen atom, a substituted or unsubstituted aryl group having 6 to 60 ring carbon atoms, a substituted or unsubstituted heteroaryl group having 3 to 60 ring carbon atoms, a substituted or unsubstituted alkyl group having 1 to 20 carbon atoms, or a substituted or unsubstituted alkoxy group having 1 to 20 carbon atoms, or a divalent group of any one of those, provided that one of Ar¹ and Ar² represents a substituted or unsubstituted fused ring group having 10 to 60 ring carbon atoms, a substituted or unsubstituted monohetero fused ring group having 3 to 60 ring carbon atoms, or a divalent group thereof;
L¹, L², and L each independently represent a single bond, a substituted or unsubstituted arylene group having 6 to 60 ring carbon atoms, a substituted or unsubstituted heteroarylene group having 3 to 60 ring carbon atoms, or a substituted or unsubstituted fluorenylene group;
R represents a hydrogen atom, a substituted or unsubstituted aryl group having 6 to 60 ring carbon atoms, a substituted or unsubstituted heteroaryl group having 3 to 60 ring carbon atoms, a substituted or unsubstituted alkyl group having 1 to 20 carbon atoms, or a substituted or unsubstituted alkoxy group having 1 to 20 carbon atoms, n represents an integer of 0 to 5, and, when n represents 2 or more, multiple R's may be identical to or different from one another, and multiple R groups adj acent to each other may be bonded to each other to form a carbocyclic aliphatic ring or a carbocyclic aromatic ring; and
R¹ represents a hydrogen atom, a substituted or unsubstituted aryl group having 6 to 60 ring carbon atoms, a substituted or unsubstituted heteroaryl group having 3 to 60 ring carbon atoms, a substituted or unsubstituted alkyl group having 1 to 20 carbon atoms, a substituted or unsubstituted alkoxy group having 1 to 20 ring carbon atoms, or -L-Ar¹-Ar².

HAr-L-Ar¹-Ar² (G)

A nitrogen-containing heterocyclic derivative represented by the formula (G), where: HAr represents a nitrogen-containing heterocyclic ring having 3 to 40 carbon atoms and may have a substituent; L represents a single bond, an arylene group having 6 to 60 carbon atoms and may have a substituent, a heteroarylene group having 3 to 60 carbon atoms and may have a substituent, or a fluorenylene group which may have a substituent; Ar¹ represents a divalent aromatic hydrocarbon group which has 6 to 60 carbon atoms and may have a substituent; and Ar² represents an aryl group having 6 to 60 carbon atoms and may have a substituent or a heteroaryl group having 3 to 60 carbon atoms and may have a substituent.

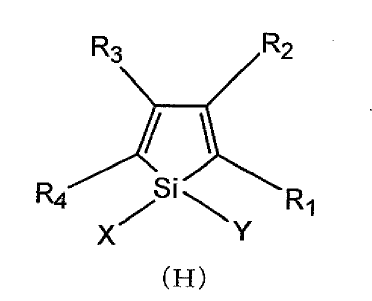

A silacyclopentadiene derivative represented by the general formula (H), where: X and Y each independently represent a saturated or unsaturated hydrocarbon group having 1 to 6 carbon atoms, an alkoxy group, an alkenyloxy group, an alkynyloxy group, a hydroxy group, a substituted or unsubstituted aryl group, or a substituted or unsubstituted heterocycle, or X and Y are bonded to each other to form a structure as a saturated or unsaturated ring; and R₁ to R₄ each independently represent hydrogen, a halogen atom, a substituted or unsubstituted alkyl group having 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group, or a cyano group, or, when two or more of R₁ to R₄ are adjacent to each other, they form a structure in which a substituted or unsubstituted ring is condensed.

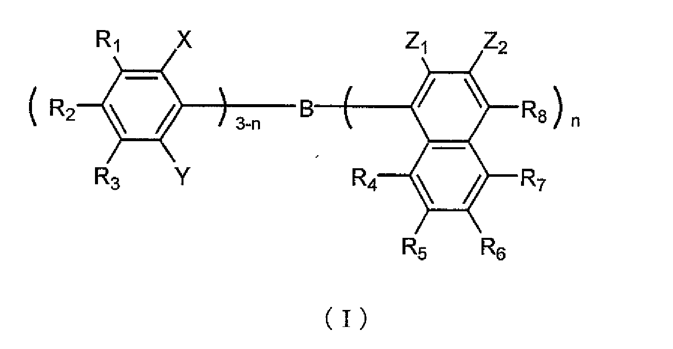

A borane derivative represented by the formula (I), where: R₁ to R₈ and Z₂ each independently represent a hydrogen atom, a saturated or unsaturated hydrocarbon group, an aromatic hydrocarbon group, a heterocyclic group, a substituted amino group, a substituted boryl group, an alkoxy group, or an aryloxy group; X, Y, and Z₁ each independently represent a saturated or unsaturated hydrocarbon group, an aromatic hydrocarbon group, a heterocyclic group, a substituted amino group, an alkoxy group, or an aryloxy group; substituents of Z₁ and Z₂ may be bonded to each other to form a fused ring; and n represents an integer of 1 to 3, and, when n represents 2 or more, Z₁'s may be different from each other, provided that the case where n represents 1, X, Y, and R₂ each represent a methyl group, R₈ represents a hydrogen atom or a substituted boryl group and the case where n represents 3 and Z₁'s each represent a methyl group are excluded.

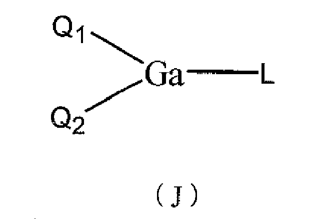

where: Q¹ and Q² each independently represent a ligand represented by the following general formula (K); and L represents a halogen atom, a substituted or unsubstituted alkyl group, a substituted or unsubstituted cycloalkyl group, a substituted or unsubstituted aryl group, a substituted or unsubstituted heterocyclic group, -OR¹ (where R¹ represents a hydrogen atom, a substituted or unsubstituted alkyl group, a substituted or unsubstituted cycloalkyl group, a substituted or unsubstituted aryl group, or a substituted or unsubstituted heterocyclic group), or a ligand represented by -O-Ga-Q³(Q⁴) (where Q³ and Q⁴ are identical to Q¹ and Q², respectively).

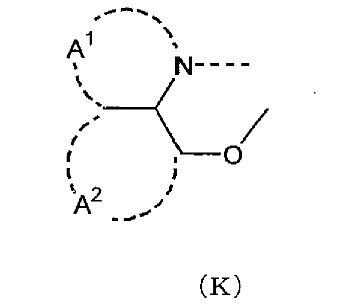

where rings A¹ and A² are six-membered aryl ring structures which are condensed with each other and each of which may have a substituent.

The metal complex behaves strongly as an n-type semiconductor, and has a large electron injecting ability. Further, generation energy upon formation of the complex is low. As a result, the metal and the ligand of the formed metal complex are bonded to each other so strongly that the fluorescent quantum efficiency of the complex as a light emitting material improves.
Specific examples of a substituent in the rings A¹ and A² which each form a ligand in the general formula (K) include: a halogen atom such as chlorine, bromine, iodine, or fluorine; a substituted or unsubstituted alkyl group such as a methyl group, an ethyl group, a propyl group, a butyl group, an s-butyl group, a t-butyl group, a pentyl group, a hexyl group, a heptyl group, an octyl group, a stearyl group, or trichloromethyl group; a substituted or unsubstituted aryl group such as a phenyl group, a naphthyl group, a 3-methylphenyl group, a 3-methoxyphenyl group, a 3-fluorophenyl group, a 3-trichloromethylphenyl group, a 3-trifluoromethylphenyl group, or a 3-nitrophenyl group; a substituted or unsubstituted alkoxy group such as a methoxy group, an n-butoxy group, a t-butoxy group, a trichloromethoxy group, a trifluoroethoxy group, a pentafluoropropoxy group, a 2,2,3,3-tetrafluoropropoxy group, a 1,1,1,3,3,3-hexafluoro-2-propoxy group, or a 6-(perfluoroethyl)hexyloxy group; a substituted or unsubstituted aryloxy group such as a phenoxy group, a p-nitrophenoxy group, p-t-butylphenoxy group, a 3-fluorophenoxy group, a pentafluorophenyl group, or a 3-trifluoromethylphenoxy group; a substituted or unsubstituted alkylthio group such as a methylthio group, an ethylthio group, a t-butylthio group, a hexylthio group, an octylthio group, or a trifluoromethylthio group; a substituted or unsubstituted arylthio group such as a phenylthio group, a p-nitrophenylthio group, a p-t-butylphenylthio group, a 3-fluorophenylthio group, a pentafluorophenylthio group, or a 3-trifluoromethylphenylthio group; a mono-substituted or di-substituted amino group such as a cyano group, a nitro group, an amino group, a methylamino group, a diethylamino group, an ethylamino group, a diethylamino group, a dipropylamino group, a dibutylamino group, or a diphenylamino group; an acylamino group such as a bis(acetoxymethyl)amino group, a bis(acetoxyethyl)amino group, a bis (acetoxypropyl) amino group, or a bis (acetoxybutyl) amino group; a hydroxyl group, a siloxy group, an acyl group, a carbamoyl group such as a methylcarbamoyl group, a dimethylcarbamoyl group, anethylcarbamoyl group, adiethylcarbamoyl group, a propylcarbamoyl group, a butylcarbamoyl group, or a phenylcarbamoyl group; a carboxylic acid group, a sulfonic acid group, an imide group, a cycloalkyl group such as a cyclopentane group, or a cyclohexyl group; an aryl group such as a phenyl group, a naphthyl group, a biphenyl group, an anthranyl group, a phenanthryl group, a fluorenyl group, or a pyrenyl group; and a heterocyclic group such as a pyridinyl group, a pyrazinyl group, a pyrimidinyl group, a pyridazinyl group, a triazinyl group, an indolinyl group, a quinolinyl group, an acridinyl group, a pyrrolidinyl group, a dioxanyl group, a piperidinyl group, a morpholidinyl group, a piperazinyl group, a triathinyl group, a carbazolyl group, a furanyl group, a thiophenyl group, an oxazolyl group, an oxadiazolyl group, a benzoxazolyl group, a thiazolyl group, a thiadiazolyl group, a benzothiazolyl group, a triazolyl group, an imidazolyl group, a benzoimidazolyl group, or a puranyl group. In addition, the above-mentioned substituents may be bound to each other to further form a six-membered aryl ring or a heterocyclic ring.

A preferable embodiment of the organic EL device of the present invention includes a device including a reducing dopant in the region of electron transport or in the interfacial region of the cathode and the organic layer. The reducing dopant is defined as a substance which can reduce a compound having the electron transporting property. Various compounds can be used as the reducing dopant as long as the compounds have a uniform reductive property. For example, at least one substance selected from the group consisting of alkali metals, alkaline earth metals, rare earth metals, alkali metal oxides, alkali metal halides, alkaline earth metal oxides, alkaline earth metal halides, rare earth metal oxides, or rare earth metal halides, alkali metal carbonates, alkaline earth metal carbonates, organic complexes of alkali metals, organic complexes of alkaline earth metals, and organic complexes of rare earth metals can be preferably used.
More specifically, examples of the reducing dopant include substances having a work function of 2.9 eV or smaller, specific examples of which include at least one alkali metal selected from the group consisting of Na (the work function: 2.36 eV), K (the work function: 2.28 eV), Rb (the work function: 2.16 eV), and Cs (the work function: 1.95 eV) and at least one alkaline earth metal selected from the group consisting of Ca (the work function: 2.9 eV), Sr (the work function: 2.0 to 2.5 eV), and Ba (the work function: 2.52 eV). Of those, at least one alkali metal selected from the group consisting of K, Rb, and Cs is more preferable, Rb and Cs are still more preferable, and Cs is most preferable as the reducing dopant. Those alkali metals have great reducing ability, and the luminance of the emitted light and the lifetime of the organic EL device can be increased by addition of a relatively small amount of the alkali metal into the electron injecting zone. As the reducing dopant having a work function of 2.9 eV or smaller, combinations of two or more alkali metals thereof are also preferable. Combinations having Cs such as the combinations of Cs and Na, Cs and K, Cs and Rb, or Cs, Na, and K are more preferable. The reducing ability can be efficiently exhibited by the combination having Cs. The luminance of emitted light and the lifetime of the organic EL device can be inproved by adding the combination having Cs into the electron injecting zone.

The present invention may further include an electron injecting layer which is composed of an insulating material or a semiconductor and disposed between the cathode and the organic layer.
At this time, leak of electric current can be effectively prevented by the electron injecting layer and the electron injecting property can be improved. As the insulating material, at least one metal compound selected from the group consisting of alkali metal chalcogenides, alkaline earth metal chalcogenides, alkali metal halides, and alkaline earth metal halides is preferable. It is preferable that the electron injecting layer be composed of the above-mentioned substance such as the alkali metal chalcogenide since the electron injecting property can be further improved. Specifically, preferable examples of the alkali metal chalcogenide include Li₂O, K₂O, Na₂S, Na₂Se, and Na₂O. Preferable examples of the alkaline earth metal chalcogenide include CaO, BaO, SrO, BeO, BaS, and CaSe. Further, preferable examples of the alkali metal halide include LiF, NaF, KF, CsF, LiCl, KCl, and NaCl. Preferable examples of the alkaline earth metal halide include fluorides such as CaF₂, BaF₂, SrF₂, MgF₂, and BeF₂ and halides other than the fluorides.
Examples of the semiconductor composing the electron transporting layer include oxides, nitrides, and oxide nitrides of at least one element selected from Ba, Ca, Sr, Yb, Al, Ga, In, Li, Na, Cd, Mg, Si, Ta, Sb, and Zn used alone or in combination of two or more. It is preferable that the inorganic compound composing the electron transporting layer form a crystallite or amorphous insulating thin film. When the electron injecting layer is composed of the insulating thin film described above, a more uniform thin film can be formed, and defects of pixels such as dark spots can be decreased. Examples of the inorganic compound include alkali metal chalcogenides, alkaline earth metal chalcogenides, alkali metal halides, and alkaline earth metal halides which are described above.

Next, as the cathode, a material such as a metal, an alloy, a conductive compound, or a mixture of those materials which has a small work function (4 eV or smaller) is used. Specific examples of the electrode material include sodium, sodium-potassium alloys, magnesium, lithium, cesium, magnesium-silver alloys, aluminum/aluminum oxide, Al/Li₂O, Al/LiO, Al/LiF, aluminum-lithium alloys, indium, and rare earth metals.
The cathode can be prepared by forming a thin film of the electrode material described above in accordance with a process such as the vapor deposition process and the sputtering process.
When the light emitted from the light emitting layer is obtained through the cathode, it is preferable that the cathode have a transmittance of the emitted light greater than 10%. It is also preferable that the sheet resistance of the cathode be several hundred Ω/square or smaller. The thickness of the cathode is, in general, selected in the range of 10 nm to 1 µm and preferably in the range of 50 to 200 nm.

Further, in general, defects in pixels tend to be formed in organic EL device due to leak and short circuit since an electric field is applied to ultra-thin films. To prevent the formation of the defects, a layer of a thin film having an insulating property may be inserted between the pair of electrodes.
Examples of the material used for the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. Mixtures and laminates of the above-mentioned compounds may also be used.

Next, to prepare the organic EL device of the present invention, the anode and the light emitting layer, and, where necessary, the hole injecting layer and the electron injecting layer are formed in accordance with the above process using the above materials, and the cathode can be formed in the last step. The organic EL device may also be prepared by forming the above-mentioned layers in the order reverse to that described above, i.e., the cathode being formed in the first step and the anode in the last step.
Hereinafter, an exampleproduction of the process for preparing an organic EL device having a construction in which an anode, a hole injecting layer, a light emitting layer, an electron injecting layer, and a cathode are disposed successively on a substrate transmitting light will be described.
On a suitable translucent substrate, a thin film made of a material for the anode is formed in accordance with the vapor deposition process or the sputtering process so that the thickness of the formed thin film is 1 µm or smaller and preferably in the range of 10 to 200 nm. The formed thin film is used as the anode. Then, a hole injecting layer is formed on the anode. The hole injecting layer can be formed in accordance with the vacuum vapor deposition process, the spin coating process, the casting process, or the LB process, as described above. The vacuum vapor deposition process is preferable since a uniform film can be easily obtained and the possibility of formation of pin holes is small. When the hole injecting layer is formed in accordance with the vacuum vapor deposition process, in general, it is preferable that the conditions be suitably selected in the following ranges: the temperature of the source of the deposition: 50 to 450°C; the vacuum: 10⁻⁷ to 10⁻³ Torr; the rate of deposition: 0.01 to 50 nm/second; the temperature of the substrate: -50 to 300°C; and the thickness of the film: 5 nm to 5 µm; although the conditions of the vacuum vapor deposition are different depending on the compound to be used (i.e., the material for the hole injecting layer) and the crystal structure and the recombination structure of the target hole injecting layer.

Then, the light emitting layer is formed on the hole injecting layer. The light emitting layer can be formed by using the light emitting material of the present invention in accordance with a process such as the vacuum vapor deposition process, the sputtering process, the spin coating process, or the casting process, and the formed thin film is used as the light emitting layer. The vacuum vapor deposition process is preferable since a uniform film can be easily obtained and the possibility of formation of pin holes is small. When the light emitting layer is formed in accordance with the vacuum vapor deposition process, in general, the conditions of the vacuum vapor deposition process can be selected in the same ranges as those described for the vacuum vapor deposition of the hole injecting layer, although the conditions are different depending on the used compound. The thickness of the layer is preferably 10 to 40 nm.

Next, an electron injecting layer is formed on the light emitting layer. In this case, similarly to the hole injecting layer and the light emitting layer, it is preferable that the electron injecting layer be formed in accordance with the vacuum vapor deposition process since a uniform film must be obtained. The conditions of the vacuum vapor deposition can be selected in the same ranges as those described for the vacuum vapor deposition of the hole injecting layer and the light emitting layer.
Then, finally, a cathode is laminated, whereby an organic EL device can be obtained. Since the cathode is constituted of a metal, a vapor deposition method or sputtering can be employed. However, a vacuum vapor deposition method is preferable in order that an organic substance layer as a ground may be protected from damage at the time of film formation.
The foregoing production process for the organic EL device commencing on the production of the anode and ending on the production of the cathode is preferably performed while the environment where the above layers are laminated is evacuated to a vacuum only once.

The method of forming the layers in the organic EL device of the present invention is not particularly limited. A conventionally known process such as the vacuum vapor deposition process or the spin coating process can be used. The organic thin film layer which is used in the organic EL device of the present invention and includes the compound represented by general formula (1) described above can be formed in accordance with a known process such as the vacuum vapor deposition process or the molecular beam epitaxy process (the MBE process) or, using a solution prepared by dissolving the compounds into a solvent, in accordance with a coating process such as the dipping process, the spin coating process, the casting process, the bar coating process, or the roll coating process.
The thickness of each layer in the organic thin film layer in the organic EL device of the present invention is not particularly limited. A thickness in the range of several nanometers to 1 µm is preferable for improving defects such as pin holes or efficiency.
The organic EL device emits light when a direct voltage of 5 to 40 V is applied in the condition that the polarity of the anode is positive and the polarity of the cathode is negative. When the polarity is reversed, no electric current is observed and no light is emitted at all. When an alternating voltage is applied to the organic EL device, the uniform light emission is observed only in the condition that the polarity of the anode is positive and the polarity of the cathode is negative. When an alternating voltage is applied to the organic EL device, any type of wave shape can be used.

### Examples

Hereinafter, examples of the present invention will be described. However, the present invention is not limited by these examples. It should be noted that an organic EL device obtained in each example was evaluated for the following items.
(1) Initial performance: A predetermined voltage was applied to the organic EL device, and a current value at the time of the application was measured. An emission luminance value and CIE1931 chromaticity coordinates were measured by luminance meter (Spectroradiometer CS-1000, manufactured by Konica Minolta Sensing, Inc.) and evaluated simultaneously with the measurement of the current value.
(2) Lifetime: The organic EL device was driven at a constant current and specific initial luminance. The device was evaluated for its lifetime on the basis of the half life of the luminance and a change in chromaticity.

### Example 1

A transparent electrode having a thickness of 130 nm and composed of an indium tin oxide was provided on a glass substrate of sizes measuring 25 mm wide by 75 mm long by 1.1 mm thick. The glass substrate was irradiated with ultraviolet light and ozone to be washed. After that, the substrate was placed in a vacuum vapor deposition apparatus.
First, an N,N'-bis(N,N'-diphenyl-4-aminophenyl)-N,N-diphenyl-4,4'-diamino-1,1'-biphenyl film (hereinafter abbreviated as "TPD232 film") was deposited from the vapor to serve as a hole injecting layer having a thickness of 60 nm. After that, an N,N,N',N'-tetra(4-biphenyl)-diaminobiphenylene layer (hereinafter, "TBDB layer") was deposited from the vapor onto the hole injecting layer to serve as a hole transporting layer having a thickness of 20 nm. Subsequently, Compounds (H-63) and (D-157) shown below were simultaneously deposited from the vapor at a weight ratio of 40 : 2, whereby a light emitting layer having a thickness of 40 nm was formed.
Next, tris (8-hydroxyquinolinato) aluminum was deposited from the vapor to serve as an electron injecting layer having a thickness of 20 nm. Next, lithium fluoride was deposited from the vapor to have a thickness of 0.3 nm, and then aluminum was deposited from the vapor to have a thickness of 150 nm. The aluminum/lithium fluoride layer functions as a cathode. Thus, an organic EL device was produced.
Next, the device was subjected to a current test. As a result, the device emitted blue light with a luminance of 650 cd/m² at a voltage of 6.2 V and a current density of 10 mA/cm².
In addition, the device was subjected to a DC continuous current test at an initial luminance of 1,000 cd/cm². As a result, the half lifetime was found to be 17, 800 hours. Table 1 summarizes the results of the evaluation of the device.

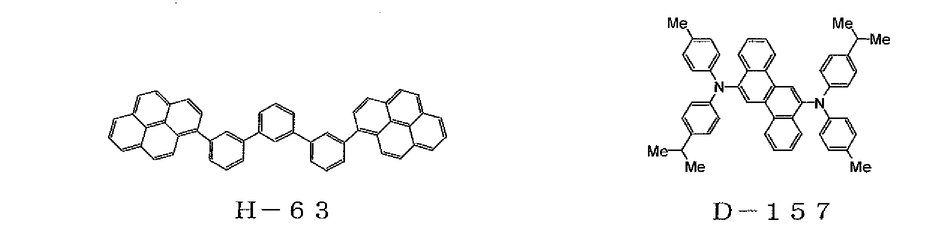

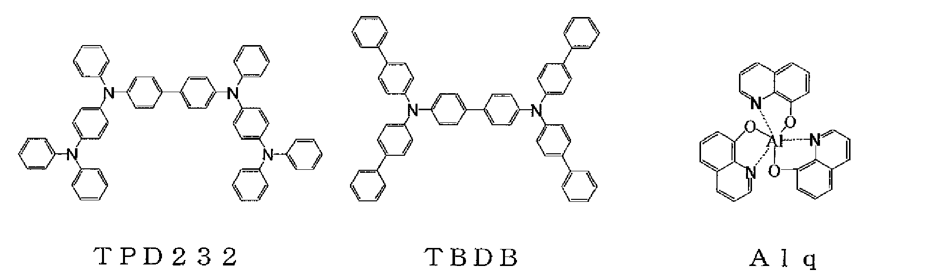

### Examples 2 to 9

Organic EL devices were each produced in the same manner as in Example 1 except that light emitting materials described in Table 1 were used instead of Compounds (H-63) and (D-157) in Example 1.
Table 1 summarizes the results of the evaluation of the devices.

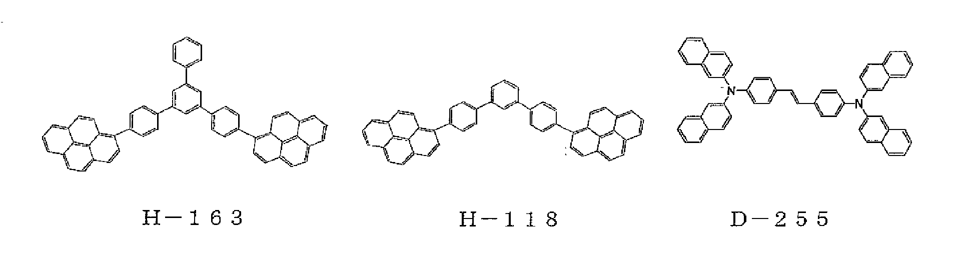

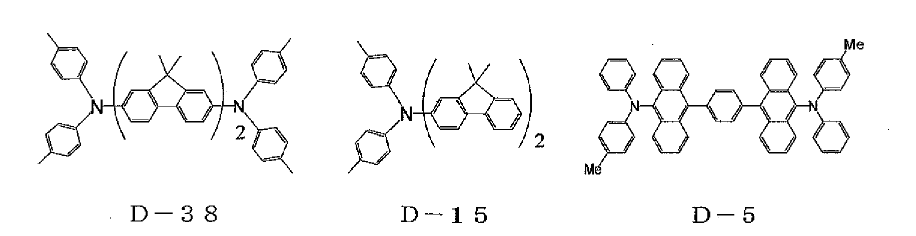

### Comparative Examples 1 and 2

Organic EL devices were each produced in the same manner as in Example 1 except that Comparative Compound-1 and Comparative Compound-2 shown belowwere used instead of Compound (H-63) in Example 1.
Table 1 summarizes the results of the evaluation of the devices .
Comparison between Example 1 and Comparative Example 1 showed the following: even when an unsubstituted dopant compound was used, a blue light emitting device having a long lifetime was obtained by using a pyrene derivative having a specific structure like the present invention.

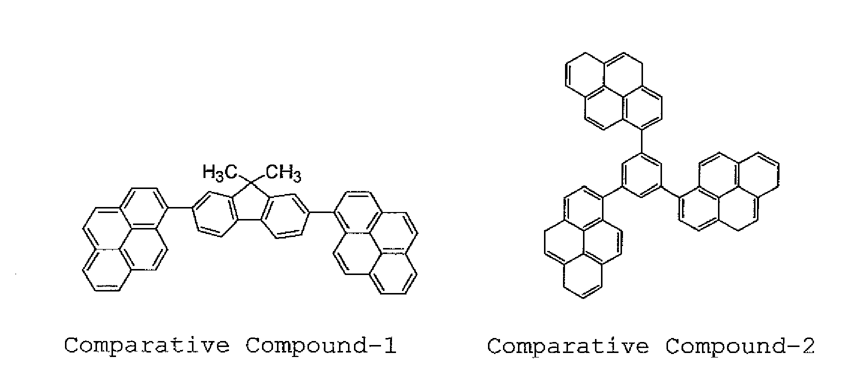

### Comparative Example 3

A transparent electrode having a thickness of 130 nm and composed of an indium tin oxide was provided on a glass substrate of sizes measuring 25 mm wide by 75 mm long by 1.1 mm thick. The glass substrate was irradiated with ultraviolet light and ozone to be washed. After that, the substrate was placed in a vacuum vapor deposition apparatus.
First, TPD232 was deposited from the vapor to serve as a hole injecting layer having a thickness of 60 nm. After that, TBDB was deposited from the vapor onto the hole injecting layer to serve as a hole transporting layer having a thickness of 20 nm. Subsequently, TBDB and Compound (H-63) shown above were simultaneously deposited from the vapor at a weight ratio of 1 : 1, whereby a light emitting layer having a thickness of 40 nm was formed. Further, Compound (H-63) shown above was deposited from the vapor to have a thickness of 20 nm.
Next, tris (8-hydroxyquinolinato) aluminum was deposited from the vapor to serve as an electron injecting layer having a thickness of 20 nm. Next, lithium fluoride was deposited from the vapor to have a thickness of 0.3 nm, and then aluminum was deposited from the vapor to have a thickness of 150 nm. The aluminum/lithium fluoride layer functions as a cathode. Thus, an organic EL device was produced. Table 1 summarizes the results of the evaluation of the device.

**Table 1. Performance comparison between blue light emitting devices (@10mA/cm²)**

| | Light emitting material 1 | Light emitting material 2 | Voltage at which device is driven (V) | Emission luminance (cd/m²) | Current efficien cy (cd/A) | Half lifetime (hr) |
|---|---|---|---|---|---|---|
| Example 1 | H-63 | D-157 | 6.2 | 650 | 7 | 17,800 |
| Example 2 | H-63 | D-255 | 6 | 600 | 6.7 | 15,450 |
| Example 3 | H-63 | D-38 | 5.9 | 630 | 7.3 | 17,500 |
| Example 4 | H-63 | D-15 | 5.9 | 600 | 7.4 | 16,900 |
| Example 5 | H-63 | D-5 | 6 | 610 | 7 | 16,500 |
| Example 6 | H-163 | D-157 | 5.9 | 660 | 7.4 | 18,800 |
| Example 7 | H-163 | D-255 | 6 | 650 | 7 | 17,900 |
| Example 8 | H-118 | D-157 | 5.9 | 620 | 7.4 | 16,800 |
| Example 9 | H-118 | D-255 | 6 | 610 | 7 | 15,500 |
| Comparative Example 1 | Comparative Compound-1 | D-157 | 6.5 | 450 | 4.9 | 6,600 |
| Comparative Example 2 | Comparative Compound-2 | D-157 | 6.7 | 400 | 4.5 | 5,900 |
| Comparative Example 3 | TBDB | H-63 | 7.0 | 240 | 2.4 | 2,000 |

### Example 10

A transparent electrode having a thickness of 80 nm and composed of an indium tin oxide was provided on a glass substrate of sizes measuring 25 mmwide by 75 mm long by 1.1 mm thick. The glass substrate was irradiated with ultraviolet light and ozone to be washed. After that, the substrate was placed in a vacuum vapor deposition apparatus.
First, an 4,4'-bis(N,N-di-(3-tolyl)-4-aminophenyl)-4"-phenyltriphenylamine was deposited from the vapor to serve as a hole injecting layer having a thickness of 60 nm. After that, an N',N"-bis[4-(diphenylamino)phenyl]-N',N"-diphenylbiphenyl-4,4'-diamine was deposited from the vapor onto the hole injecting layer to serve as a hole transporting layer having a thickness of 20 nm. Subsequently, Compounds (H-63) and (D-100) shown above were simultaneously deposited from the vapor at a weight ratio of 40 : 3, whereby a light emitting layer having a thickness of 40 nm was formed.
Next, tris (8-hydroxyquinolinato) aluminum was deposited from the vapor to serve as an electron injecting layer having a thickness of 20 nm. Next, lithium fluoride was deposited from the vapor to have a thickness of 0.3 nm, and then aluminum was deposited from the vapor to have a thickness of 150 nm. The aluminum/lithium fluoride layer functions as a cathode. Thus, an organic EL device was produced.
Next, the device was subjected to a current test. As a result, the device emitted green light with a luminance of 2,000 cd/m² at a voltage of 6.3 V and a current density of 10 mA/cm².

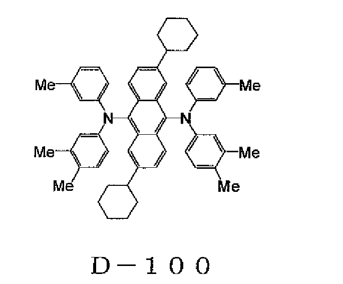

### Comparative Example 4

An organic EL device was produced in the same manner as in Example 3 except that 3-(2'-benzothiazoyl)-7-diethylaminocoumarin was used instead of Compound (D-38) in the light emitting layer of the device.
The device was subjected to a current test. As a result, the device emitted green light with a luminance of 870 cd/m² at a voltage of 6.5 V and a current density of 10 mA/cm².
Comparison between Example 10 and Comparative Example 4 showed the following: when the pyrene derivative of the present invention was used as a dopant, a green light emitting device having higher efficiency and a longer lifetime than those of a device obtained by using a conventional coumarin derivative as a dopant, was obtained. 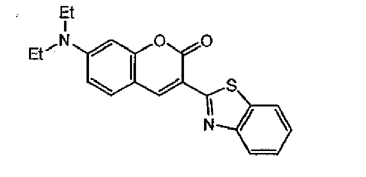 3-(2'-benaothiazoyl)-7-diethylaminocoumarin

### Example 11

A transparent electrode having a thickness of 180 nm and composed of an indium tin oxide was provided on a glass substrate of sizes measuring 25 mm wide by 75 mm long by 1.1 mm thick. The glass substrate was irradiated with ultraviolet light and ozone to be washed. After that, the substrate was placed in a vacuum vapor deposition apparatus.
First, an 4,4'-bis(N,N-di-(3-tolyl)-4-aminophenyl)-4"-phenyltriphenylamine was deposited from the vapor to serve as a hole injecting layer having a thickness of 60 nm. After that, an N,N,N',N'-tetrakis(4-biphenyl)-4,4'-benzidine was deposited from the vapor onto the hole injecting layer to serve as a hole transporting layer having a thickness of 20 nm. Subsequently, Compounds (H-63) and (D-240) shown above were simultaneously deposited from the vapor at a weight ratio of 40 : 10, whereby a light emitting layer having a thickness of 40 nm was formed.
Next, tris(8-hydroxyquinolinato) aluminum was deposited from the vapor to serve as an electron injecting layer having a thickness of 20 nm. Next, lithium fluoride was deposited from the vapor to have a thickness of 0.3 nm, and then aluminum was deposited from the vapor to have a thickness of 150 nm. The aluminum/lithium fluoride layer functions as a cathode. Thus, an organic EL device was produced.
Next, the device was subjected to a current test. As a result, the device emitted red light with a luminance of 490 cd/m² at a voltage of 7.8 V and a current density of 10 mA/cm²

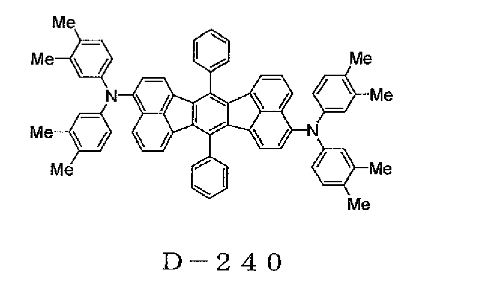

### Comparative Example 5

An organic EL device was produced in the same manner as in Example 11 except that 4-dicyanomethylene-6-julolidinostyryl-2-t-butyl-4H-pyrane (DCJTB) was used instead of Compound (D-240) in the light emitting layer of the device.
The device was subjected to a current test. As a result, the device emitted red light with a luminance of 300 cd/m² at a voltage of 8.5 V and a current density of 10 mA/cm².
Comparison between Example 6 and Comparative Example 4 showed the following: when a combination of the pyrene derivative of the present invention as a host and a dopant having a specific structure was employed, a red light emitting device having higher efficiency and a longer lifetime than those of a device obtained by employing a conventional combination of DCJTB as a dopant and a fluorene compound as a host was obtained.
As described above, in the present invention, blue light having a long lifetime was emitted with high efficiency as compared to conventional blue light as a result of the formation of a light emitting layer from a pyrene derivative compound having a specific structure and an amine compound having a specific structure. In addition, greenish or reddish light was also emitted with high efficiency.

### Industrial Applicability

As described above in detail, the organic electroluminescence device of the present invention utilizing a specific pyrene derivative and a specific amine compound as light emitting materials has a high color purity, is excellent in heat resistance, has a long lifetime and high efficiency, and can emit bluish, greenish, and reddish light.
The organic EL device of the present invention can find use in applications including: flat light emitting bodies such as a flat panel display of a wall television; light sources for backlights or meters of copying machines, printers, and liquid crystal displays; display boards; and identification lamps.

## Claims

1. An organic electroluminescence device comprising an organic thin film layer composed of one or more layers including at least a light emitting layer, the organic thin film layer being interposed between a cathode and an anode, wherein at least one layer of the organic thin film layer contains a pyrene derivative represented by the following general formula (1) and an amine compound represented by the following general formula (2):
(A)ₖ-(X)ₘ-(Ar)ₙ-(Y)ₒ-(B)ₚ (1)
where:
X's each represent a substituted or unsubstituted pyrene residue;
A's and B's each independently represent a hydrogen atom, a substituted or unsubstituted aromatic hydrocarbon group having 6 to 50 carbon atoms, a substituted or unsubstituted aromatic heterocyclic group having 5 to 50 carbon atoms, or a substituted or unsubstituted, saturated or unsaturated alkylene group having 1 to 50 carbon atoms;
Ar's each represent a substituted or unsubstituted aromatic hydrocarbon group having 6 to 50 carbon atoms, or a substituted or unsubstituted aromatic heterocyclic group having 5 to 50 carbon atoms;
Y's each represent a substituted or unsubstituted fused ring group or fused heterocyclic group having 4 to 50 carbon atoms;
k, o, and p each independently represent an integer of 0 to 10;
m represents an integer of 1 to 10;
n represents an integer of 3 or more;
multiple X's, multiple A's, multiple B's, multiple Ar's, or multiple Y's may be identical to or different from each other; and
at least one bond between X, Ar and Y comprises a meta bond or an ortho bond; 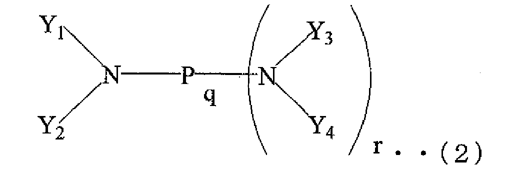
where:
P represents a substituted or unsubstituted aromatic hydrocarbon group having 6 to 40 carbon atoms, a substituted or unsubstituted heterocyclic group having 3 to 40 carbon atoms, a substituted or unsubstituted styryl group, or a substituted or unsubstituted fused aromatic ring group having 10 to 40 carbon atoms;
Y₁ to Y₄ each independently represent a group selected from the group consisting of a substituted or unsubstituted alkylene group, aralkylene group, alkenylene group, amino group, and silyl group, and an unsubstituted carbonyl group, or ether group, and thioether group each having a linking group composed of a substituted or unsubstituted arylene group or divalent heterocyclic group, and may be identical to or different from one another;
when r represents 2 or more, Y₃s or Y₄s may be identical to or different from each other;
q represents an integer of 1 to 20; and
r represents an integer of 0 to 3.

2. An organic electroluminescence device according to claim 1, wherein the pyrene derivative represented by the general formula (1) is represented by the following general formula (3):
X-Ar₁-Ar₂-Ar₃-Y (3)
where:
X represents a substituted or unsubstituted pyrene residue;
Ar₁ to Ar₃ each independently represent a substituted or unsubstituted aromatic hydrocarbon group having 6 to 50 carbon atoms, or a substituted or unsubstituted aromatic heterocyclic group having 5 to 50 carbon atoms;
Y represents a substituted or unsubstituted fused ring group or fused heterocyclic group having 4 to 50 carbon atoms; and
at least one of an X-Ar₁ bond, an Ar₁-Ar₂ bond, an Ar₂-Ar₃ bond, and an Ar₃-Y bond comprises a meta bond or an ortho bond.

3. An organic electroluminescence device according to claim 1 or 2, wherein P in the general formula (2) is represented by the following general formula (4) : 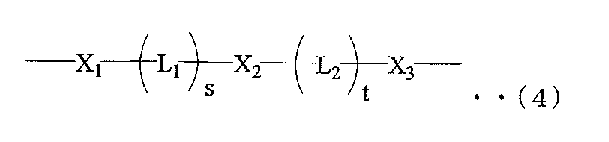 where:
X₁, X₂, and X₃ each independently represent a divalent group selected from the group consisting of a single bond, a substituted or unsubstituted alkylene group, aralkylene group, arylene group, and heterocyclic group, may be identical to or different from each other, and may each represent any one of an alkenylene group, an amino group, a silyl group, a carbonyl group, an ether group, and a thioether group;
each of X₁, X₂, and X₃ may be bonded to each of Y₁, Y₂, Y₃, and Y₄ to form a ring;
L₁ and L₂ each independently represent a divalent group selected from the group consisting of a substituted or unsubstituted alkyl group, aralkyl group, aryl group, and heterocyclic group, and may be identical to or different from each other; and
s and t each represent an integer of 0 to 10 provided that s + t ≥ 1.

4. An organic electroluminescence device according to claim 3, wherein L₁ or L₂ in the general formula (4) represents a residue of fluorene, anthracene, naphthalene, phenanthrene, fluoranthene, pyrene, perylene, chrysene, or phenylanthracene, or a residue composed of a combination of two or more of those groups.

5. An organic electroluminescence device according to any one of claims 1 to 4, comprising a chalcogenide layer, a halogenated metal layer, or a metal oxide layer placed on at least one surface of a pair of electrodes.

6. An organic electroluminescence device according to any one of claims 1 to 5, wherein the light emitting layer contains the pyrene derivative and the amine compound.

7. An organic electroluminescence device according to any one of claims 1 to 6, wherein the light emitting layer contains the pyrene derivative and the amine compound at a ratio of 99.99 : 0.01 to 80.00:20.00 wt%.

8. An organic electroluminescence device according to any one of claims 1 to 7, wherein the light emitting layer contains a metal complex compound.
